(19) Europäisches Patentamt
European Patent Office
Office européen des brevets

(11) EP 4 654 795 A1

(12) EUROPEAN PATENT APPLICATION

(43) Date of publication:
**26.11.2025 Bulletin 2025/48**

(21) Application number: **25177499.8**

(22) Date of filing: **20.05.2025**

(51) International Patent Classification (IPC):
***H10K 50/15*** *(2023.01)* ***H10K 50/18*** *(2023.01)*
*H10K 50/19* *(2023.01)* *H10K 85/60* *(2023.01)*

(52) Cooperative Patent Classification (CPC):
**H10K 50/15; H10K 50/181;** H10K 50/19;
H10K 85/633; H10K 85/636

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **22.05.2024 KR 20240066712**

(71) Applicant: **Duk San Neolux Co., Ltd.**
**Chungcheongnam-do 31027 (KR)**

(72) Inventors:
- **SONG, Hyeng Gun**
  **31027 Cheonan-si, Chungcheongnam-do (KR)**
- **KIM, Dong Hyun**
  **31027 Cheonan-si, Chungcheongnam-do (KR)**
- **LEE, Hyung Dong**
  **31027 Cheonan-si, Chungcheongnam-do (KR)**

(74) Representative: **Isarpatent**
**Patent- und Rechtsanwälte**
**Barth Hassa Peckmann & Partner mbB**
**Friedrichstraße 31**
**80801 München (DE)**

# (54) AN ORGANIC ELECTRONIC ELEMENT AND AN ELECTRONIC DEVICE THEREOF

(57) The present invention provides an organic electronic element comprising a first electrode; second electrode; and an organic material layer comprising an emitting layer formed between the first electrode and the second electrode; wherein the organic material layer comprises a hole transport layer formed between the first electrode and the emitting layer, and an emitting auxiliary layer formed between the hole transport layer and the emitting layer, and by controlling the amount of holes injected into the emitting layer, the driving voltage of the organic electronic element can be lowered and the emitting-efficiency and lifetime can be improved.

FIG. 2

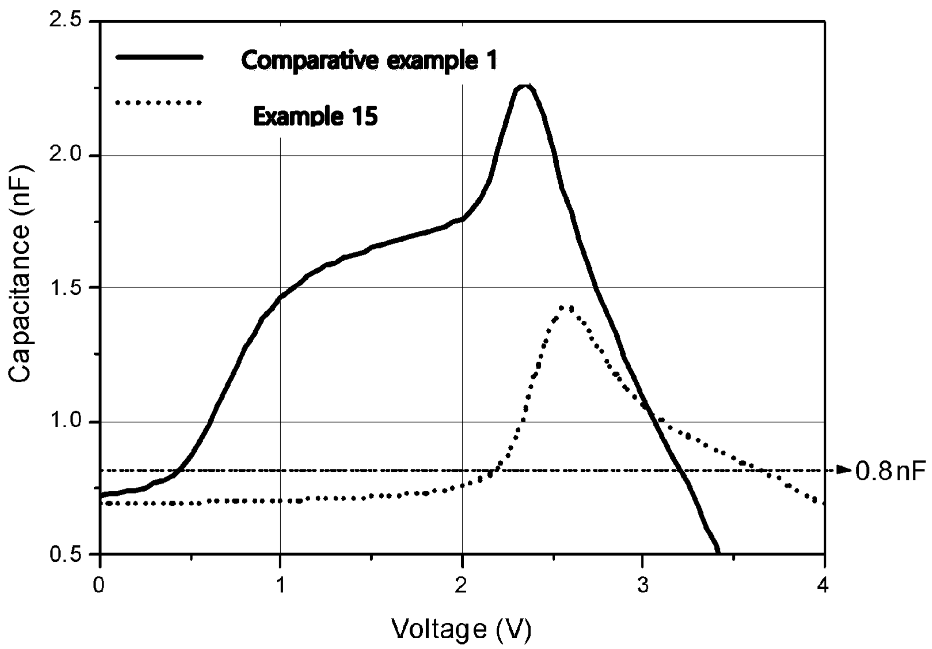




Processed by Luminess, 75001 PARIS (FR)

## Description

BACKGROUND

[Technical Field]

The present invention relates to an organic electronic element and an electronic device thereof.

[Background Art]

In general, organic light emitting phenomenon refers to a phenomenon that converts electric energy into light energy by using an organic material. An organic electronic element using an organic light emitting phenomenon usually has a structure including an anode, a cathode, and an organic material layer interposed therebetween. Here, in order to increase the efficiency and stability of the organic electronic element, the organic material layer is often composed of a multi-layered structure composed of different materials, and for example, may include a hole injection layer, a hole transport layer, an emitting layer, an electron transport layer, an electron injection layer etc.

In general, electrons are transferred from the electron transport layer to the emitting layer, and holes are transferred from the hole transport layer to the emitting layer to generate excitons by recombination.

However, since the material used in the hole transport layer must have a low HOMO value, most of them have a low T1 value, which causes excitons generated in the emitting layer to diffused to the hole transport layer, resulting in charge unbalance within the emitting layer and causing light emission at the hole transport layer interface. To solve the problem of luminescence in such hole transport layers, organic electronic elements that form multiple hole transport layers or form an emitting-auxiliary layer between the hole transport layer and the emitting layer are being proposed.

By using an emitting-auxiliary layer, problems such as light emission in the hole transport layer and charge unbalance within the emitting layer can be solved. However, in order to achieve the goal of high brightness, hole injection and transport between the hole transport layer and the emitting-auxiliary layer or between the emitting-auxiliary layer and the emitting layer should be controlled, and in particular, the interaction between the hole transport layer and the emitting-auxiliary layer determine significant role.

In the design of the emitting-auxiliary layer inserted between the hole transport layer and the emitting layer in organic electronic elements, it is essential to reduce the device driving voltage and improve the Luminescence efficiency, power efficiency, color purity, and operating lifetime. Currently, organic electronic elements are susceptible to interface degradation caused by parasite excitons generated along the interface between the emitting-auxiliary layer and the emitting layer due to trapping of holes accumulated at the interface, which may lead to a reduction in the operating lifetime of the organic electronic element. Accordingly, comprehensive research into the suppression of interfacial excitons is required.

DETAILED DESCRIPTION OF THE INVENTION

[Summary]

The present invention aims to provide an organic electronic element comprising a compound capable of reducing the driving voltage of the element and improving the luminescence efficiency, color purity, stability and lifetime of the element, and an electronic device thereof

[Technical Solution]

In one aspect, the organic electronic element according to the present invention provides an organic electronic element comprising a first electrode; second electrode; and an organic material layer comprising an emitting layer formed between the first electrode and the second electrode; wherein the organic material layer comprises a hole transport layer formed between the first electrode and the emitting layer, and an emitting-auxiliary layer formed between the hole transport layer and the emitting layer, and wherein the organic electronic element has capacitance characteristics satisfying Equation 2.

[Equation 2]

$$V_{cmax} - V_{c(0.8nF)} \leq 1.3\,V$$

In another aspect, the present invention provides an electronic device comprising the organic electronic element.

[Effects of the Invention]

The present invention can achieve high luminescence efficiency, low driving voltage, and high thermal stability of an element by controlling the amount of holes injected into an emitting layer, and can significantly improve the color purity and lifetime of the element.

[BRIEF DESCRIPTION OF THE DRAWINGS]

FIG. 1 illustrates an example of an organic light emitting diode according to the present invention.

FIG. 2 shows the results of a capacitance measurement experiment of an organic electronic element according to one embodiment of the present invention.

FIG. 3 is a graph showing the lifetime of an organic electronic element according to the $V_{Cmax}$-$V_{C(0.8nF)}$ value according to one embodiment of the present invention.

FIG. 4 is a graph showing the efficiency of an organic electronic element according to the $V_{Cmax}$-$V_{C(0.8nF)}$ value according to one embodiment of the present invention.

[DETAILED DESCRIPTION]

Hereinafter, some embodiments of the present invention will be described in detail. Further, in the following description of the present invention, a detailed description of known functions and configurations incorporated herein will be omitted when it may make the subject matter of the present invention rather unclear.

In addition, terms, such as first, second, A, B, (a), (b) or the like may be used herein when describing components of the present invention. Each of these terminologies is not used to define an essence, order or sequence of a corresponding component but used merely to distinguish the corresponding component from other component(s). It should be noted that if a component is described as being "connected", "coupled", or "connected" to another component, the component may be directly connected or connected to the other component, but another component may be "connected ", " coupled" or "connected" between each component.

As used in the specification and the accompanying claims, unless otherwise stated, the following is the meaning of the term as follows.

Unless otherwise stated, the term "halo" or "halogen", as used herein, includes fluorine(F), bromine(Br), chlorine(Cl), or iodine(I).

Unless otherwise stated, the term "alkyl" or "alkyl group", as used herein, has a single bond of 1 to 60 carbon atoms, 1 to 30 carbon atoms, 1 to 25 carbon atoms, 1 to 18 carbon atoms, or 1 to 12 carbon atoms, and means saturated aliphatic functional radicals including a linear alkyl group, a branched chain alkyl group, a cycloalkyl group (alicyclic), an cycloalkyl group substituted with a alkyl or an alkyl group substituted with a cycloalkyl.

Unless otherwise stated, the term "alkenyl" or "alkynyl", as used herein, has double or triple bonds of 2 to 60 carbon atoms, 2 to 30 carbon atoms, 2 to 25 carbon atoms, 2 to 18 carbon atoms, 2 to 12 carbon atoms, but is not limited thereto, and includes a linear or a branched chain group.

Unless otherwise stated, the term "cycloalkyl", as used herein, means alkyl forming a ring having 3 to 60 carbon atoms, 3 to 30 carbon atoms, 3 to 25 carbon atoms, 3 to 18 carbon atoms, 3 to 12 carbon atoms, but is not limited thereto.

Unless otherwise stated, the term "alkoxyl group", "alkoxy group" or "alkyloxy group", as used herein, means an alkyl group bonded to oxygen radical, but is not limited thereto, and has 1 to 60 carbon atoms, 1 to 30 carbon atoms, 1 to 25 carbon atoms, 1 to 18 carbon atoms, or 1 to 12 carbon atoms.

Unless otherwise stated, the term "aryloxyl group" or "aryloxy group", as used herein, means an aryl group bonded to oxygen radical, but is not limited thereto, and has 6 to 60 carbon atoms, 6 to 30 carbon atoms, 6 to 25 carbon atoms, 6 to 18 carbon atoms, or 6 to 12 carbon atoms.

Unless otherwise specified, the terms "aryl group" and "arylene group" used in the present invention have 6 to 60 carbon atoms, 6 to 30 carbon atoms, 6 to 25 carbon atoms, 6 to 18 carbon atoms, or 6 to 12 carbon atoms, respectively, but are not limited thereto. In the present invention, an aryl group or arylene group refers to an aromatic group of a single ring or multiple rings, and contain aromatic rings formed by bonding or reacting with adjacent substituents. For example, the aryl group may be a phenyl group, a biphenyl group, a fluorene group, or a spirofluorene group.

The prefix "aryl" or "ar" means a radical substituted with an aryl group. For example, an arylalkyl may be an alkyl substituted with an aryl, and an arylalkenyl may be an alkenyl substituted with aryl, and a radical substituted with an aryl has a number of carbon atoms as defined herein.

Also, when prefixes are named subsequently, it means that substituents are listed in the order described first. For example, an arylalkoxy means an alkoxy substituted with an aryl, an alkoxylcarbonyl means a carbonyl substituted with an alkoxyl, and an arylcarbonylalkenyl also means an alkenyl substituted with an arylcarbonyl, wherein the arylcarbonyl may be a carbonyl substituted with an aryl.

Unless otherwise stated, the term "heterocyclic group", as used herein, contains one or more heteroatoms, but is not limited thereto, has 2 to 60 carbon atoms, 2 to 30 carbon atoms, 2 to 25 carbon atoms, 2 to 18 carbon atoms, 2 to 12 carbon atoms, and includes any one of a single ring or multiple ring, and may include heteroaliphatic ring and heteroaromatic ring. Also, the heterocyclic group may also be formed by bonding with an adjacent group.

Unless otherwise stated, the term "heteroatom", as used herein, represents at least one of N, O, S, P, or Si.

Also, "heterocyclic group" refers to a single ring containing heteroatoms, a ring aggregate, multiple fused ring systems, spiro compounds, etc. Additionally, compounds containing heteroatom groups such as $SO_2$, P=O, etc., such as the compounds below, instead of carbon forming a ring, may also be included in the heterocyclic group. For example, "heterocyclic group" includes the following compound.

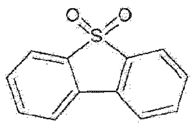

The term "aliphatic ring group" used in the present invention refers to cyclic hydrocarbons excluding aromatic hydrocarbons, and includes single rings, ring aggregates, fused multiple ring systems, spiro compounds, etc., and means a ring having 3 to 60 carbon atoms, 3 to 30 carbon atoms, 3 to 25 carbon atoms, 3 to 18 carbon atoms, 3 to 12 carbon atoms, but is not limited thereto. For example, even when benzene, an aromatic ring, and cyclohexane, a non-aromatic ring, are fused, it is an aliphatic ring.

Unless otherwise stated, the term "fluorenyl group", "fluorenylene group" or "fluorentriyl group" as used herein, means a monovalent, divalent or trivalent functional group, in which R, R' and R" are all hydrogen in the following structures, and the term "substituted fluorenyl group", "substituted fluorenylene group" or "substituted fluorentriyl group" means that at least one of the substituents R, R' and R" is a substituent other than hydrogen, and include those in which R and R' are bonded to each other to form a spiro compound together with the carbon to which they are bonded. In this specification, fluorenyl group, fluorenylene group, and fluorenetriyl group may all be referred to as fluorene groups, regardless of valence.

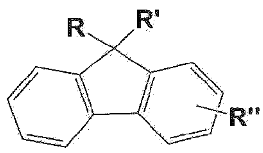

The term "spiro compound", as used herein, has a 'spiro union', and a spiro union means a connection formed by 2 rings sharing only one atom. Wherein, the atoms shared between the 2 rings are called 'spiro atoms', and depending on the number of spiro atoms contained in a compound, they are called 'monospiro-', 'dispiro-', and 'trispiro-' compounds, respectively.

Unless otherwise stated, the term "aliphatic" as used herein means an aliphatic hydrocarbon having 1 to 60 carbon atoms, 1 to 30 carbon atoms, 1 to 25 carbon atoms, 1 to 18 carbon atoms or 1 to 12 carbon atoms, and "aliphatic ring" means an aliphatic hydrocarbon ring having 3 to 60 carbon atoms, 3 to 30 carbon atoms, 3 to 25 carbon atoms, 3 to 18 carbon atoms or 3 to 12 carbon atoms.

Unless otherwise stated, the term "ring", as used herein, means an aliphatic ring having 3 to 60 carbon atoms, 3 to 30 carbon atoms, 3 to 25 carbon atoms, 3 to 18 carbon atoms or 3 to 12 carbon atoms; or an aromatic ring having 6 to 60 carbon atoms, 6 to 30 carbon atoms, 6 to 25 carbon atoms, 6 to 18 carbon atoms, or 6 to 12 carbon atoms; or a heterocyclic having 2 to 60 carbon atoms, 2 to 30 carbon atoms, 2 to 25 carbon atoms, 2 to 18 carbon atoms, 2 to 12 carbon atoms, or a fused ring formed by the combination thereof, and includes a saturated or unsaturated ring.

Other hetero compounds or hetero radicals other than the above-mentioned hetero compounds include, but are not limited thereto, one or more heteroatoms.

Also, unless expressly stated, as used herein, "substituted" in the term "substituted or unsubstituted" means substituted with one or more substituents selected from the group consisting of deuterium, halogen, an amino group, a

nitrile group, a nitro group, a $C_1$-$C_{20}$ alkyl group, a $C_1$-$C_{20}$ alkoxyl group, a $C_1$-$C_{20}$ alkylamine group, a $C_1$-$C_{20}$ alkylthiopen group, a $C_6$-$C_{20}$ arylthiopen group, a $C_2$-$C_{20}$ alkenyl group, a $C_2$-$C_{20}$ alkynyl group, a $C_3$-$C_{20}$ cycloalkyl group, a $C_6$-$C_{20}$ aryl group, a $C_6$-$C_{20}$ aryl group substituted by deuterium, a $C_8$-$C_{20}$ arylalkenyl group, a silane group, a boron group, a germanium group, and a $C_2$-$C_{20}$ heterocyclic group, but is not limited to these substituents.

In this specification, the 'group name' corresponding to the aryl group, arylene group, heterocyclic group, etc., as examples of each symbol and its substituent, may be written as the 'name of the group reflecting the valence', but is written as the 'parent compound name'. For example, in the case of 'phenanthrene', a type of aryl group, the name of the group may be written by distinguishing the valence, such as the monovalent 'group' is 'phenanthryl' and the divalent group is 'phenanthrylene', but may be written as 'phenanthrene', which is the name of the parent compound, regardless of the valence. Similarly, in the case of pyrimidine, it can be written as 'pyrimidine' regardless of the valence, or it can be written as the 'name of the group' of the valence, such as pyrimidineyl group in the case of monovalent group, pyrimidineylene in the case of divalent group, etc. Additionally, in this specification, when describing compound names or substituent names, numbers or alphabets indicating positions may be omitted. For example, pyrido[4,3-d]pyrimidine to pyridopyrimidine, benzofuro[2,3-d]pyrimidine to benzofuropyrimidine, 9,9-dimethyl-9H-fluorene can be described as dimethylfluorene, etc. Therefore, both benzo[g]quinoxaline and benzo[f]quinoxaline can be described as benzoquinoxaline.

Also, unless there is an explicit explanation, the formula used in the present invention is the same as the definition of the substituent by the exponent definition of the following formula.

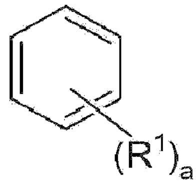

Here, when a is an integer of 0, the substituent $R^1$ is absent, when a is an integer of 1, the sole substituent $R^1$ is linked to any one of the carbon constituting the benzene ring, when a is an integer of 2 or 3, each is combined as follows, where $R^1$ may be the same or different from each other, when a is an integer of 4 to 6, it is bonded to the carbon of the benzene ring in a similar manner, while the indication of the hydrogen bonded to the carbon forming the benzene ring is omitted.

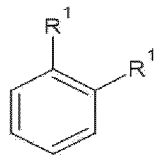

(a=2)

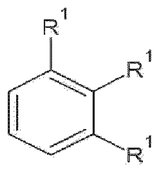

(a=3)

Unless otherwise expressly stated, the terms "ortho", "meta", and "para" used in the present invention refer to the substitution positions of all substituents, and the ortho position refers to a compound in which the position of the substituent is immediately adjacent, for example, when benzene is used, it means 1 or 2 position, and the meta position is the next substitution position of the neighbor substitution position, when benzene as an example stands for 1 or 3 position, and the para position is the next substitution position of the meta position, which means 1 and 4 position when benzene is taken as an example. A more detailed example of the substitution position is as follows, and it can be confirmed that the ortho-, and meta- position are substituted by non-linear type and para- positions are substituted by linear type.

[Example of ortho-position]

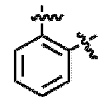 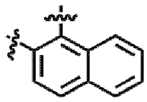 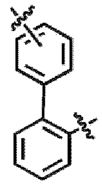 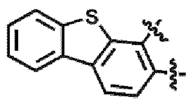 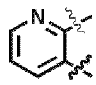 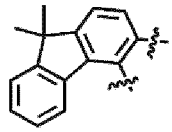

[Example of meta-position]

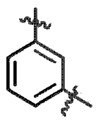 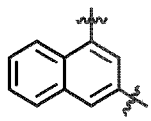 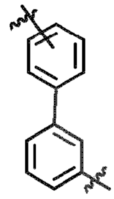 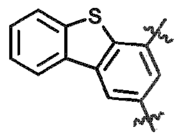 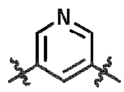 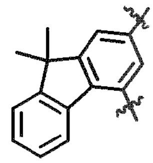

[Example of para-position]

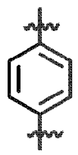 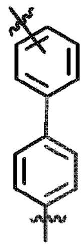 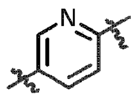

Hereinafter, an organic electronic element according to one aspect of the present invention will be described.

Referring to FIG. 1, an organic electronic element according to one embodiment of the present invention comprises a first electrode, a second electrode and an organic material layer formed between the first electrode and the second electrode formed on a substrate (not shown).

Wherein, the first electrode may be an anode (positive electrode), and the second electrode may be a cathode (negative electrode). In the case of an inverted organic electronic element, the first electrode may be a cathode, and the second electrode may be an anode.

The organic material layer comprises a hole transport layer, an emitting layer, an electron transport layer, and an emitting-auxiliary layer is formed between the hole transport layer and the emitting layer.

The organic material layer may comprise a hole injection layer between the first electrode and the hole transport layer, and an electron injection layer between the second electrode and the electron transport layer. Additionally, a buffer layer can be formed between the hole transport layer and the emitting-auxiliary layer.

Although not shown in Fig. 1, an electron transport auxiliary layer may be additionally formed between the emitting layer and the electron transport layer.

Also, the organic electronic element according to an embodiment of the present invention may further comprise a protective layer or a light efficiency enhancing layer. Wherein the light efficiency enhancing layer is formed on one of both surfaces of the first electrode that is not in contact with the organic material layer or on one of both surfaces of the second electrode that is not in contact with the organic material layer.

According to one embodiment of the present invention, the interaction between the hole transport layer and the emitting-auxiliary layer in the organic electronic element can be determined through capacitance measurement. When the difference between the voltage at which the capacitance reaches its maximum (hereinafter referred to as VCmax) and the initial voltage at which the capacitance begins to increase (hereinafter VC(0.8 nF) is large, hole accumulation between the hole transport layer and the auxiliary emission layer begins at a relatively low voltage.

As a result, the amount of holes trapped in both the auxiliary emission layer and the emitting layer increases. This

leads to a charge unbalance between holes and electrons in the emitting layer.

This can cause non-radiative decay to be generated, which can lead to a decrease in the charge carrier balance. It can be predicted that the efficiency decreases due to a decrease in charge carrier balance through Equation 1.

[Equation 1]

$$\eta_{EQE} = \gamma \cdot \eta_{S/T} \cdot q_{eff} \cdot \eta_{out}$$

$\eta_{EQE}$ : External Quantum Efficiency (%)
$\gamma$ : Carrier (hole-electron) balance (%)
$\eta_{S/T}$: Exciton generation rate according to singlet/triplet spin-orbit rules (%)
$q_{eff}$: Radiation Quantum Efficiency (%)
$\eta_{out}$: External exciton extraction efficiency (%)

[Equation 3]

$$\eta_{IQE} = \gamma \cdot \eta_{S/T} \cdot q_{eff}$$

$\eta_{IQE}$: Internal quantum efficiency (%)

[Equation 4]

$$\eta_{EQE} = \eta_{IQE} \cdot \eta_{out}$$

More specifically, the unbalance of the charge carrier balance causes a decrease in $\gamma$ (carrier balance) in Equation 1, which causes a problem of a decrease in the luminescence efficiency of the organic electronic element, and as the accumulation of holes increases with voltage, the exciton formation region moves along the interface of the emitting-auxiliary layer and the emitting layer, which causes degradation of the interface and can lead to a decrease in the lifetime of the organic electronic element. Therefore, when the energy levels or intrinsic properties of the material (mobility, interface properties, etc.) are optimally combined between the hole transport layer, the buffer layer, and the emitting-auxiliary layer, the characteristics and stability of the organic electronic element can be improved without causing hole accumulation at the interface between the emitting-auxiliary layer and the emitting layer.

At this time, the capacitance characteristics of the organic electronic element satisfy Equation 2.

[Equation 2]

$$V_{cmax} - V_{c(0.8nF)} \leq 1.3\,V$$

Wherein,

1) $V_{Cmax}$ is the voltage value at which the capacitance of organic electronic element is measured to be maximum.

2) $V_{C(0.8nF)}$ is the voltage value at which the capacitance of organic electronic element becomes 0.8 nF.

Capacitance refers to the amount of charge stored inside between the electrodes at both ends of an organic electronic element. The element's capacitance increases according to the voltage, and when holes and electrons in the organic electronic element begin to recombinant to form excitons, the capacitance stored inside decreases due to the carriers (holes and electrons) being consumed. The unit of capacitance is F(farad), which means storing or releasing 1C of charge at a voltage of 1V. The capacitance of organic electronic element is in the range of nF (n(nano : $1.0 \times 10^{-9}$)F).

As can be seen from Equation 2, $V_{Cmax}$ - $V_{C(0.8nF)}$ value is preferably 1.3 V or less, more preferably 1.1 V or less, even more preferably 1.0 V or less, and even more preferably 0.8 V or less. When the $V_{Cmax}$ - $V_{C(0.8nF)}$ value exceeds 1.3 V, it causes unnecessary charge accumulation at the interface due to an increase in trapped holes. This shows an unstable panel structure with reduced luminescence efficiency and lifetime due to the formation of an exciton recombination zone moving to the interface of the emitting-auxiliary layer and the deterioration of the charge carrier balance. That is, after the voltage $V_{Cmax}$, the consumption of accumulated holes and the rapid generation of excitons cause interface degradation and efficiency roll-off. The more stable the structure of the organic electronic element, the more $V_{c(0.8nF)}$ is delayed, which delays charge accumulation at the interface. Therefore, when the $V_{Cmax}$ - $V_{C(0.8nF)}$ value is less than 1.3 V, $V_{c(0.8nF)}$ is delayed, which allows for high efficiency and increased lifetime.

Additionally, it is preferable that the $V_{Cmax}$ is the driving voltage range of the organic electronic element which is $\pm$0.5 V of $V_{turn\text{-}on}$. That is, the range of $V_{Cmax}$ is preferably $\pm$0.5 V of $V_{turn\text{-}on}$, which is the point at which the exciton of the organic electronic element is formed, more preferably $\pm$0.45 V, and even more preferably $\pm$0.4 V. The $V_{turn\text{-}on}$ refers to the voltage at which exciton recombination (1~5 nit) of the organic electronic element begins. When the $V_{Cmax}$ value is as above, $V_{turn\text{-}on}$, where the internally charged carriers reach their maximum point, is close to the point where exciton recombination begins, and when an exciton is formed, the internally charged holes and electrons are quickly depleted.

Additionally, it is preferable that the range of the $V_{C(0.8nF)}$ is the driving voltage range of the organic electronic element having a current density (mA/cm$^2$) range of 1.0$\times$10$^{-7}$ to 1.0$\times$10$^{-4}$ mA/cm$^2$. Preferably 8.0$\times$10$^{-6}$ to 1.0$\times$10$^{-4}$ mA/cm$^2$, and more preferably 5.0$\times$10$^{-6}$ to 9.0$\times$10$^{-5}$ mA/cm$^2$. Current density is the current-voltage characteristic of organic electronic elements and means the amount of current per unit area with units of mA/cm$^2$.

The capacitance used in this specification is a numerical value representing the capacitance in an organic electronic element having 2 electrodes.

In organic electronic elements, the stored capacity can change depending on the permittivity of the internal organic material layers, such as the hole injection layer, hole transport layer, emitting-auxiliary layer, emitting layer, electron transport layer, and electron injection layer, as well as the polarization and transition dipole moment. Additionally, a buffer layer may be further included between the hole transport layer and the emitting-auxiliary layer.

$$C = \frac{\varepsilon_0 \varepsilon_r}{d} A$$

C : Capacitance
$\varepsilon_0$ : Permittivity of vacuum
$\varepsilon_r$ : Dielectric constant of internal organic material between anode and cathode
A : area

An ALPHA-AN Analyzer impedance meter was used to measure capacitance (F), which represents the ratio of the amount of charge accumulated according to charge mobility. Impedance measurement can evaluate the charge transfer characteristics of bulk or interfacial regions of ions, semiconductors, and insulators, etc., and is also an effective method for analyzing the electrical properties of materials and the interface with electrodes in OLEDs.

Specifically, the hole accumulation phenomenon can be confirmed by checking whether there is a change in capacitance according to the hole mobility from the anode to the hole transport layer. If the capacitance increases from the beginning, it can be seen that holes do not move smoothly at the hole transport layer interface and accumulate, resulting in a hole accumulation phenomenon.

According to one embodiment of the present specification, at least one of the hole transport layer, the buffer layer or the emitting-auxiliary layer may comprise a compound represented by the following Formula 1 or Formula 2.

[Formula 1]

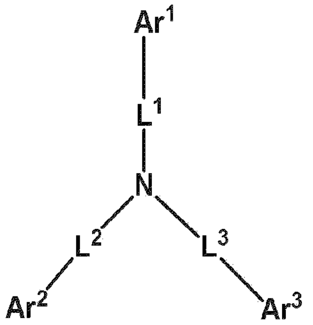

[Formula 2]

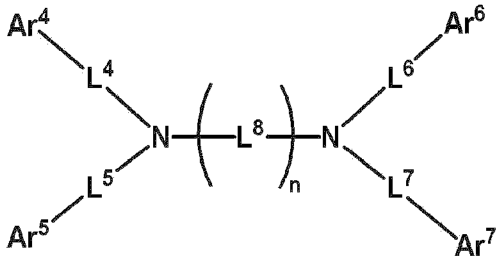

Wherein:

$L^1$, $L^2$, $L^3$, $L^4$, $L^5$, $L^6$ and $L^7$ are each independently selected from the group consisting of single bond; a $C_6$-$C_{60}$ arylene group; a fluorenylene group; a $C_2$-$C_{60}$ heterocyclic group including at least one heteroatom of O, N, S, Si or P; and a fused ring group of a $C_3$-$C_{60}$ aliphatic ring and a $C_6$-$C_{60}$ aromatic ring;

$L^8$ is each independently selected from the group consisting of a $C_6$-$C_{60}$ arylene group; a fluorenylene group; a $C_2$-$C_{60}$ heterocyclic group including at least one heteroatom of O, N, S, Si or P; and a fused ring group of a $C_3$-$C_{60}$ aliphatic ring and a $C_6$-$C_{60}$ aromatic ring;

Wherein when $L^1$, $L^2$, $L^3$, $L^4$, $L^5$, $L^6$, $L^7$ and $L^8$ are an arylene group, preferably an $C_6$-$C_{30}$ arylene group, more preferably an $C_6$-$C_{25}$ arylene group, an $C_6$-$C_{18}$ arylene group or an $C_6$-$C_{12}$ arylene group, such as phenylene, biphenylene, naphthylene, terphenylene, anthracenylene, phenanthrenylen, etc.

Wherein when $L^1$, $L^2$, $L^3$, $L^4$, $L^5$, $L^6$, $L^7$ and $L^8$ are a heterocyclic group, preferably a $C_2$-$C_{30}$ heterocyclic group, more preferably a $C_2$-$C_{25}$ heterocyclic group, a $C_2$-$C_{18}$ heterocyclic group, or a $C_2$-$C_{12}$ heterocyclic group, such as pyrazine, thiophene, pyridine, pyrimidine, quinoline, pyrimidoindole, 5-phenyl-5H-pyrimido[5,4-b]indole, quinazoline, quinoxaline, benzoquinazoline, carbazole, dibenzoquinazoline, benzofuran, benzothiophene, dibenzofuran, dibenzothiophene, benzothienopyrimidine, benzofuropyrimidine, phenothiazine, phenylphenothiazine, naphthobenzofuran, naphthobenzothiophene, etc.

Wherein when $L^1$, $L^2$, $L^3$, $L^4$, $L^5$, $L^6$, $L^7$ and $L^8$ are a fused ring group, preferably a fused ring group of an $C_3$-$C_{30}$ aliphatic ring and an $C_6$-$C_{30}$ aromatic ring, more preferably a fused ring group of an $C_3$-$C_{25}$ aliphatic ring and an $C_6$-$C_{25}$ aromatic ring.

$Ar^1$, $Ar^2$, $Ar^3$, $Ar^4$, $Ar^5$, $Ar^6$ and $Ar^7$ are each independently selected from the group consisting of an $C_6$-$C_{60}$ aryl group; a fluorenyl group; a $C_2$-$C_{60}$ heterocyclic group including at least one heteroatom of O, N, S, Si or P; a fused ring group of a $C_3$-$C_{60}$ aliphatic ring and a $C_6$-$C_{60}$ aromatic ring; a $C_3$-$C_{60}$ aliphatic ring; a $C_1$-$C_{50}$ alkyl group; a $C_2$-$C_{20}$ alkenyl group; a $C_2$-$C_{20}$ alkynyl group; a $C_1$-$C_{30}$ alkoxyl group; a $C_6$-$C_{30}$ aryloxy group; and -L'-N(R')(R"); or $Ar^4$ and $Ar^5$ or $Ar^6$ and $Ar^7$ can be bonded to each other to form a ring,

Wherein when $Ar^1$, $Ar^2$, $Ar^3$, $Ar^4$, $Ar^5$, $Ar^6$ and $Ar^7$ are an aryl group, preferably an $C_6$-$C_{30}$ aryl group, more preferably an $C_6$-$C_{25}$ aryl group, an $C_6$-$C_{18}$ aryl group or an $C_6$-$C_{12}$ aryl group, such as phenyl, biphenyl, terphenyl, naphthalene, phenanthrene, chryshen, etc.

Wherein when $Ar^1$, $Ar^2$, $Ar^3$, $Ar^4$, $Ar^5$, $Ar^6$ and $Ar^7$ are a heterocyclic group, preferably a $C_2$-$C_{30}$ heterocyclic group, more preferably a $C_2$-$C_{25}$ heterocyclic group, a $C_2$-$C_{18}$ heterocyclic group, or a $C_2$-$C_{12}$ heterocyclic group, such as pyrazine, thiophene, pyridine, pyrimidine, quinoline, pyrimidoindole, 5-phenyl-5H-pyrimido[5,4-b]indole, quinazoline, quinoxaline, benzoquinazoline, carbazole, dibenzoquinazoline, benzofuran, benzothiophene, dibenzofuran, dibenzothiophene, benzothienopyrimidine, benzofuropyrimidine, phenothiazine, phenylphenothiazine, naphthobenzofuran, naphthobenzothiophene, etc.

Wherein when $Ar^1$, $Ar^2$, $Ar^3$, $Ar^4$, $Ar^5$, $Ar^6$ and $Ar^7$ are a fused ring group, preferably a fused ring group of an $C_3$-$C_{30}$ aliphatic ring and an $C_6$-$C_{30}$ aromatic ring, more preferably a fused ring group of an $C_3$-$C_{25}$ aliphatic ring and an $C_6$-$C_{25}$ aromatic ring.

Wherein when $Ar^1$, $Ar^2$, $Ar^3$, $Ar^4$, $Ar^5$, $Ar^6$ and $Ar^7$ are an aliphatic ring group, preferably a $C_3$-$C_{30}$ aliphatic ring group, more preferably a $C_3$-$C_{25}$ aliphatic ring group, a $C_3$-$C_{18}$ aliphatic ring group, and a $C_3$-$C_{12}$ aliphatic ring group, and specifically, cyclobutane, cyclopentane, cyclohexane, bicycloheptane, adamantyl, etc.

Wherein when $Ar^1$, $Ar^2$, $Ar^3$, $Ar^4$, $Ar^5$, $Ar^6$ and $Ar^7$ are an alkyl group, preferably a $C_1$-$C_{30}$ alkyl group, more

preferably a $C_1$-$C_{25}$ alkyl group, a $C_1$-$C_{18}$ alkyl group or a $C_1$-$C_{12}$ alkyl group, such as a methyl group, ethyl group, propyl group, isopropyl group, butyl group, t-butyl group, pentyl group, etc.

Wherein when $Ar^1$, $Ar^2$, $Ar^3$, $Ar^4$, $Ar^5$, $Ar^6$ and $Ar^7$ are an alkoxyl group, preferably a $C_1$-$C_{25}$ alkoxyl group, a $C_1$-$C_{18}$ alkoxyl group or a $C_1$-$C_{12}$ alkoxyl group.

Wherein when $Ar^1$, $Ar^2$, $Ar^3$, $Ar^4$, $Ar^5$, $Ar^6$ and $Ar^7$ are an aryloxy group, preferably a $C_6$-$C_{25}$ aryloxy group, a $C_6$-$C_{18}$ an aryloxy group or a $C_6$-$C_{12}$ aryloxyl group.

Wherein L' is selected from the group consisting of a single bond; a $C_6$-$C_{60}$ arylene group; a fluorenylene group; a $C_3$-$C_{60}$ aliphatic ring; and a $C_2$-$C_{60}$ heterocyclic group including at least one heteroatom of O, N, S, Si or P;

Wherein when L' is an arylene group, preferably an $C_6$-$C_{30}$ arylene group, more preferably an $C_6$-$C_{25}$ arylene group, an $C_6$-$C_{18}$ arylene group or an $C_6$-$C_{12}$ arylene group, such as phenylene, biphenylene, naphthylene, terphenylene, anthracenylene, phenanthrenylene, etc.

Wherein when L' is an aliphatic ring, preferably a $C_3$-$C_{30}$ aliphatic ring; more preferably a $C_3$-$C_{25}$ aliphatic ring; a $C_3$-$C_{18}$ aliphatic ring; or a $C_3$-$C_{12}$ aliphatic ring; and specifically, cyclobutane, cyclopentane, cyclohexane, bicycloheptane, adamantyl, etc.

Wherein when L' is a heterocyclic group, preferably a $C_2$-$C_{30}$ heterocyclic group, more preferably a $C_2$-$C_{25}$ heterocyclic group, a $C_2$-$C_{18}$ heterocyclic group, or a $C_2$-$C_{12}$ heterocyclic group, such as pyrazine, thiophene, pyridine, pyrimidine, quinoline, pyrimidoindole, 5-phenyl-5H-pyrimido[5,4-b]indole, quinazoline, quinoxaline, benzoquinazoline, carbazole, dibenzoquinazoline, benzofuran, benzothiophene, dibenzofuran, dibenzothiophene, benzothienopyrimidine, benzofuropyrimidine, phenothiazine, phenylphenothiazine, naphthobenzofuran, naphthobenzothiophene, etc.

Wherein R' and R" are each independently selected from the group consisting of an $C_6$-$C_{60}$ aryl group; a fluorenyl group; a $C_3$-$C_{60}$ aliphatic ring; and a $C_2$-$C_{60}$ heterocyclic group including at least one heteroatom of O, N, S, Si or P; Wherein when R' and R" are an aryl group, preferably an $C_6$-$C_{30}$ aryl group, more preferably an $C_6$-$C_{25}$ aryl group, an $C_6$-$C_{18}$ aryl group or an $C_6$-$C_{12}$ aryl group, such as phenyl, biphenyl, terphenyl, naphthalene, phenanthrene, chryshen, etc.

Wherein when R' and R" are an aliphatic ring, preferably a $C_3$-$C_{30}$ aliphatic ring; more preferably a $C_3$-$C_{25}$ aliphatic ring; a $C_3$-$C_{18}$ aliphatic ring; or a $C_3$-$C_{12}$ aliphatic ring; and specifically, cyclobutane, cyclopentane, cyclohexane, bicycloheptane, adamantyl, etc.

Wherein when R' and R" are a heterocyclic group, preferably a $C_2$-$C_{30}$ heterocyclic group, more preferably a $C_2$-$C_{25}$ heterocyclic group, a $C_2$-$C_{18}$ heterocyclic group, or a $C_2$-$C_{12}$ heterocyclic group, such as pyrazine, thiophene, pyridine, pyrimidine, quinoline, pyrimidoindole, 5-phenyl-5H-pyrimido[5,4-b]indole, quinazoline, quinoxaline, benzoquinazoline, carbazole, dibenzoquinazoline, benzofuran, benzothiophene, dibenzofuran, dibenzothiophene, benzothienopyrimidine, benzofuropyrimidine, phenothiazine, phenylphenothiazine, naphthobenzofuran, naphthobenzothiophene, etc.

n is an integer from 1 to 3,

wherein the aryl group, arylene group, heterocyclic group, fluorenyl group, fluorenylene group, fused ring group, aliphatic ring group, alkyl group, alkenyl group, alkynyl group, alkoxy group and aryloxy group may be substituted with one or more substituents selected from the group consisting of deuterium; halogen; silane group substituted or unsubstituted with a $C_1$-$C_{20}$ alkyl group or a $C_6$-$C_{20}$ aryl group; siloxane group; boron group; germanium group; cyano group; nitro group; $C_1$-$C_{20}$ alkylthio group; $C_1$-$C_{20}$ alkoxyl group; $C_6$-$C_{20}$ aryloxy group; $C_1$-$C_{20}$ alkyl group; $C_2$-$C_{20}$ alkenyl group; $C_2$-$C_{20}$ alkynyl group; $C_6$-$C_{20}$ aryl group; $C_6$-$C_{20}$ aryl group substituted with deuterium; a fluorenyl group; $C_2$~$C_{20}$ heterocyclic group; a $C_3$-$C_{20}$ cycloalkyl ring; a $C_7$-$C_{20}$ arylalkyl group; a $C_8$-$C_{20}$ arylalkenyl group; and -L'-NR'R"; also the hydrogen of these substituents may be further substituted with one or more deuterium, and also the substituents may be bonded to each other to form a saturated or unsaturated ring, wherein the term 'ring' means a $C_3$-$C_{60}$ aliphatic ring or a $C_6$-$C_{60}$ aromatic ring or a $C_2$-$C_{60}$ heterocyclic group or a fused ring formed by the combination thereof.

Additionally, at least one of the $Ar^1$, $Ar^2$ and $Ar^3$ and/or at least one of $Ar^4$, $Ar^5$, $Ar^6$ and $Ar^7$ is represented by any one of Formulae Ar-a to Ar-d:

Formula Ar-a

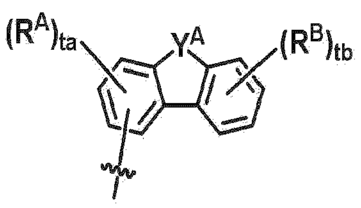

Formula Ar-b

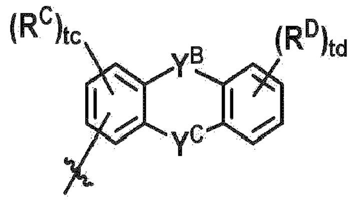

Formula Ar-c Formula Ar-d

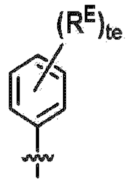

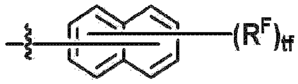

Wherein:

$Y^A$, $Y^B$ and $Y^C$ are each independently O, S, $NR^{1A}$, $Si(R^{1B})(R^{1C})$ or $C(R^{1B})(R^{1C})$,

$R^A$, $R^B$, $R^C$, $R^D$, $R^E$, $R^F$, $R^{1A}$, $R^{1B}$ and $R^{1C}$ are each the same or different, and each independently selected from the group consisting of a hydrogen; deuterium; halogen; cyano group; $C_6$-$C_{20}$ aryl group; $C_6$-$C_{20}$ aryl group substituted with deuterium; a fluorenyl group; a $C_2$-$C_{60}$ heterocyclic group including at least one heteroatom of O, N, S, Si or P; $C_1$-$C_{20}$ alkyl group; $C_2$-$C_{20}$ alkenyl group; $C_2$-$C_{20}$ alkynyl group; $C_1$-$C_{20}$ alkoxyl group; $C_6$-$C_{20}$ aryloxy group; and -L'-N(R')(R"); or an adjacent plurality of $R^A$s or plurality of $R^B$s or plurality of $R^C$s or plurality of $R^D$s or plurality of $R^E$s or plurality of $R^F$s may be bonded to each other to form a ring, or $R^{1B}$ and $R^{1C}$ can be bonded to each other to form a spiro,

ta and tc are each independently an integer of 0 to 3, tb and td are each independently an integer of 0 to 4, te is an integer of 0 to 5, tf is an integer of 0 to 7,

L', R' and R" are the same as defined above,

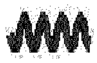

indicates the binding position.

Formula Ar-a is represented by any one of Formulas Ar-a-1 to Ar-a-4:

<Formula Ar-a-1> <Formula Ar-a-2>

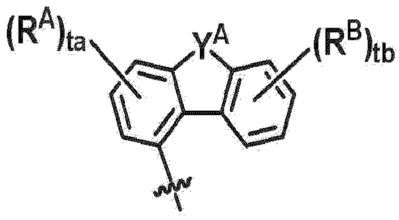

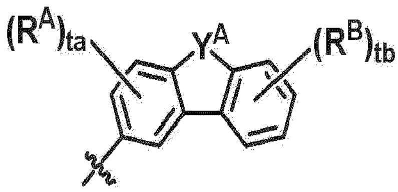

<Formula Ar-a-3> <Formula Ar-a-4>

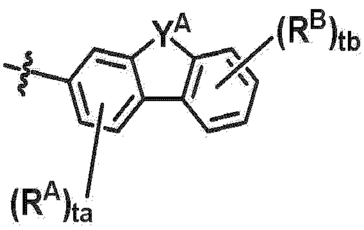

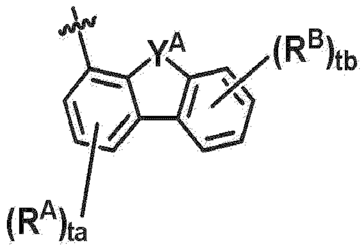

Wherein, $R^A$, $R^B$, $Y^A$, ta, tb and

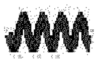

are the same as defined in Formula Ar-a.

Formula Ar-b is represented by any one of Formulas Ar-b-1 to Ar-b-2:

<Formula Ar-b-1> <Formula Ar-b-2>

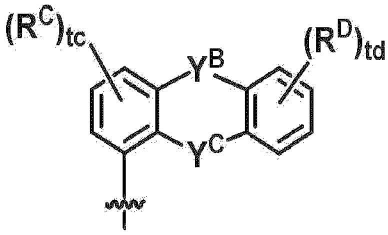

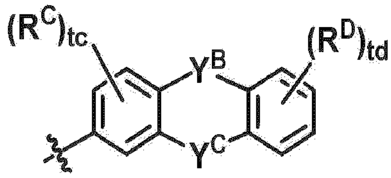

Wherein, $R^C$, $R^D$, $Y^B$, $Y^C$, tc, td and

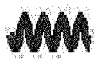

are the same as defined in Formula Ar-b.

Formula Ar-d is represented by any one of Formulas Ar-d-1 to Ar-d-2:

<Formula Ar-d-1> <Formula Ar-d-2>

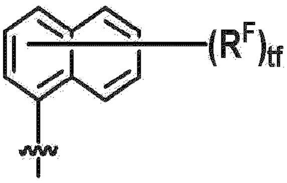

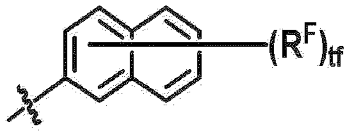

Wherein, $R^F$, tf and

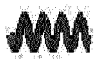

are the same as defined in Formula Ar-d.

$L^1$, $L^2$, $L^3$, $L^4$, $L^5$, $L^6$ and $L^7$ may be represented by a single bond or any one of Formulas b-1 to b-13, and $L^8$ may be represented by any one of Formulas b-1 to b-13.

Formula b-1 Formula b-2 Formula b-3 Formula b-4 Formula b-5 Formula b-6

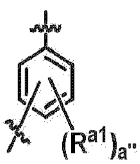

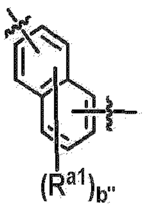

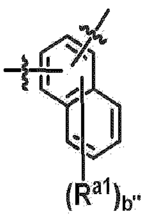

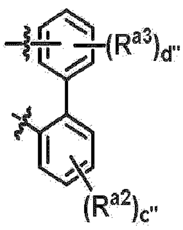

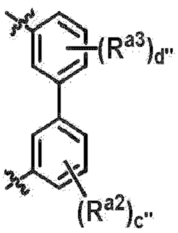

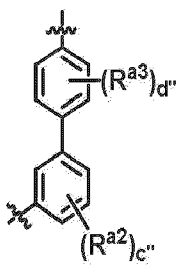

Formula b-7 Formula b-8 Formula b-9 Formula b-10

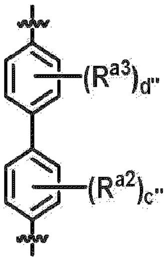
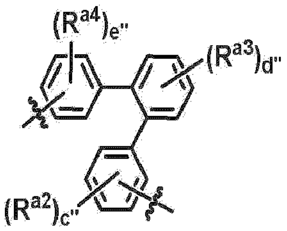
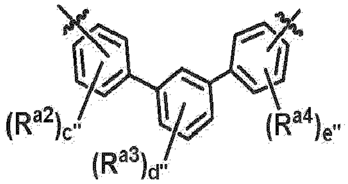
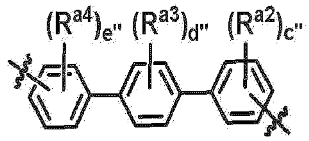

Formula b-11

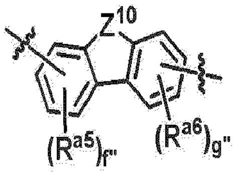

Formula b-12

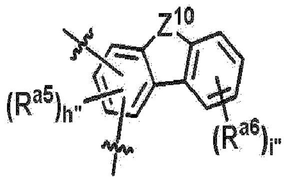

Formula b-13

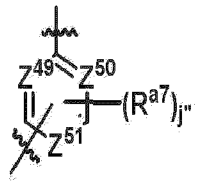

Wherein:

$Z^{10}$ is O, S, $NR^{1D}$ or $C(R^{1E})(R^{1F})$,

a", c", d", e" and i" are independently integers from 0 to 4, b" is an integer from 0 to 6, f" and g" are independently integers from 0 to 3, h" is an integer from 0 to 2, j" is an integer of 0 or 1,

$R^{a1}$, $R^{a2}$, $R^{a3}$, $R^{a4}$, $R^{a5}$, $R^{a6}$, $R^{a7}$, $R^{1D}$, $R^{1E}$ and $R^{1F}$ are each the same or different, and each independently selected from the group consisting of a hydrogen; deuterium; an $C_6$-$C_{20}$ aryl substituted or unsubstituted with deuterium; a fluorenyl group; a $C_2$-$C_{20}$ heterocyclic group including at least one heteroatom of O, N, S, Si or P; $C_1$-$C_{50}$ alkyl group; $C_2$-$C_{20}$ alkenyl group; $C_2$-$C_{20}$ alkynyl group; $C_1$-$C_{20}$ alkoxyl group; and $C_6$-$C_{20}$ aryloxy group; or adjacent groups can be bonded together to form a ring,

$Z^{49}$, $Z^{50}$ and $Z^{51}$ are each independently $CR^{1G}$ or N,

However, at least one of $Z^{49}$, $Z^{50}$ and $Z^{51}$ is N,

$R^{1G}$ is each independently selected from the group consisting of a hydrogen; deuterium; an $C_6$-$C_{20}$ aryl; a fluorenyl group; a $C_2$-$C_{20}$ heterocyclic group including at least one heteroatom of O, N, S, Si or P; $C_1$-$C_{20}$ alkyl group; $C_2$-$C_{20}$ alkenyl group; $C_2$-$C_{20}$ alkynyl group; $C_1$-$C_{20}$ alkoxyl group; and $C_6$-$C_{20}$ aryloxy group;

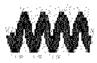

indicates the binding position.

Specifically, the compound represented by Formula 1 may be a compound represented by any one of the compounds P1-1 to P1-96, but is not limited thereto.

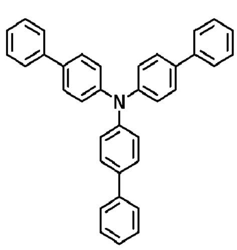

P1-1

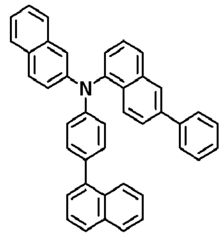

P1-2

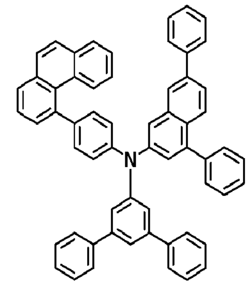

P1-3

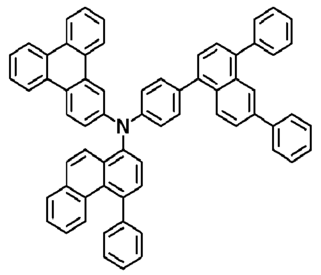

P1-4

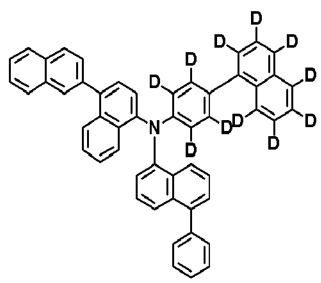

P1-5

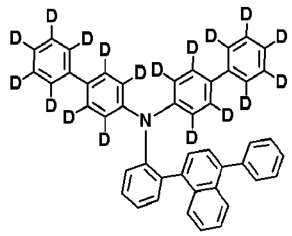

P1-6

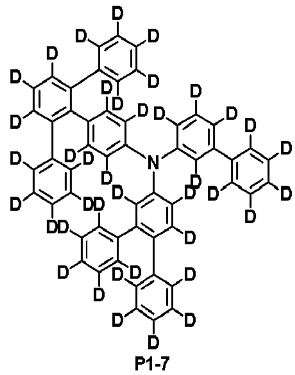

P1-7

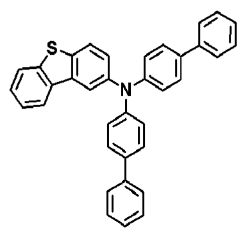

P1-8

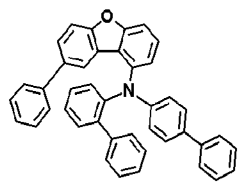

P1-9

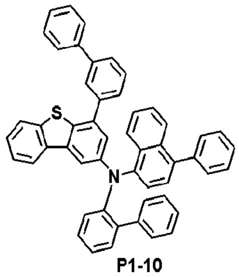

P1-10

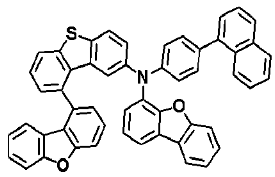

P1-11

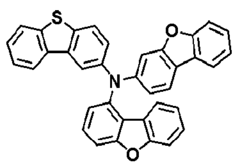

P1-12

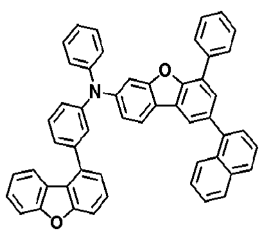

P1-13

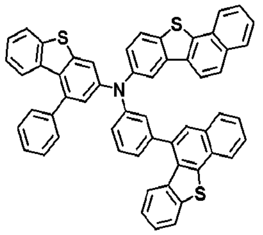

P1-14

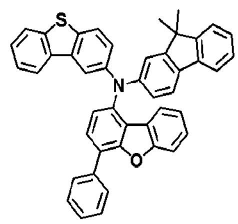

P1-15

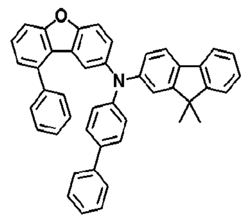

P1-16

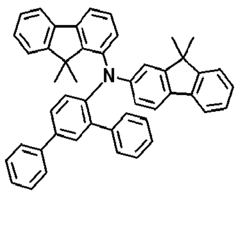

P1-17

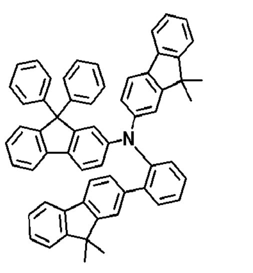

P1-18

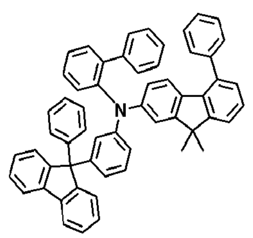

P1-19

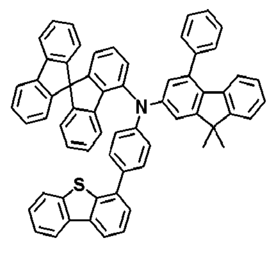

P1-20

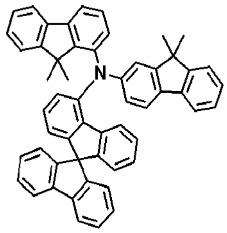

P1-21

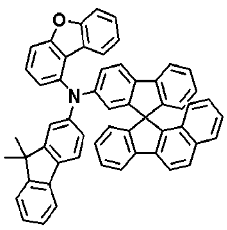

P1-22

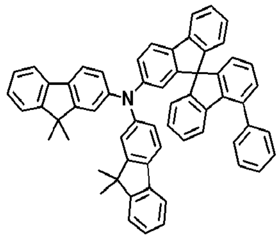

P1-23

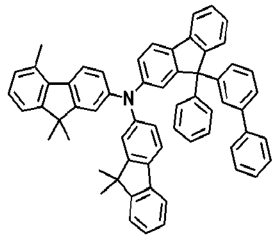

P1-24

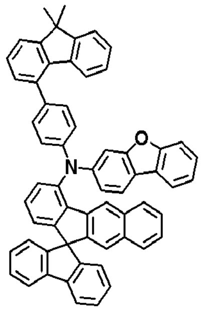

P1-25

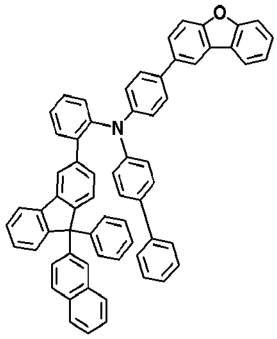

P1-26

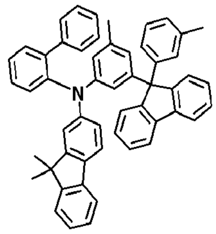

P1-27

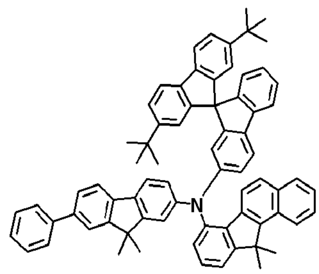

P1-28

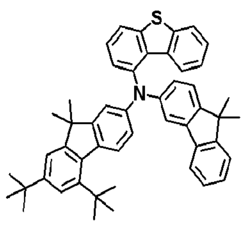

P1-29

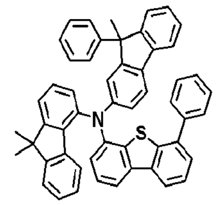

P1-30

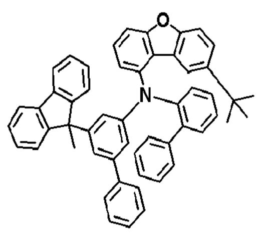

P1-31

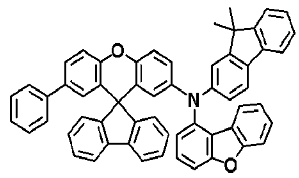

P1-32

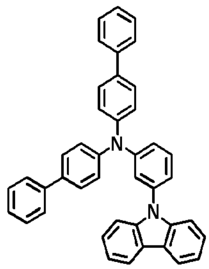

P1-33

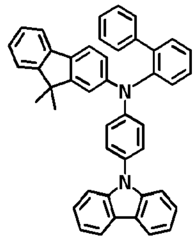

P1-34

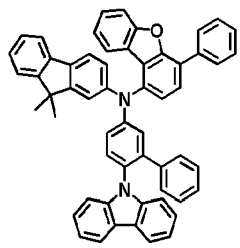

P1-35

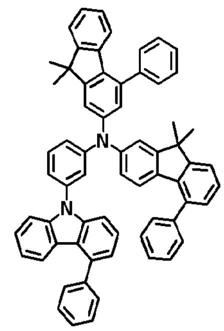

P1-36

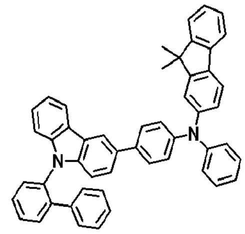

P1-37

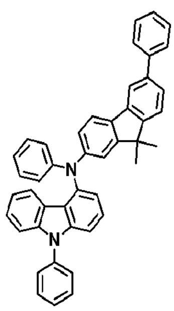

P1-38

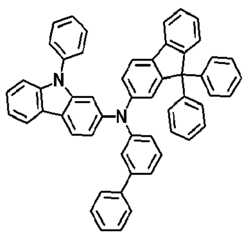

P1-39

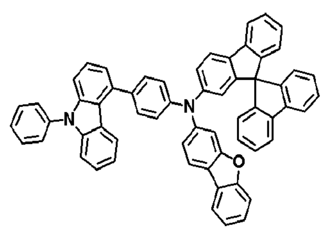

P1-40

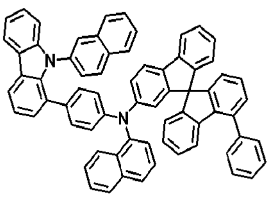
P1-41

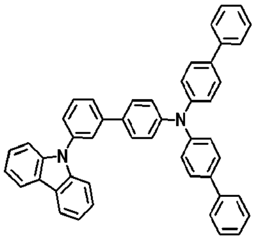
P1-42

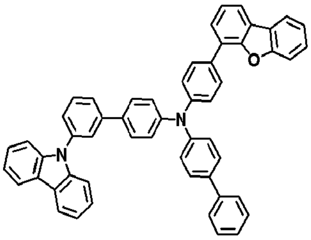
P1-43

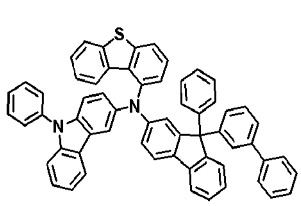
P1-44

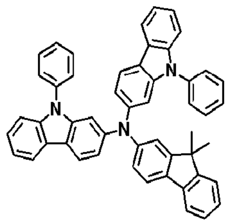
P1-45

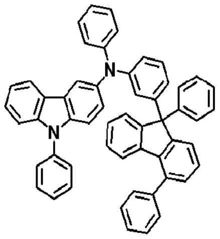
P1-46

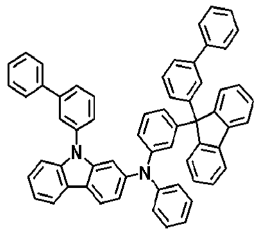
P1-47

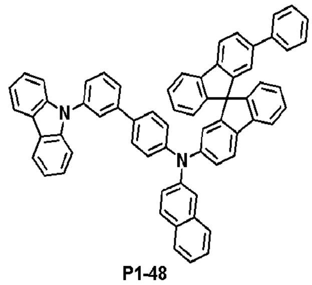
P1-48

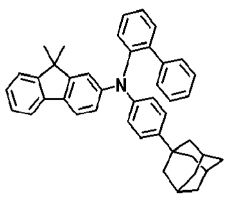
P1-49

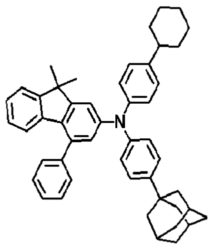
P1-50

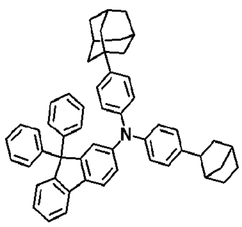
P1-51

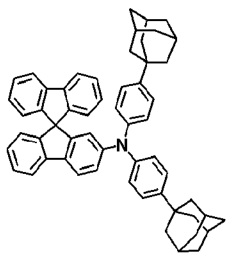
P1-52

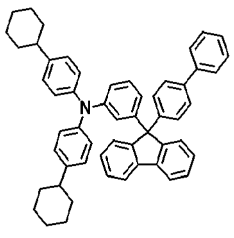
P1-53

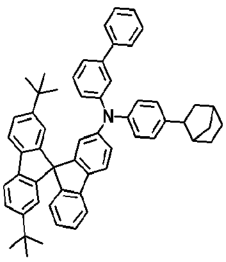
P1-54

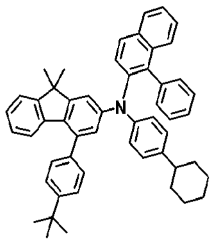
P1-55

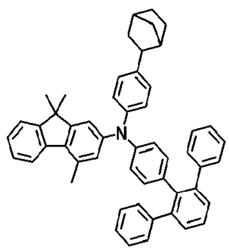
P1-56

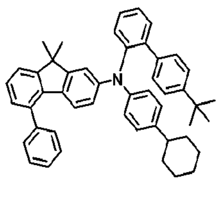
P1-57

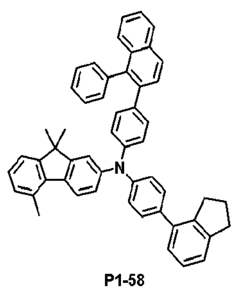
P1-58

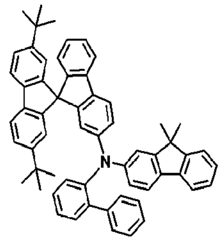
P1-59

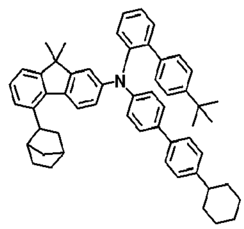
P1-60

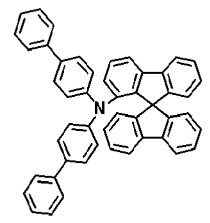
P1-61

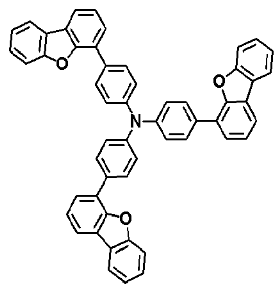
P1-62

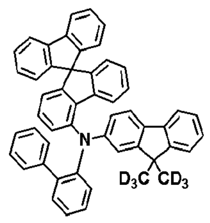
P1-63

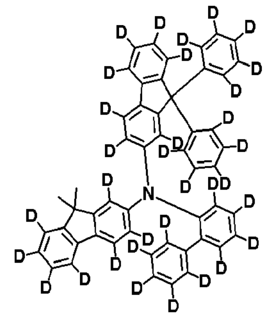
P1-64

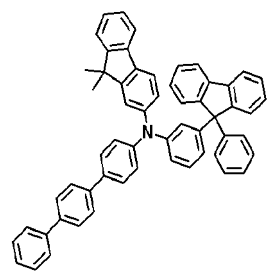
P1-65

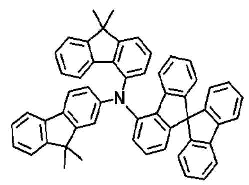
P1-66

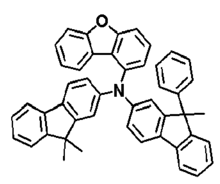
P1-67

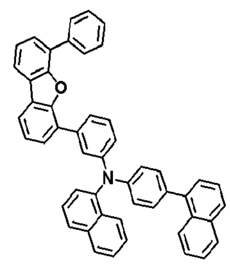
P1-68

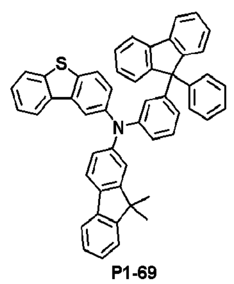
P1-69

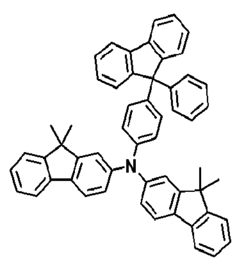
P1-70

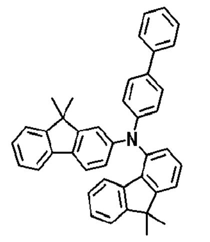
P1-71

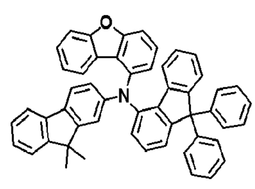
P1-72

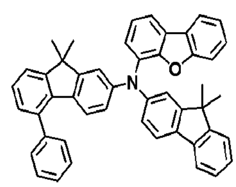
P1-73

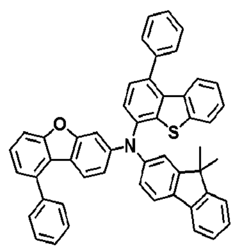
P1-74

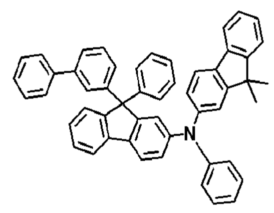
P1-75

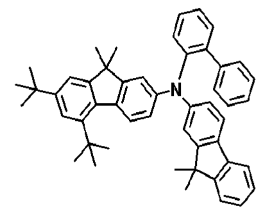
P1-76

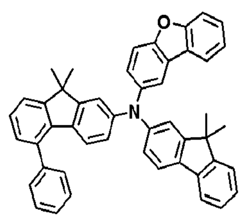
P1-77

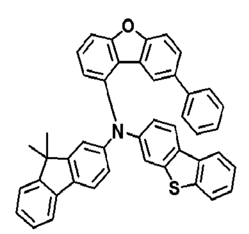
P1-78

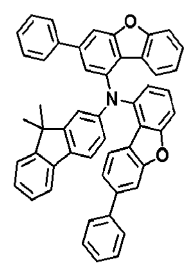
P1-79

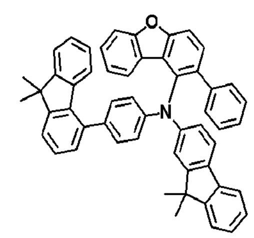
P1-80

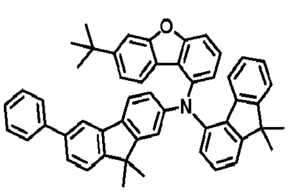
P1-81

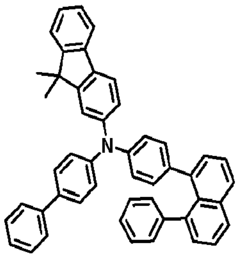
P1-82

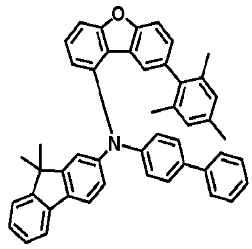
P1-83

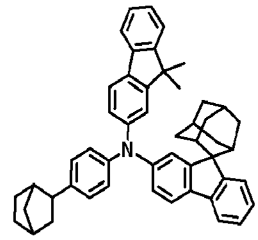
P1-84

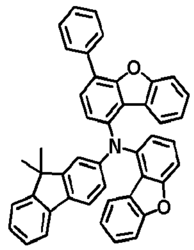
P1-85

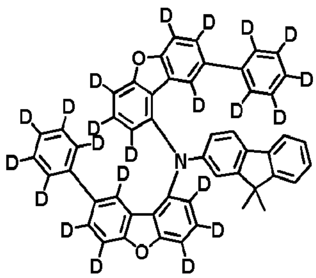
P1-86

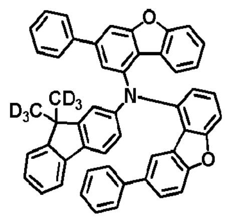
P1-87

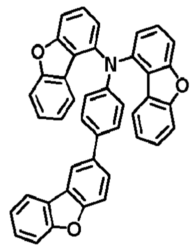
P1-88

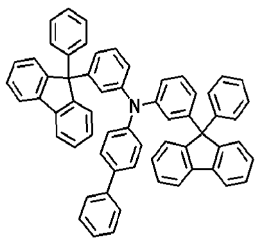
P1-89

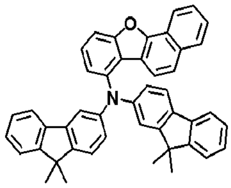
P1-90

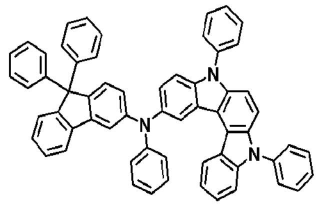
P1-91

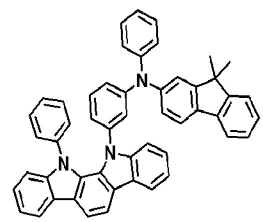
P1-92

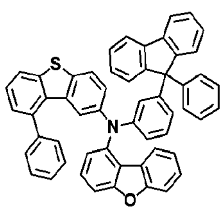
P1-93

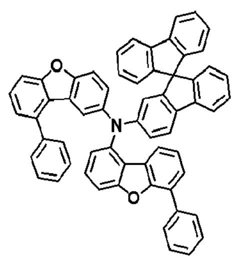
P1-94

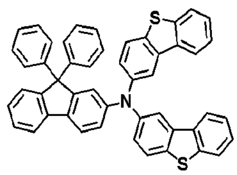
P1-95

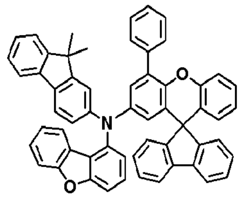
P1-96

Specifically, the compound represented by Formula 2 may be any one of the following compounds P2-1 to P2-76, but is not limited thereto.

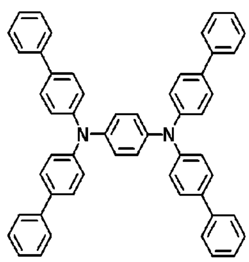
P2-1

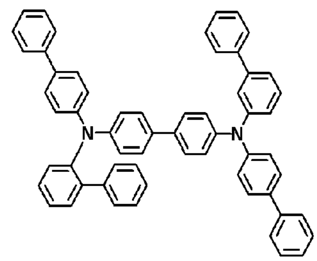
P2-2

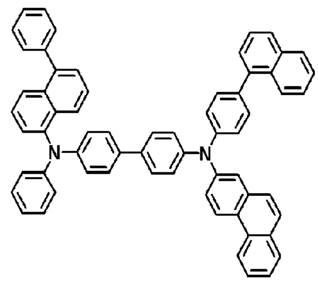
P2-3

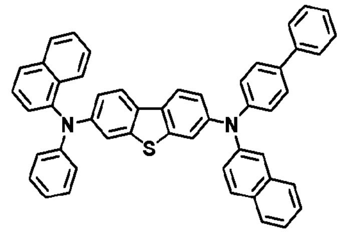

P2-4

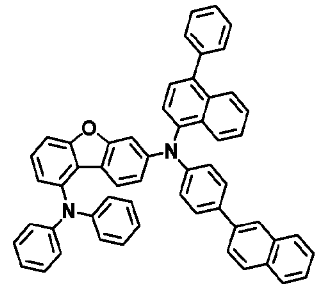

P2-5

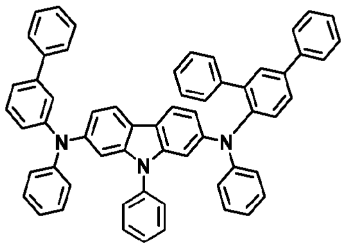

P2-6

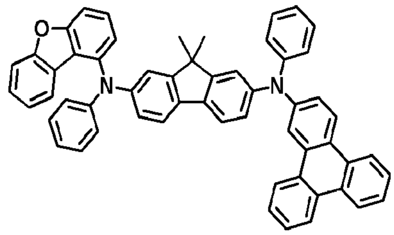

P2-7

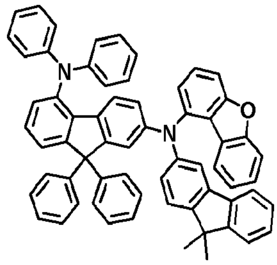

P2-8

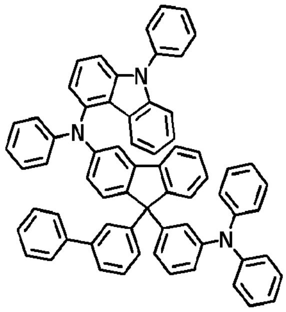

P2-9

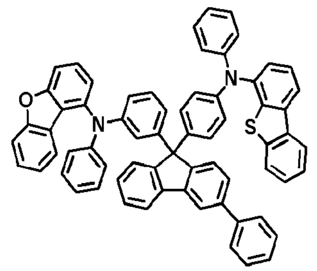

P2-10

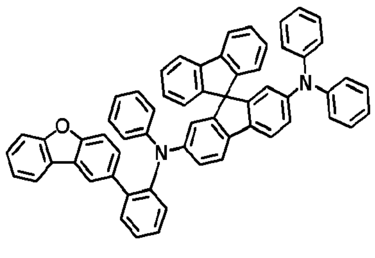

P2-11

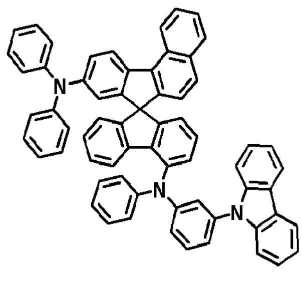

P2-12

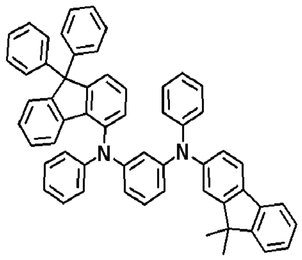

P2-13

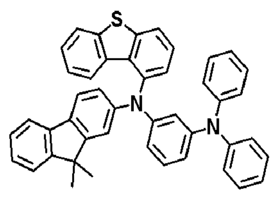

P2-14

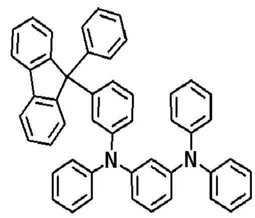

P2-15

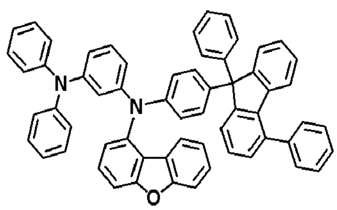

P2-16

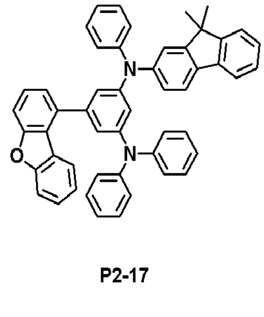

P2-17

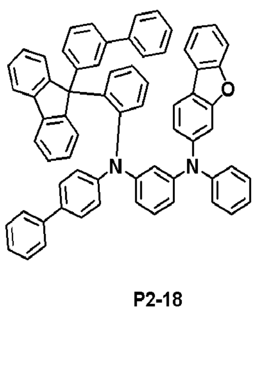

P2-18

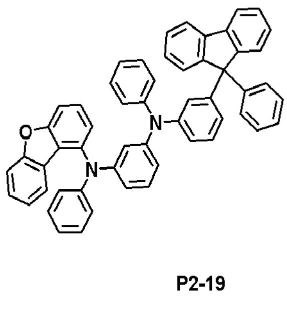

P2-19

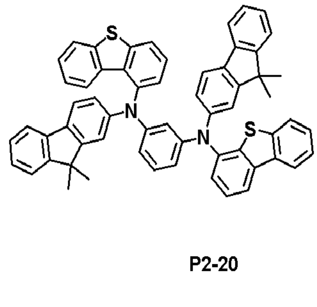

P2-20

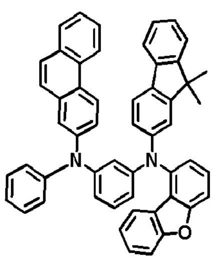

P2-21

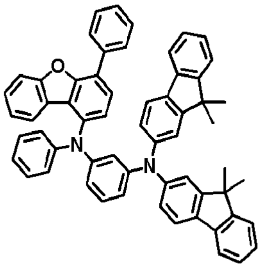

P2-22

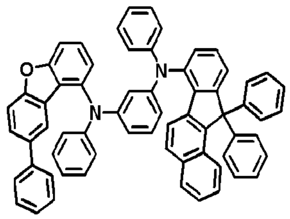

P2-23

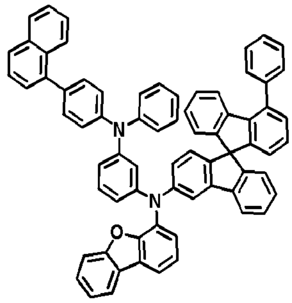

P2-24

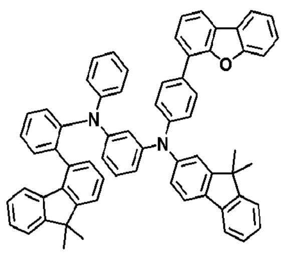

P2-25

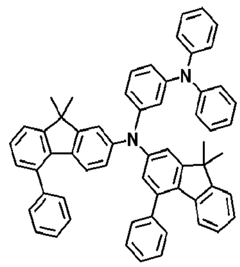

P2-26

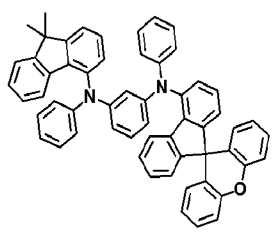

P2-27

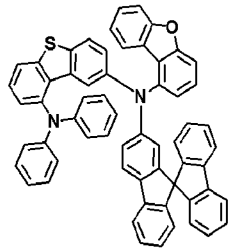

P2-28

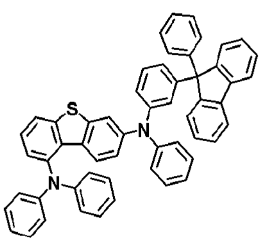

P2-29

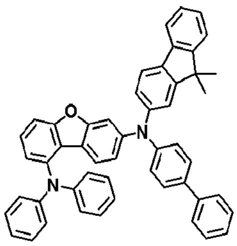

P2-30

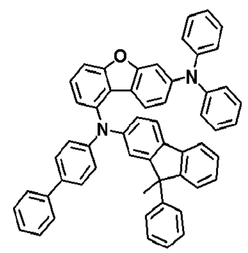

P2-31

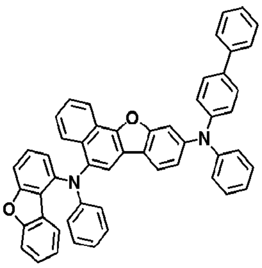

P2-32

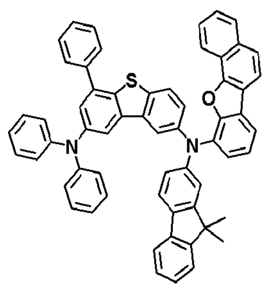

P2-33

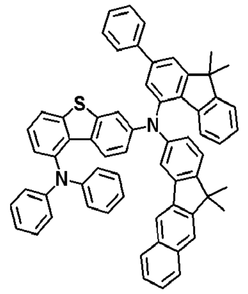

P2-34

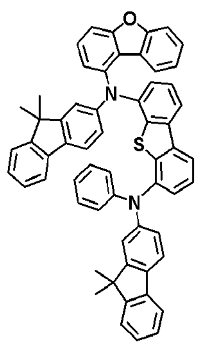

P2-35

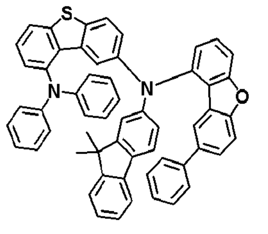

P2-36

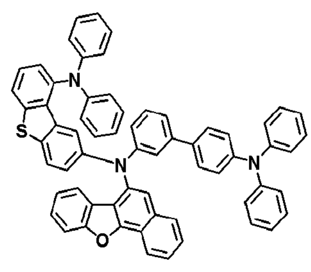

P2-37

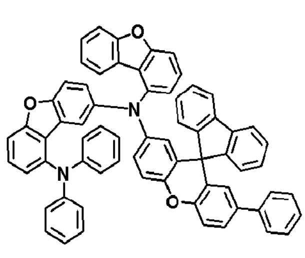

P2-38

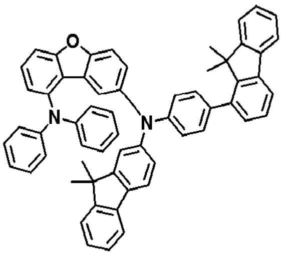

P2-39

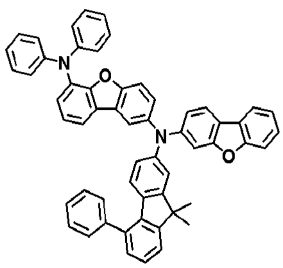

P2-40

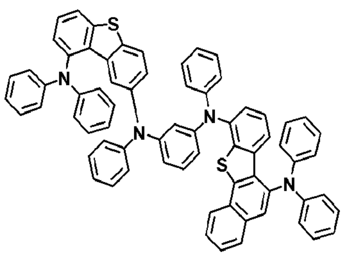

P2-41

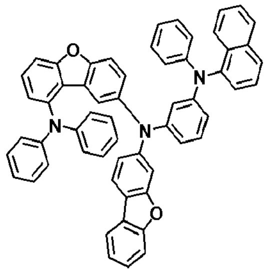

P2-42

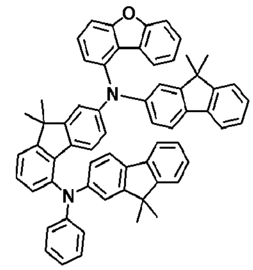

P2-43

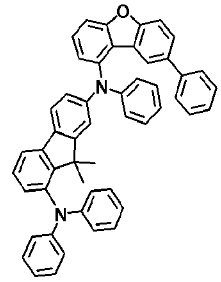

P2-44

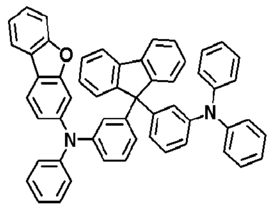

P2-45

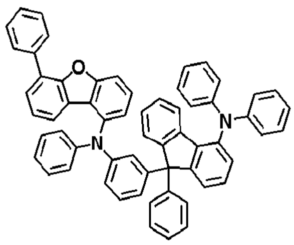

P2-46

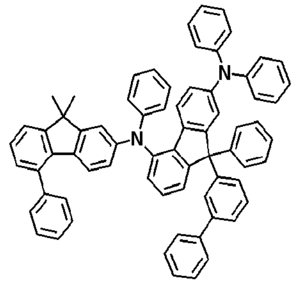

P2-47

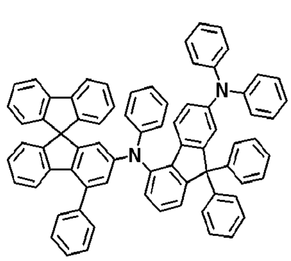

P2-48

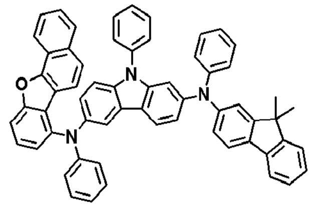

P2-49

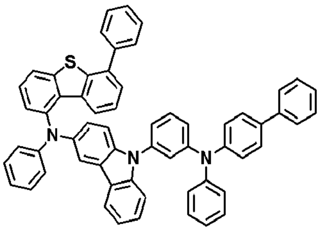

P2-50

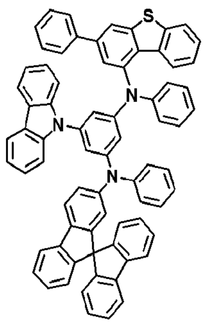

P2-51

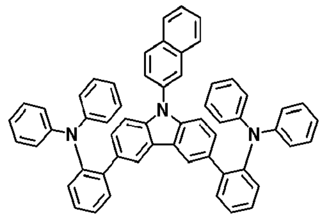

P2-52

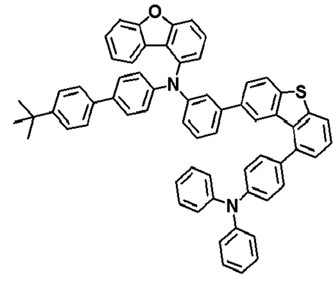

P2-53

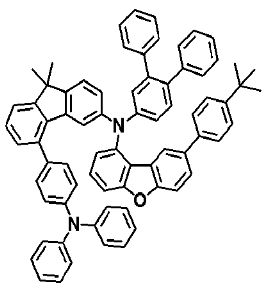

P2-54

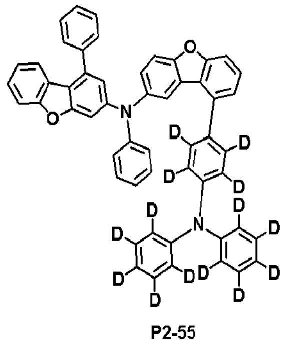

P2-55

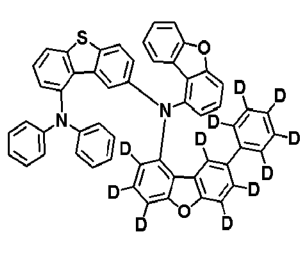

P2-56

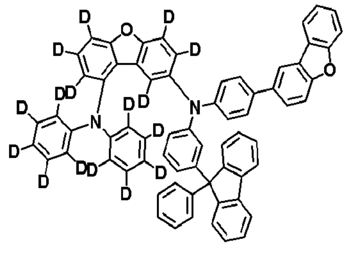

P2-57

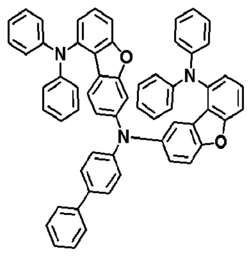

P2-58

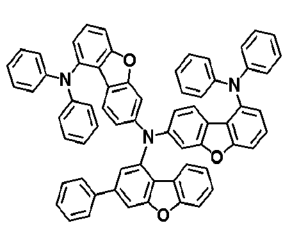

P2-59

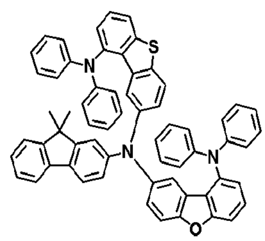

P2-60

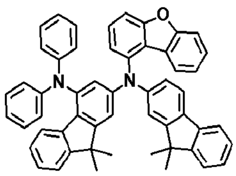

P2-61

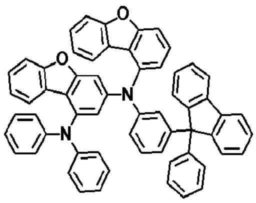

P2-62

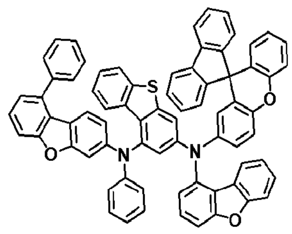

P2-63

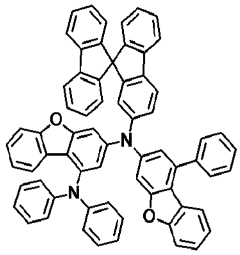

P2-64

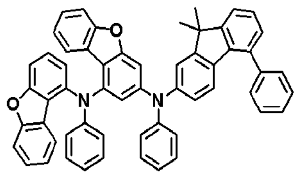

P2-65

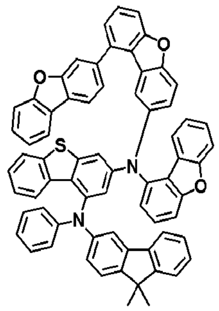

P2-66

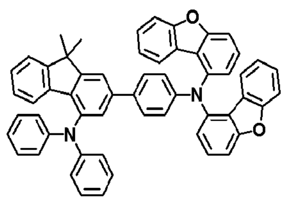

P2-67

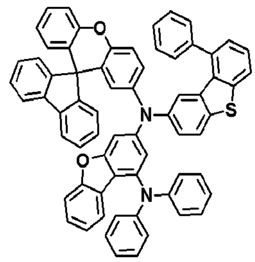

P2-68

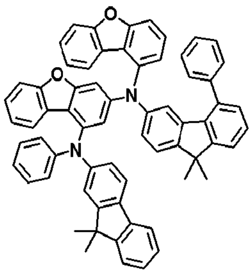

P2-69

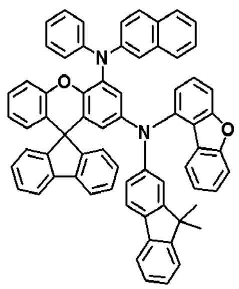

P2-70

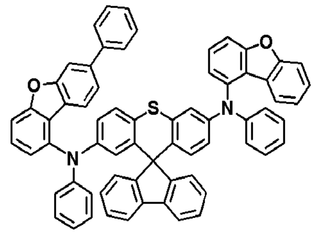

P2-71

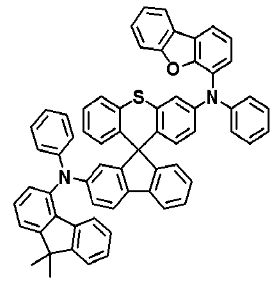

P2-72

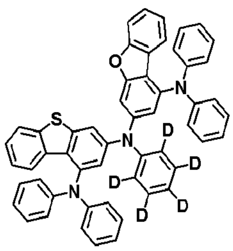

P2-73

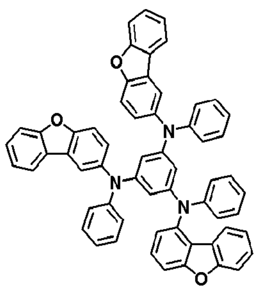

P2-74

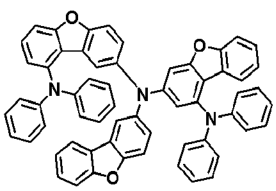

P2-75

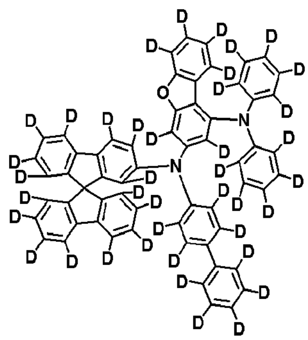

P2-76

The emitting-auxiliary layer plays a role in transporting and injecting holes from the hole transport layer to the emitting layer and in blocking electrons from the emitting layer to the hole transport layer. At this time, by controlling the injection of holes between the hole transport layer and the emitting-auxiliary layer, the amount of holes and electrons in the emitting layer can be controlled to be balanced. Here, the balance between the amount of holes and the amount of electrons means that the holes and electrons injected into the emitting layer recombine within the emitting layer to effectively form excitons for light emission. For example, if the amount of holes in the emitting layer becomes greater than the amount of electrons, non-radiative decay of holes are generated in addition to the holes involved in recombination, resulting in a loss of quantum efficiency of the element.

Therefore, by achieving a quantitative balance of injected holes and electrons, the amount of holes and electrons that are extinguished without contributing to light emission can be reduced, thereby affecting the element characteristics.

When there is an excess of holes in the emitting layer, the amount of holes injected in the hole transport band, such as the hole transport layer, buffer layer, and emitting-auxiliary layer, can be reduced to achieve a balance between holes and electrons in the emitting layer. In general, the hole mobility of the hole transport band, such as the hole transport layer, buffer layer, and emitting-auxiliary layer provided between the anode side terminal and the emitting layer, exhibits a faster characteristic than the electron mobility of the electron transport band, such as the electron transport-auxiliary layer and electron transport layer provided between the cathode and the emitting layer.

Therefore, it is important to control the amount of holes injected into the emitting layer in order to increase the luminescence efficiency of the element, and it may be more effective to control the injection of holes between the hole transport layer and the emitting-auxiliary layer than to control the injection of holes from the emitting-auxiliary layer to the emitting layer. Additionally, a buffer layer may be further included between the hole transport layer and the emitting-auxiliary layer.

The amount of holes injected into the emitting layer can be controlled depending on the emitting-auxiliary layer. When the hole trapping between the emitting-auxiliary layer and the emitting layer becomes stronger, $V_{Cmax}$ - $V_{C(0.8nF)}$ exceeds 1.3 V, which means that hole accumulation between the emitting-auxiliary layer and the emitting layer continues to occur. This can cause efficiency reduction and lifetime reduction due to the inability to form exciton and the unbalance of the amount of holes and electrons within the emitting layer due to the accumulation of carriers. If the hole accumulation between the emitting-auxiliary layer and the emitting layer is alleviated and the balance according to the hole injection control is improved, $V_{Cmax}$ - $V_{C(0.8nF)}$ shows a characteristic of less than 1.3 V, which can be said to be a characteristic of an organic electronic element in which not only hole accumulation is minimized but exciton formation is smooth. Therefore, the element characteristics of $V_{Cmax}$ - $V_{C(0.8nF)}$ are less than 1.3 V, and the efficiency of the organic electronic element can be improved and the operating time can be extended through the element design with the minimized value of $V_{Cmax}$.

In an OLED display, each pixel is made up of different colored subpixels to emit the desired color. Subpixels are fabricated by depositing a white-emitting OLED stack covering the entire surface of the matrix and positioning RGB (red, green, and blue) or RGBW (red, green, blue, and white) color filters on top of the OLED stack. Alternatively, different primary color OLED layers are configured within the subpixels. In this case, it is desirable to structure only the emitting layer after depositing common layers (layers prior to the emitting layer, hole injection layer, hole transport layer, emitting-auxiliary layer, etc.). However, it is observed that in the above 2 cases, they can interact through parasitic currents passing through the common layer of the OLED stack. Undesirable interaction between adjacent pixels or subpixels is known as "crosstalk". Crosstalk leads to undesirable color shifts, especially in the case of color screens. (See Korean Patent No. 10-1647160)

In the case of an OLED device such as Fig. 1, parasitic currents are observed in adjacent pixels or subpixels, not only in common layers but also in layers formed by overlapping layers of each color without being deposited perfectly separately during the process.

In this case, it is thought that the stability of the OLED device will be improved by limiting the parasitic current by controlling the lateral resistance change rate.

Preferably, the emitting layer according to the present invention is a red emitting layer or a green emitting layer, and preferably includes a phosphorescent emitter.

According to another embodiment of the present invention, the organic material layer may be formed in a form in which a plurality of stacks including a hole transport layer, an emitting-auxiliary layer, an emitting layer, and an electron transport layer are formed.

In general, organic light-emitting devices can be divided into single-light-emitting structure devices (Single OLED) and multilayer light-emitting structure devices (Tandem OLED) depending on the number of light-emitting parts. A multilayer light-emitting structure device (Tandem OLED) is an OLED device composed of 2 or more light-emitting parts (stack), and can easily improve efficiency and lifetime compared to existing single OLEDs.

Specifically, an organic electronic element according to one embodiment of the present invention may comprise a first electrode, a first stack formed on the first electrode, a second stack formed on the first stack, and a second electrode. Wherein, the stack may correspond to an organic material layer including an emitting layer, and a light efficiency enhancing layer may be further formed on a surface of the first electrode and/or the second electrode that is not in contact with the organic material layer.

The first stack and the second stack are organic material layers comprising a hole transport layer, an emitting layer, and an electron transport layer, respectively, and the first stack and the second stack can be formed with the same or different laminated structures.

At least one of the first stack and the second stack may comprise an emitting-auxiliary layer between the hole transport layer and the emitting layer, wherein the emitting-auxiliary layer may be a mixture containing the third compound. Wherein, the third compound may be an organic compound, an organometallic compound, or a metal compound. Additionally, a buffer layer may be comprised between the hole transport layer and the emitting-auxiliary layer, wherein the buffer layer may be comprised in the first stack and/or the second stack.

Additionally, a charge generation layer (CGL) can be formed between the first stack and the second stack. The

charge generation layer (CGL) may comprise a first charge generation layer and a second charge generation layer. These charge generation layers (CGLs) are formed between the emitting layers of the first stack and the emitting layers of the second stack to increase the current efficiency generated in each emitting layer and to smoothly distribute charges.

2 or more stacks of these organic material layers can be formed. For example, when 3 stacks are formed, a charge generation layer (CGL) and a third stack can be additionally laminated on the second stack.

In this manner, when a plurality of emitting layers is formed by a multilayer stack structure, it is possible to manufacture an organic light-emitting device that emits white light through the mixing effect of the light emitted from each emitting layer, and it is also possible to manufacture an organic light-emitting device that emits light of various colors.

The present invention may further comprise a light efficiency enhancing layer formed on at least one surface of the first electrode and the second electrode, which is opposite to the organic material layer.

Additionally, the organic material layer may comprise 2 or more stacks comprising a hole transport layer, an emitting layer, and an electron transport layer sequentially formed on the anode, and the organic material layer may further comprise a charge generation layer formed between the 2 or more stacks.

The organic material layer according to the present invention can be manufactured with a smaller number of layers by using various polymer materials, and not by a deposition method, but by a solution process or a solvent process, such as a spin coating process, a nozzle printing process, an inkjet printing process, a slot coating process, a dip coating process, a roll-to-roll process, a doctor blading process, a screen printing process, or a thermal transfer method. Since the organic material layer according to the present invention can be formed by various methods, the scope of the present invention is not limited by the formation method.

An organic electronic element according to one embodiment of the present invention may be a front-emitting, back-emitting, or both-sided emitting type depending on the material used.

Additionally, the organic electronic element according to one embodiment of the present invention may be selected from the group consisting of an organic light-emitting device, an organic solar cell, an organic photoconductor, an organic transistor, a monochrome lighting device, and a quantum dot display device.

Another embodiment of the present invention may include a display device comprising the organic electronic element of the present invention described above, and an electronic device comprising a control unit for driving the display device. Wherein the electronic device may be a current or future wired or wireless communication terminal, and includes all electronic devices such as mobile communication terminals such as mobile phones, PDAs, electronic dictionaries, PMPs, remote controls, navigation systems, game consoles, various TVs, and various computers.

Hereinafter, Synthesis examples of the compound represented by Formula 1 and Formula 2 according to the present invention and preparation examples of the organic electronic element will be described in detail by way of example, but are not limited to the following examples.

[Synthesis Example 1] Synthesis example of Formula 1

The compound (final products) represented by Formula 1 according to the present invention can be synthesized according to the reaction path of Reaction Scheme 1, but is not limited thereto.

< Reaction Scheme 1> ($Hal^1$ is I, Br or Cl)

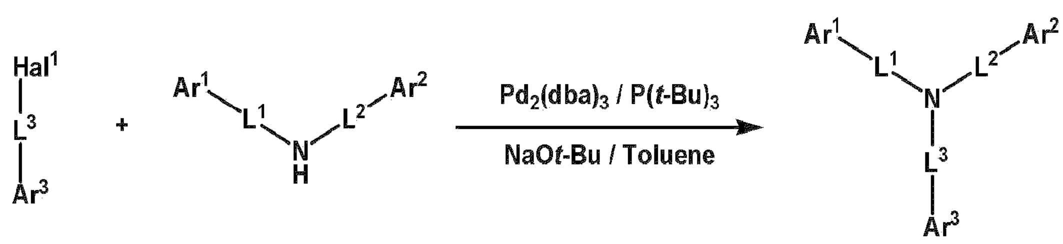


Sub 1 Sub 2 Final Product 1

I. Synthesis example of Sub 1

Compounds belonging to Sub 1 of Reaction scheme 1 may be, but are not limited to, the compounds below, and Table 1 shows the FD-MS (Field Desorption Mass Spectrometry) values of the compounds below.

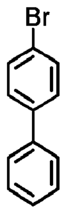
Sub 1-1

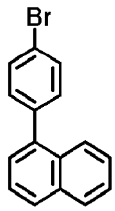
Sub 1-2

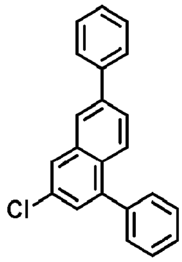
Sub 1-3

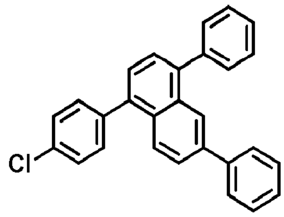
Sub 1-4

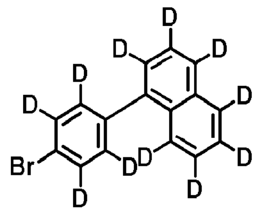
Sub 1-5

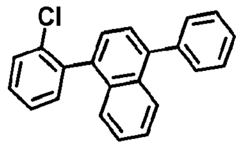
Sub 1-6

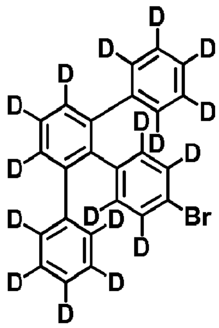
Sub 1-7

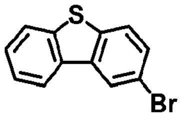
Sub 1-8

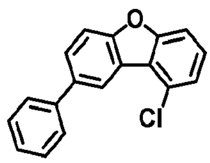
Sub 1-9

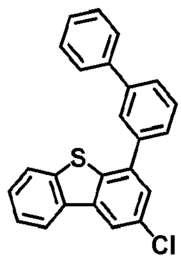
Sub 1-10

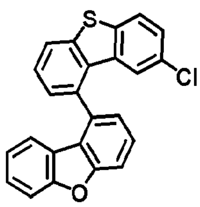
Sub 1-11

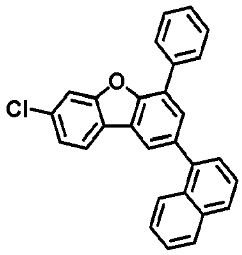
Sub 1-12

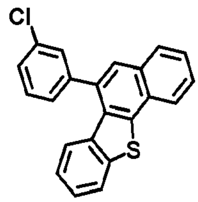
Sub 1-13

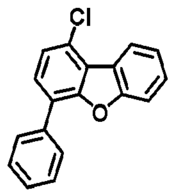
Sub 1-14

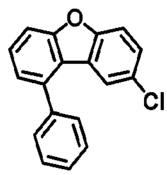
Sub 1-15

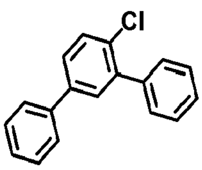
Sub 1-16

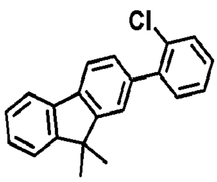
Sub 1-17

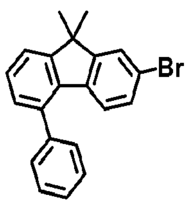
Sub 1-18

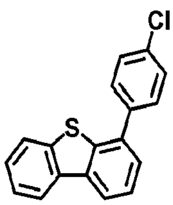
Sub 1-19

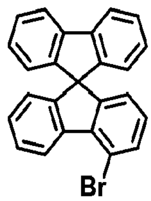
Sub 1-20

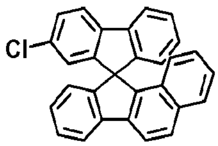
Sub 1-21

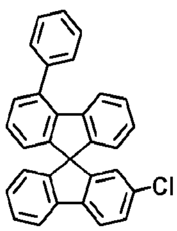
Sub 1-22

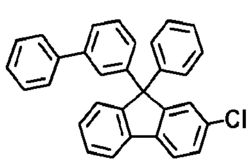
Sub 1-23

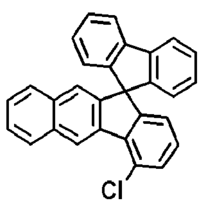
Sub 1-24

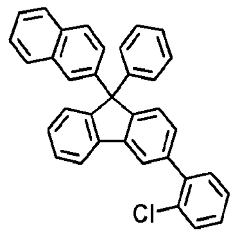
Sub 1-25

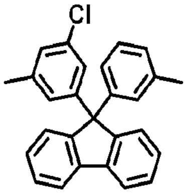

Sub 1-26

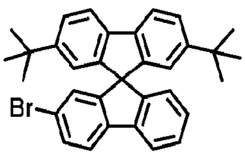

Sub 1-27

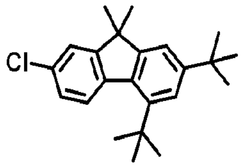

Sub 1-28

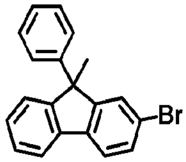

Sub 1-29

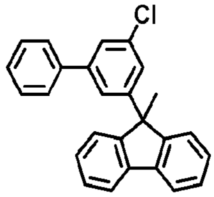

Sub 1-30

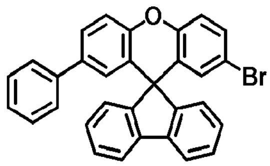

Sub 1-31

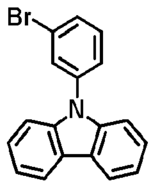

Sub 1-32

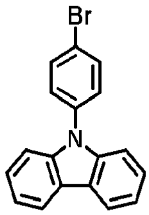

Sub 1-33

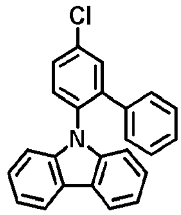

Sub 1-34

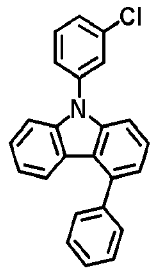

Sub 1-35

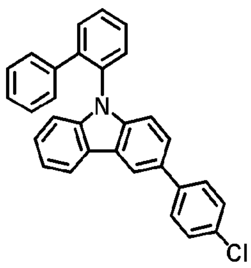

Sub 1-36

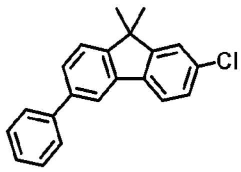

Sub 1-37

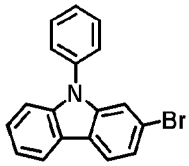

Sub 1-38

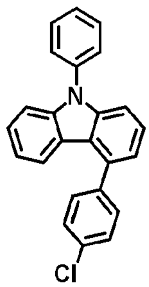

Sub 1-39

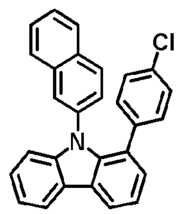

Sub 1-40

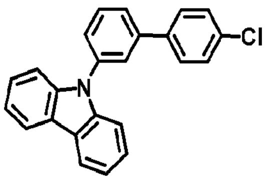

Sub 1-41

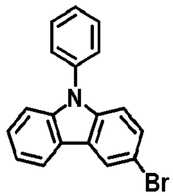

Sub 1-42

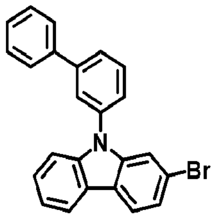

Sub 1-43

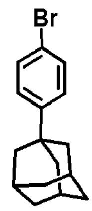

Sub 1-44

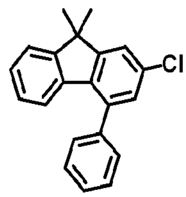

Sub 1-45

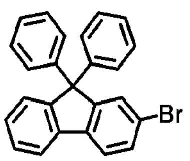

Sub 1-46

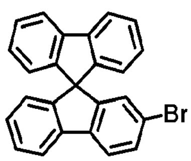

Sub 1-47

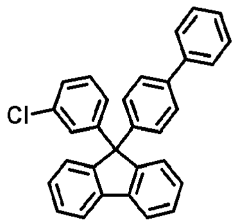

Sub 1-48

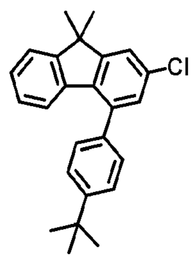

Sub 1-49

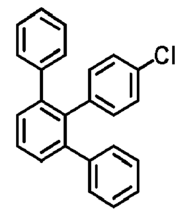

Sub 1-50

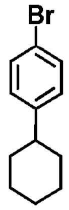 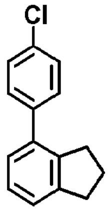 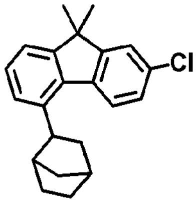 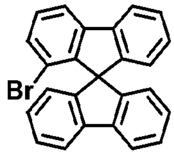 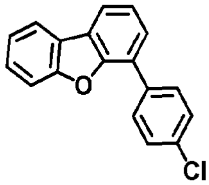

Sub 1-51 Sub 1-52 Sub 1-53 Sub 1-54 Sub 1-55

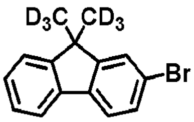 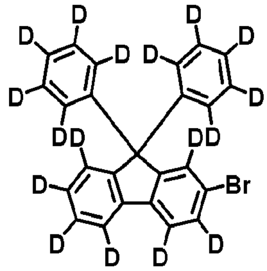 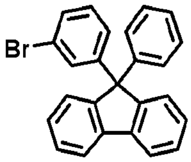 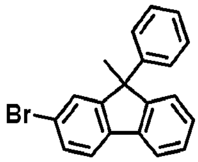 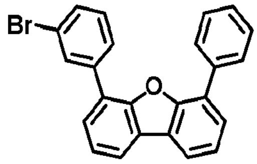

Sub 1-56 Sub 1-57 Sub 1-58 Sub 1-59 Sub 1-60

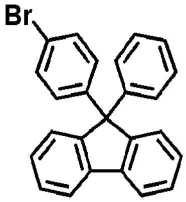 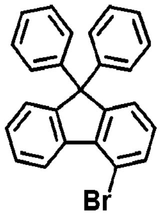 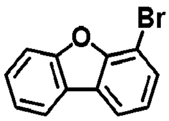 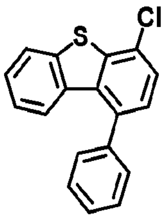 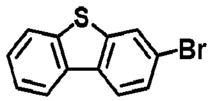

Sub 1-61 Sub 1-62 Sub 1-63 Sub 1-64 Sub 1-65

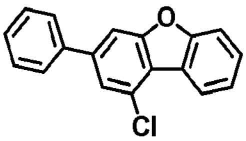 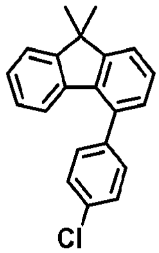 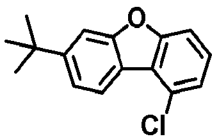 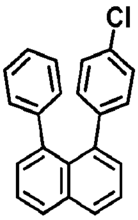 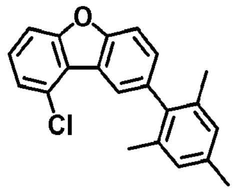

Sub 1-66 Sub 1-67 Sub 1-68 Sub 1-69 Sub 1-70

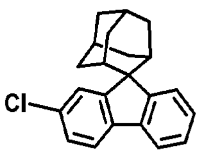 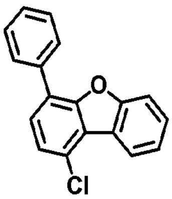 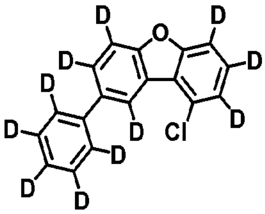 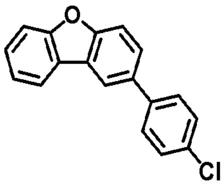 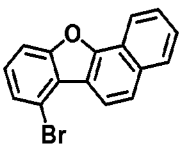

Sub 1-71 Sub 1-72 Sub 1-73 Sub 1-74 Sub 1-75

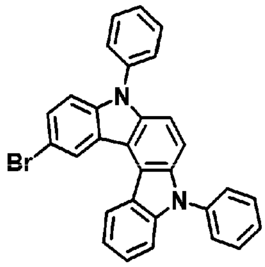 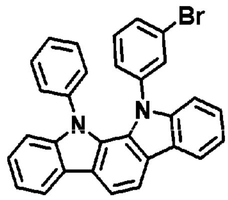 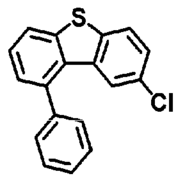 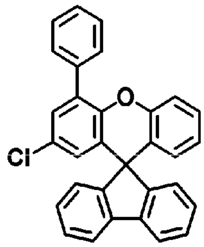

**Sub 1-76** **Sub 1-77** **Sub 1-78** **Sub 1-79**

[Table 1]

| compound | FD-MS | compound | FD-MS |
|---|---|---|---|
| Sub 1-1 | m/z=231.99(C12H9Br=233.11) | Sub 1-2 | m/z=282(C16H11Br=283.17) |
| Sub 1-3 | m/z=314.09(C22H15Cl=314.81) | Sub 1-4 | m/z=390.12(C28H19Cl=390.91) |
| Sub 1-5 | m/z=293.07(C16D11Br=294.24) | Sub 1-6 | m/z=314.09(C22H15Cl=314.81) |
| Sub 1-7 | m/z=401.16(C24D17Br=402.41) | Sub 1-8 | m/z=261.95(C12H7BrS=263.15) |
| Sub 1-9 | m/z=278.05(C18H11ClO=278.74) | Sub 1-10 | m/z=370.06(C24H15ClS=370.89) |
| Sub 1-11 | m/z=384.04(C24H13ClOS=384.88) | Sub 1-12 | m/z=404.1(C28H17ClO=404.89) |
| Sub 1-13 | m/z=344.04(C22H13ClS=344.86) | Sub 1-14 | m/z=278.05(C18H11ClO=278.74) |
| Sub 1-15 | m/z=278.05(C18H11ClO=278.74) | Sub 1-16 | m/z=264.07(C18H13Cl=264.75) |
| Sub 1-17 | m/z=304.1(C21H17Cl=304.82) | Sub 1-18 | m/z=348.05(C21H17Br=349.27) |
| Sub 1-19 | m/z=294.03(C18H11ClS=294.8) | Sub 1-20 | m/z=394.04(C25H15Br=395.3) |
| Sub 1-21 | m/z=400.1(C29H17Cl=400.9) | Sub 1-22 | m/z=426.12(C31H19Cl=426.94) |
| Sub 1-23 | m/z=428.13(C31H21Cl=428.96) | Sub 1-24 | m/z=400.1(C29H17Cl=400.9) |
| Sub 1-25 | m/z=478.15(C35H23Cl=479.02) | Sub 1-26 | m/z=380.13(C27H21Cl=380.91) |
| Sub 1-27 | m/z=506.16(C33H31Br=507.51) | Sub 1-28 | m/z=340.2(C23H29Cl=340.93) |
| Sub 1-29 | m/z=334.04(C20H15Br=335.24) | Sub 1-30 | m/z=366.12(C26H19Cl=366.89) |
| Sub 1-31 | m/z=486.06(C31H19BrO=487.4) | Sub 1-32 | m/z=321.02(C18H12BrN=322.2) |
| Sub 1-33 | m/z=321.02(C18H12BrN=322.2) | Sub 1-34 | m/z=353.1(C24H16ClN=353.85) |
| Sub 1-35 | m/z=353.1(C24H16ClN=353.85) | Sub 1-36 | m/z=429.13(C30H20ClN=429.95) |
| Sub 1-37 | m/z=304.1(C21H17Cl=304.82) | Sub 1-38 | m/z=321.02(C18H12BrN=322.2) |
| Sub 1-39 | m/z=353.1(C24H16ClN=353.85) | Sub 1-40 | m/z=403.11(C28H18ClN=403.91) |
| Sub 1-41 | m/z=353.1(C24H16ClN=353.85) | Sub 1-42 | m/z=321.02(C18H12BrN=322.2) |
| Sub 1-43 | m/z=397.05(C24H16BrN=398.3) | Sub 1-44 | m/z=290.07(C16H19Br=291.23) |
| Sub 1-45 | m/z=304.1(C21H17Cl=304.82) | Sub 1-46 | m/z=396.05(C25H17Br=397.31) |
| Sub 1-47 | m/z=394.04(C25H15Br=395.3) | Sub 1-48 | m/z=428.13(C31H21Cl=428.96) |
| Sub 1-49 | m/z=360.16(C25H25Cl=360.92) | Sub 1-50 | m/z=340.1(C24H17Cl=340.85) |
| Sub 1-51 | m/z=238.04(C12H15Br=239.16) | Sub 1-52 | m/z=228.07(C15H13Cl=228.72) |
| Sub 1-53 | m/z=322.15(C22H23Cl=322.88) | Sub 1-54 | m/z=394.04(C25H15Br=395.3) |
| Sub 1-55 | m/z=278.05(C18H11ClO=278.74) | Sub 1-56 | m/z=278.06(C15H7D6Br=279.21) |
| Sub 1-57 | m/z=413.16(C25D17Br=414.42) | Sub 1-58 | m/z=396.05(C25H17Br=397.31) |
| Sub 1-59 | m/z=334.04(C20H15Br=335.24) | Sub 1-60 | m/z=398.03(C24H15BrO=399.29) |

(continued)

| compound | FD-MS | compound | FD-MS |
|---|---|---|---|
| Sub 1-61 | m/z=396.05(C25H17Br=397.31) | Sub 1-62 | m/z=396.05(C25H17Br=397.31) |
| Sub 1-63 | m/z = 245.97 (C12 H7BrO = 247.09) | Sub 1-64 | m/z=294.03(C18H11ClS=294.8) |
| Sub 1-65 | m/z=261.95(C12H7BrS=263.15) | Sub 1-66 | m/z=278.05(C18H11ClO=278.74) |
| Sub 1-67 | m/z=304.1(C21H17Cl=304.82) | Sub 1-68 | m/z=258.08(C16H15ClO=258.75) |
| Sub 1-69 | m/z=314.09(C22H15Cl=314.81) | Sub 1-70 | m/z=320.1(C21H17ClO=320.82) |
| Sub 1-71 | m/z=320.13(C22H21Cl=320.86) | Sub 1-72 | m/z=278.05(C18H11ClO=278.74) |
| Sub 1-73 | m/z=289.12(C18D11ClO=289.8) | Sub 1-74 | m/z=278.05(C18H11ClO=278.74) |
| Sub 1-75 | m/z=295.98(C16H9BrO=297.15) | Sub 1-76 | m/z=486.07(C30H19BrN2=487.4) |
| Sub 1-77 | m/z=486.07(C30H19BrN2=487.4) | Sub 1-78 | m/z=294.03(C18H11ClS=294.8) |
| Sub 1-79 | m/z=442.11(C31H19ClO=442.94) | | |

II. Synthesis example of Sub 2

Compounds belonging to Sub 2 of Reaction scheme 1 may be, but are not limited to, the compounds below, and Table 2 shows the FD-MS (Field Desorption Mass Spectrometry) values of the compounds below.

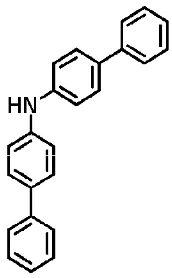

**Sub 2-1**

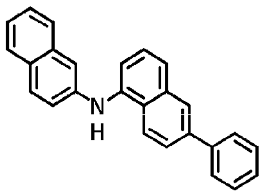

**Sub 2-2**

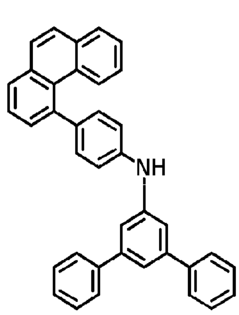

**Sub 2-3**

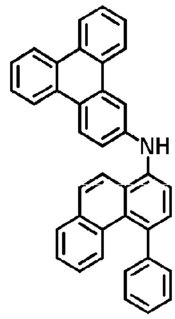

**Sub 2-4**

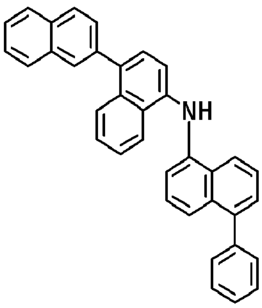

**Sub 2-5**

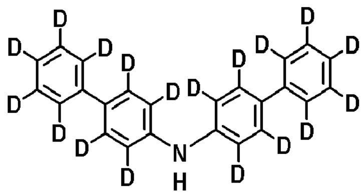

**Sub 2-6**

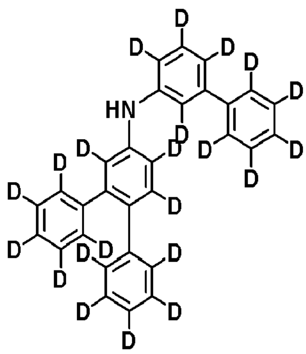

**Sub 2-7**

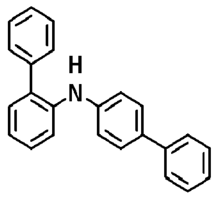

**Sub 2-8**

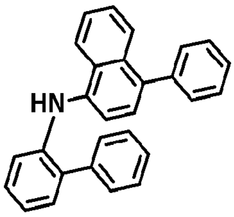

Sub 2-9

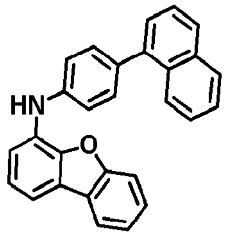

Sub 2-10

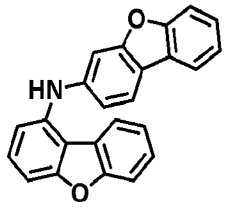

Sub 2-11

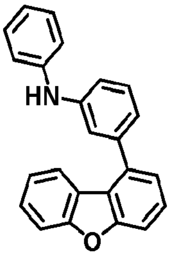

Sub 2-12

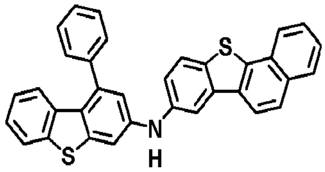

Sub 2-13

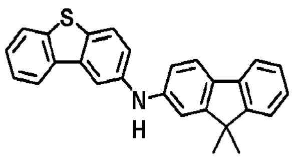

Sub 2-14

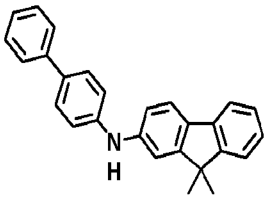

Sub 2-15

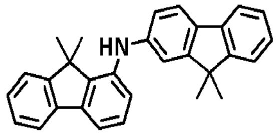

Sub 2-16

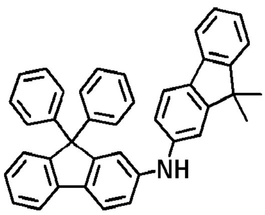

Sub 2-17

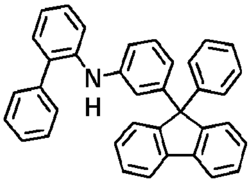

Sub 2-18

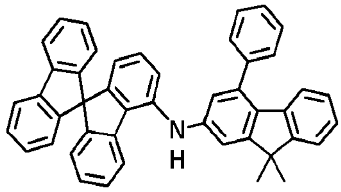

Sub 2-19

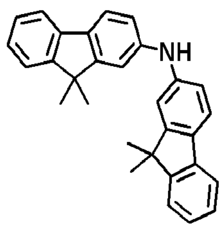

Sub 2-20

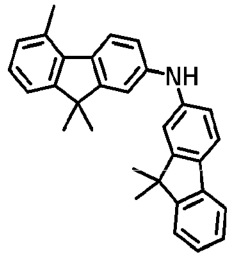

Sub 2-21

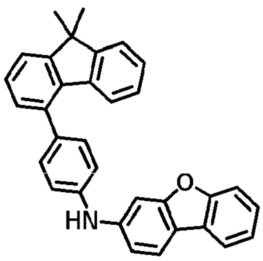

Sub 2-22

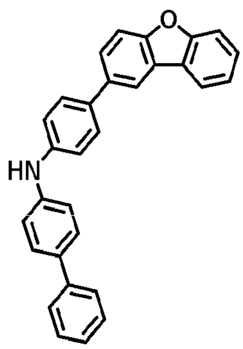

Sub 2-23

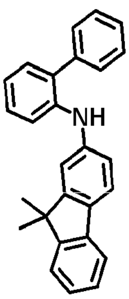

Sub 2-24

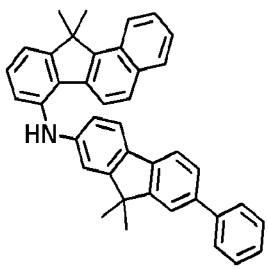

Sub 2-25

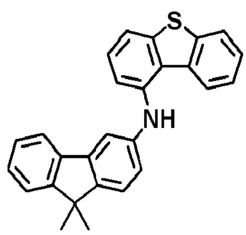

Sub 2-26

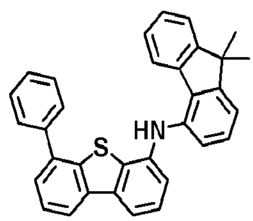

Sub 2-27

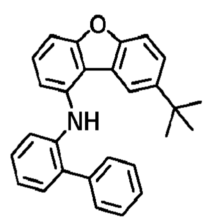

Sub 2-28

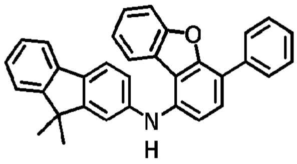

Sub 2-29

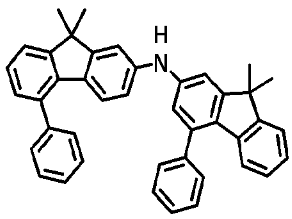

Sub 2-30

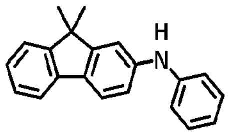

Sub 2-31

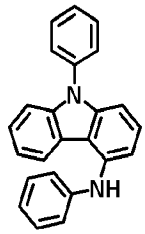

Sub 2-32

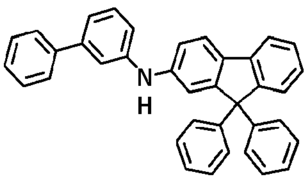

Sub 2-33

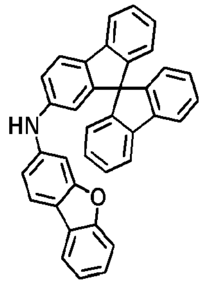

Sub 2-34

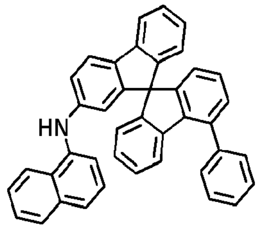

Sub 2-35

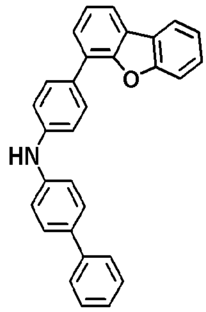

Sub 2-36

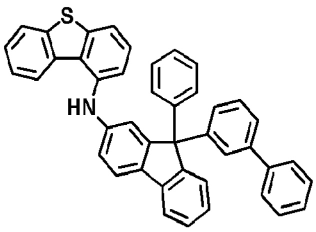

Sub 2-37

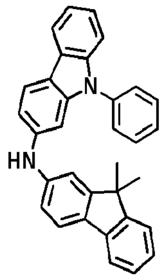

Sub 2-38

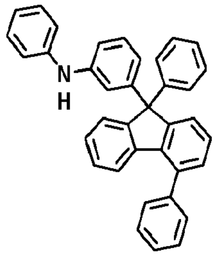

Sub 2-39

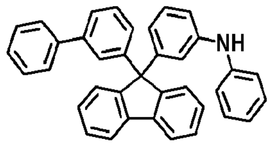

Sub 2-40

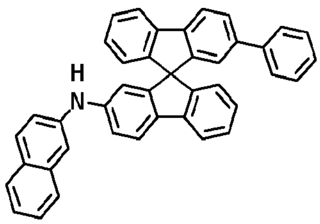

Sub 2-41

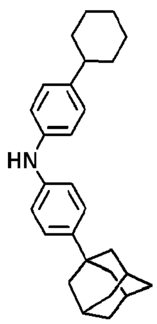

Sub 2-42

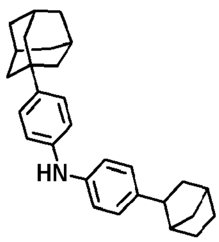

Sub 2-43

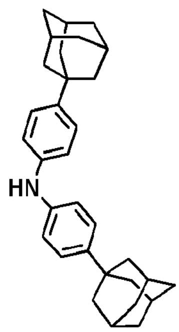

Sub 2-44

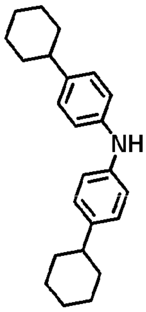
Sub 2-45

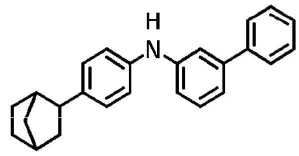
Sub 2-46

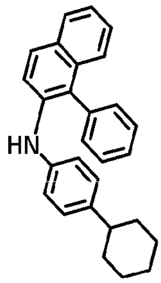
Sub 2-47

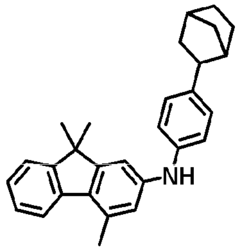
Sub 2-48

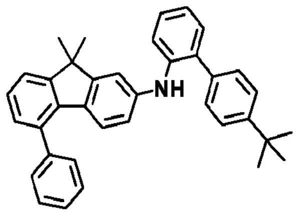
Sub 2-49

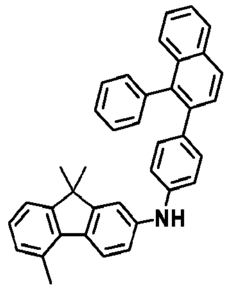
Sub 2-50

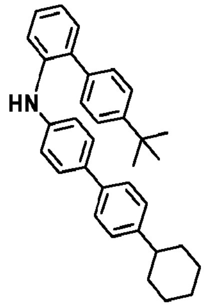
Sub 2-51

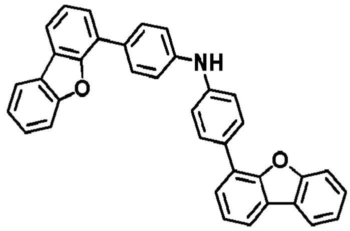
Sub 2-52

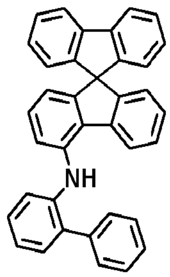
Sub 2-53

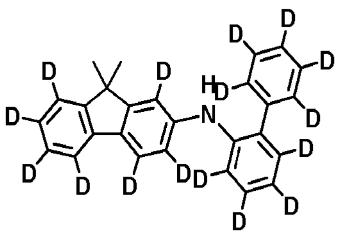
Sub 2-54

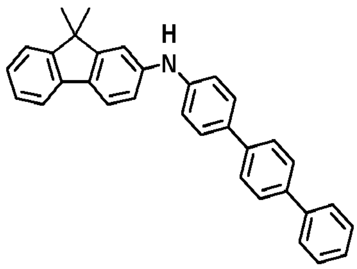
Sub 2-55

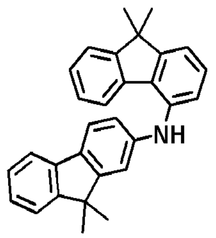
Sub 2-56

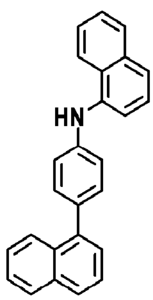
Sub 2-57

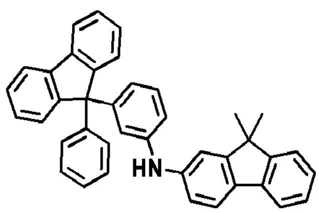
Sub 2-58

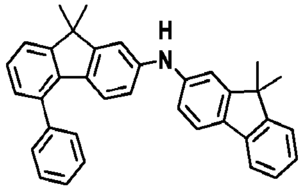
Sub 2-59

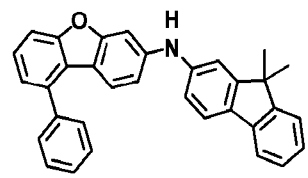
Sub 2-60

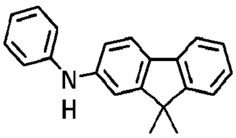
Sub 2-61

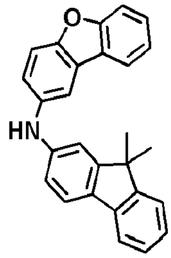
Sub 2-62

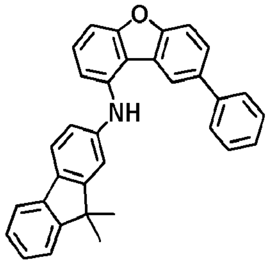
Sub 2-63

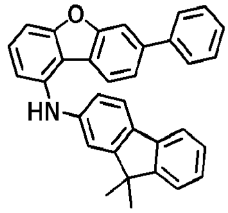
Sub 2-64

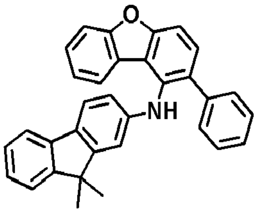
Sub 2-65

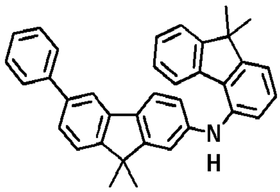
Sub 2-66

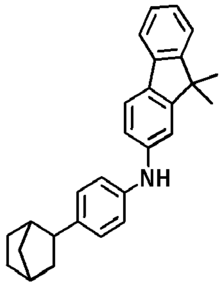
Sub 2-67

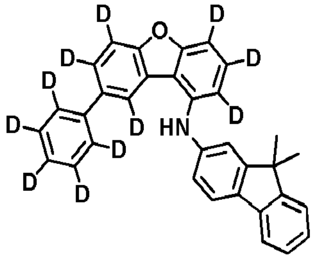
Sub 2-68

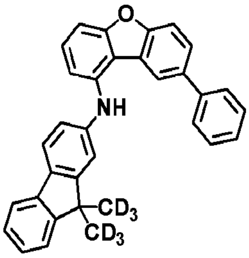
Sub 2-69

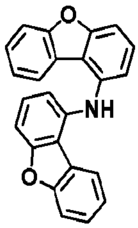
Sub 2-70

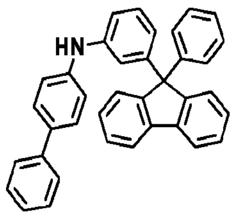
Sub 2-71

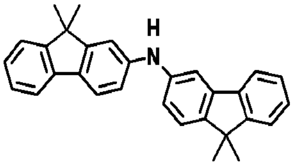
Sub 2-72

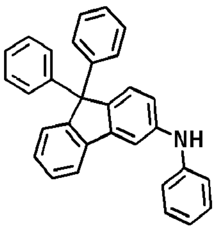
Sub 2-73

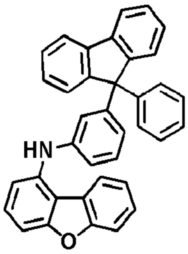
Sub 2-74

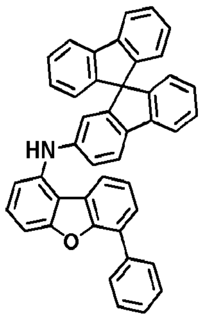
Sub 2-75

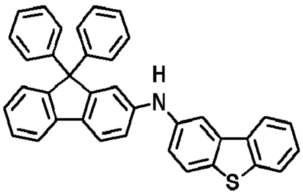
Sub 2-76

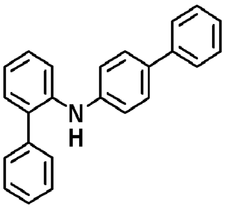
Sub 2-77

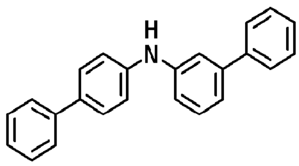
Sub 2-78

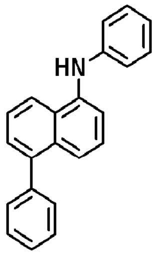
Sub 2-79

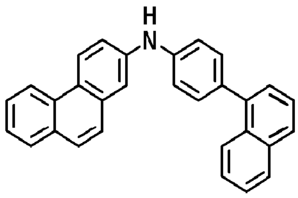
Sub 2-80

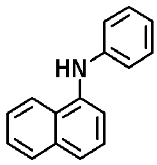

Sub 2-81

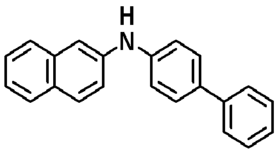

Sub 2-82

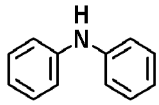

Sub 2-83

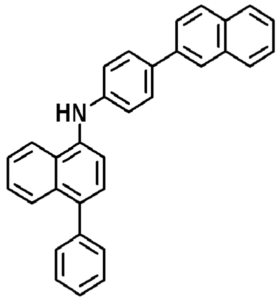

Sub 2-84

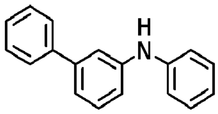

Sub 2-85

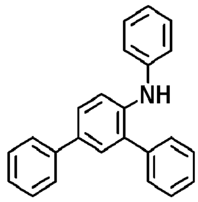

Sub 2-86

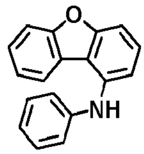

Sub 2-87

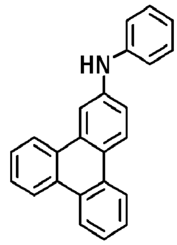

Sub 2-88

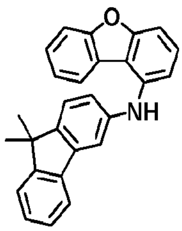

Sub 2-89

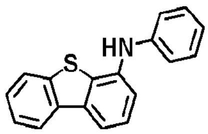

Sub 2-90

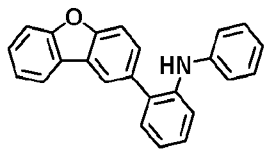

Sub 2-91

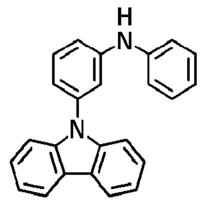

Sub 2-92

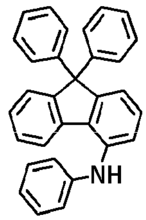

Sub 2-93

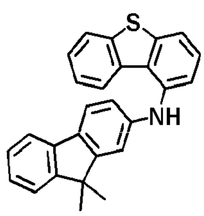

Sub 2-94

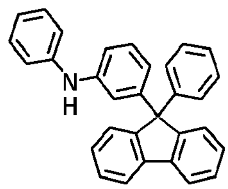

Sub 2-95

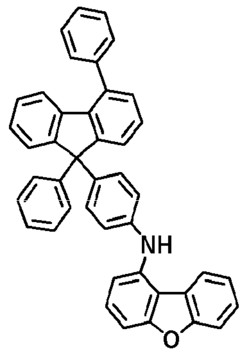

Sub 2-96

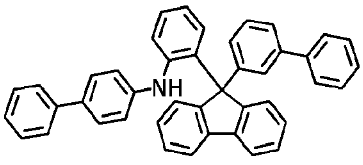

Sub 2-97

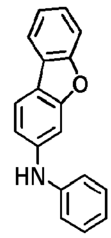

Sub 2-98

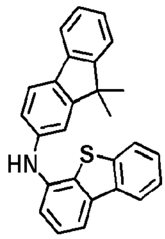

Sub 2-99

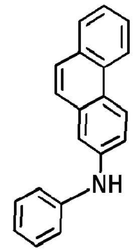

Sub 2-100

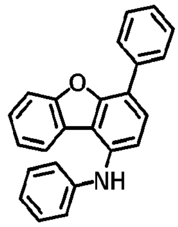

Sub 2-101

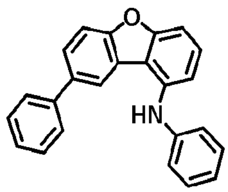

Sub 2-102

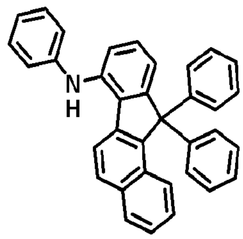

Sub 2-103

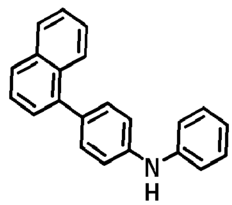

Sub 2-104

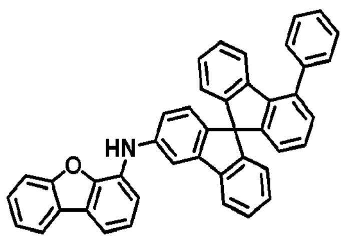

Sub 2-105

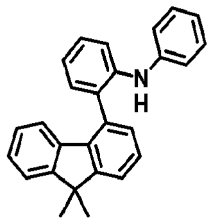

Sub 2-106

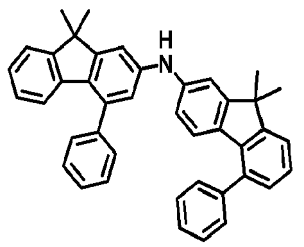

Sub 2-107

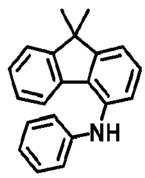

Sub 2-108

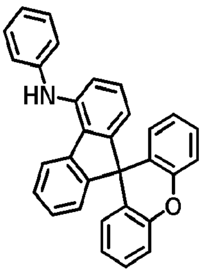

Sub 2-109

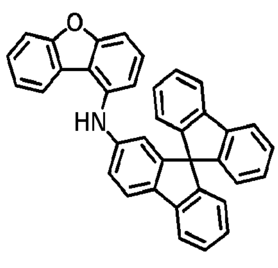

Sub 2-110

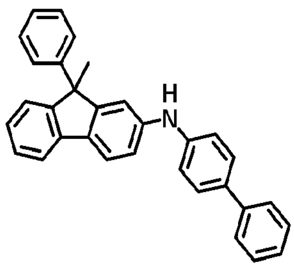

Sub 2-111

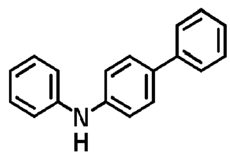

Sub 2-112

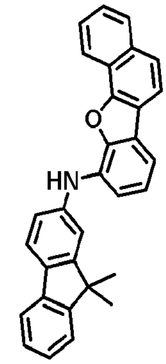

Sub 2-113

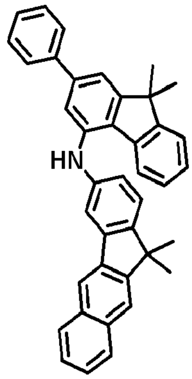

Sub 2-114

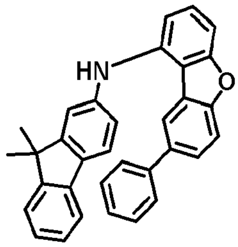

Sub 2-115

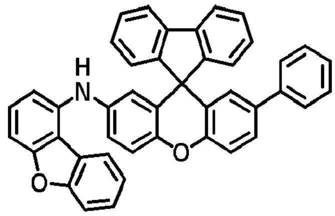

Sub 2-116

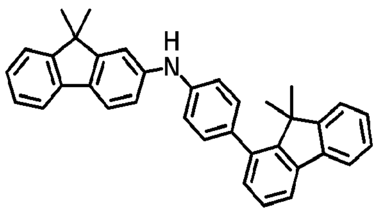

Sub 2-117

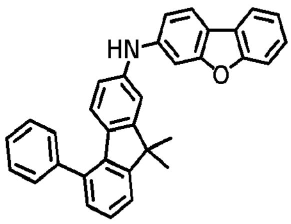

Sub 2-118

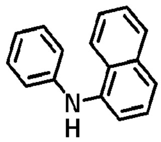

Sub 2-119

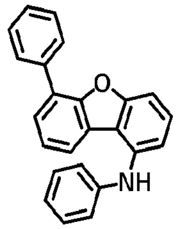

Sub 2-120

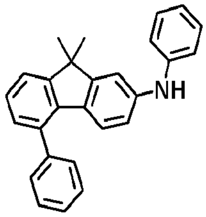

Sub 2-121

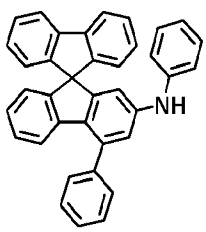

Sub 2-122

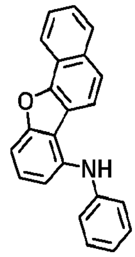

Sub 2-123

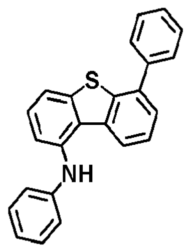

Sub 2-124

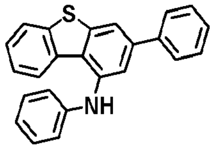

Sub 2-125

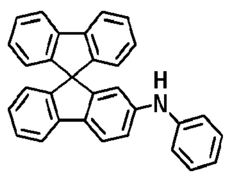

Sub 2-126

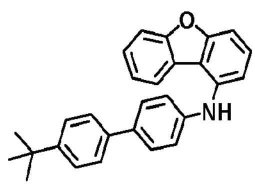

Sub 2-127

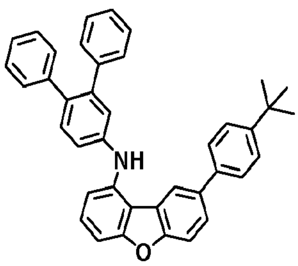

Sub 2-128

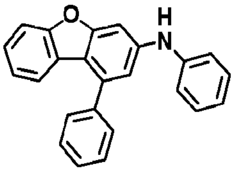

Sub 2-129

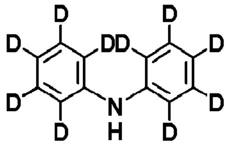

Sub 2-130

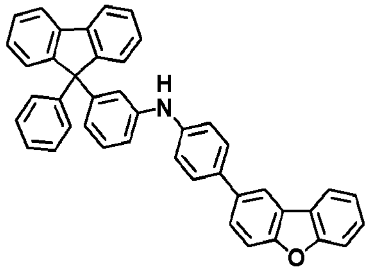

Sub 2-131

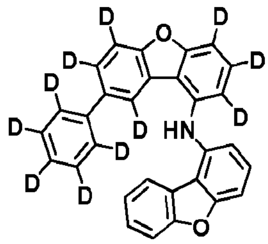

Sub 2-132

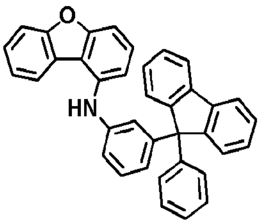

Sub 2-133

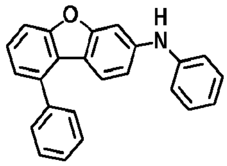

Sub 2-134

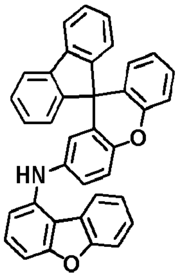

Sub 2-135

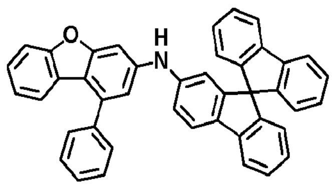

Sub 2-136

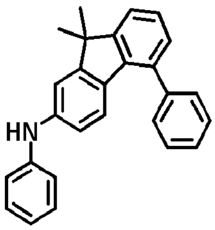

Sub 2-137

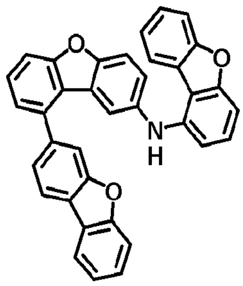

Sub 2-138

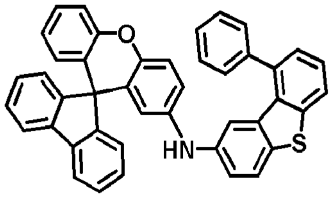

Sub 2-139

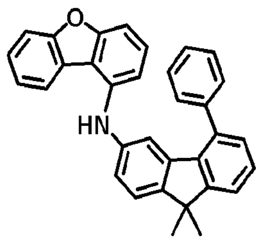

Sub 2-140

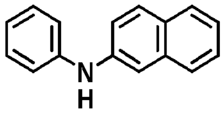

Sub 2-141

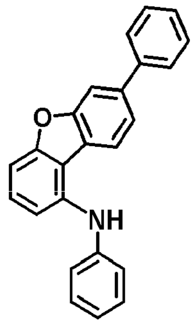

Sub 2-142

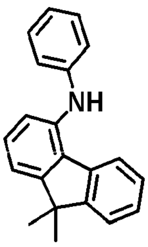

Sub 2-143

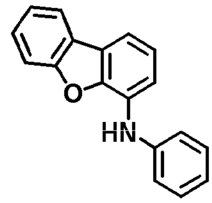

Sub 2-144

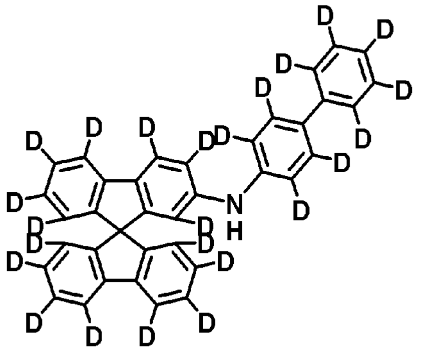

Sub 2-145

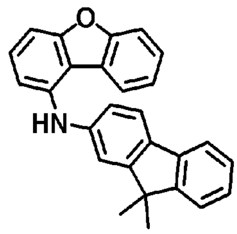

Sub 2-146

[Table 2]

| compound | FD-MS | compound | FD-MS |
|---|---|---|---|
| Sub 2-1 | m/z=321.15($C_{24}H_{19}N$=321.42) | Sub 2-2 | m/z=345.15($C_{26}H_{19}N$=345.44) |
| Sub 2-3 | m/z=497.21($C_{38}H_{27}N$=497.64) | Sub 2-4 | m/z=495.2($C_{38}H_{25}N$=495.62) |
| Sub 2-5 | m/z=471.2($C_{36}H_{25}N$=471.6) | Sub 2-6 | m/z=339.26($C_{24}HD_{18}N$=339.53) |
| Sub 2-7 | m/z=419.32($C_{30}HD_{22}N$=419.66) | Sub 2-8 | m/z=321.15($C_{24}H_{19}N$=321.42) |
| Sub 2-9 | m/z=371.17($C_{28}H_{21}N$=371.48) | Sub 2-10 | m/z=385.15($C_{28}H_{19}NO$=385.47) |
| Sub 2-11 | m/z=349.11($C_{24}H_{15}NO_2$=349.39) | Sub 2-12 | m/z=335.13($C_{24}H_{17}NO$=335.41) |
| Sub 2-13 | m/z=507.11($C_{34}H_{21}NS_2$=507.67) | Sub 2-14 | m/z=391.14($C_{27}H_{21}NS$=391.53) |
| Sub 2-15 | m/z=361.18($C_{27}H_{23}N$=361.49) | Sub 2-16 | m/z=401.21($C_{30}H_{27}N$=401.55) |
| Sub 2-17 | m/z=525.25($C_{40}H_{31}N$=525.69) | Sub 2-18 | m/z=485.21($C_{37}H_{27}N$=485.63) |
| Sub 2-19 | m/z=599.26($C_{46}H_{33}N$=599.78) | Sub 2-20 | m/z=401.21($C_{30}H_{27}N$=401.55) |
| Sub 2-21 | m/z=415.23($C_{31}H_{29}N$=415.58) | Sub 2-22 | m/z=451.19($C_{33}H_{25}NO$=451.57) |
| Sub 2-23 | m/z=411.16($C_{30}H_{21}NO$=411.5) | Sub 2-24 | m/z=361.18($C_{27}H_{23}N$=361.49) |
| Sub 2-25 | m/z=527.26($C_{40}H_{33}N$=527.71) | Sub 2-26 | m/z=391.14($C_{27}H_{21}NS$=391.53) |
| Sub 2-27 | m/z=467.17($C_{33}H_{25}NS$=467.63) | Sub 2-28 | m/z=391.19($C_{28}H_{25}NO$=391.51) |
| Sub 2-29 | m/z=451.19($C_{33}H_{25}NO$=451.57) | Sub 2-30 | m/z=553.28($C_{42}H_{35}N$=553.75) |
| Sub 2-31 | m/z=285.15($C_{21}H_{19}N$=285.39) | Sub 2-32 | m/z=334.15($C_{24}H_{18}N_2$=334.42) |
| Sub 2-33 | m/z=485.21($C_{37}H_{27}N$=485.63) | Sub 2-34 | m/z=497.18($C_{37}H_{23}NO$=497.6) |
| Sub 2-35 | m/z=533.21($C_{41}H_{27}N$=533.67) | Sub 2-36 | m/z=411.16($C_{30}H_{21}NO$=411.5) |
| Sub 2-37 | m/z=591.2($C_{43}H_{29}NS$=591.77) | Sub 2-38 | m/z=450.21($C_{33}H_{26}N_2$=450.59) |
| Sub 2-39 | m/z=485.21($C_{37}H_{27}N$=485.63) | Sub 2-40 | m/z=485.21($C_{37}H_{27}N$=485.63) |
| Sub 2-41 | m/z=533.21($C_{41}H_{27}N$=533.67) | Sub 2-42 | m/z=385.28($C_{28}H_{35}N$=385.59) |
| Sub 2-43 | m/z=397.28($C_{29}H_{35}N$=397.61) | Sub 2-44 | m/z=437.31($C_{32}H_{39}N$=437.67) |
| Sub 2-45 | m/z=333.25($C_{24}H_{31}N$=333.52) | Sub 2-46 | m/z=339.2($C_{25}H_{25}N$=339.48) |
| Sub 2-47 | m/z=377.21($C_{28}H_{27}N$=377.53) | Sub 2-48 | m/z=393.25($C_{29}H_{31}N$ =393.57) |
| Sub 2-49 | m/z=493.28($C_{37}H_{35}N$=493.69) | Sub 2-50 | m/z=501.25($C_{38}H_{31}N$=501.67) |
| Sub 2-51 | m/z=459.29($C_{34}H_{37}N$=459.68) | Sub 2-52 | m/z=501.17($C_{36}H_{23}NO_2$=501.58) |
| Sub 2-53 | m/z=483.2($C_{37}H_{25}N$=483.61) | Sub 2-54 | m/z=377.28($C_{27}H_7D_{16}N$=377.59) |
| Sub 2-55 | m/z=437.21($C_{33}H_{27}N$=437.59) | Sub 2-56 | m/z=401.21($C_{30}H_{27}N$=401.55) |
| Sub 2-57 | m/z=345.15($C_{26}H_{19}N$=345.44) | Sub 2-58 | m/z=525.25($C_{40}H_{31}N$=525.69) |

(continued)

| compound | FD-MS | compound | FD-MS |
|---|---|---|---|
| Sub 2-59 | m/z=477.25($C_{36}H_{31}N$=477.65) | Sub 2-60 | m/z=451.19($C_{33}H_{25}NO$=451.57) |
| Sub 2-61 | m/z=285.15($C_{21}H_{19}N$=285.39) | Sub 2-62 | m/z=375.16($C_{27}$ $H_{21}NO$=375.47) |
| Sub 2-63 | m/z=451.19($C_{33}H_{25}NO$=451.57) | Sub 2-64 | m/z=451.19($C_{33}H_{25}NO$=451.57) |
| Sub 2-65 | m/z=451.19($C_{33}H_{25}NO$=451.57) | Sub 2-66 | m/z=477.25($C_{36}H_{31}N$=477.65) |
| Sub 2-67 | m/z=379.23($C_{28}H_{29}N$=379.55) | Sub 2-68 | m/z=462.26($C_{33}H_{14}D_{11}NO$=462.64) |
| Sub 2-69 | m/z=457.23($C_{33}H_{19}D_{6}NO$=457.61) | Sub 2-70 | m/z=349.11($C_{24}H_{15}NO_{2}$=349.39) |
| Sub 2-71 | m/z=485.21($C_{37}H_{27}N$=485.63) | Sub 2-72 | m/z=401.21($C_{30}H_{27}N$=401.55) |
| Sub 2-73 | m/z=409.18($C_{31}H_{23}N$=409.53) | Sub 2-74 | m/z=499.19($C_{37}H_{25}NO$=499.61) |
| Sub 2-75 | m/z=573.21($C_{43}H_{27}NO$=573.69) | Sub 2-76 | m/z=515.17($C_{37}H_{25}NS$=515.67) |
| Sub 2-77 | m/z=321.15($C_{24}H_{19}N$=321.42) | Sub 2-78 | m/z=321.15($C_{24}H_{19}N$=321.42) |
| Sub 2-79 | m/z=295.14($C_{22}H_{17}N$=295.38) | Sub 2-80 | m/z=395.17($C_{30}H_{21}N$=395.5) |
| Sub 2-81 | m/z=219.1($C_{16}H_{13}N$=219.29) | Sub 2-82 | m/z=295.14($C_{22}H_{17}N$=295.38) |
| Sub 2-83 | m/z=169.09($C_{12}H_{11}N$=169.23) | Sub 2-84 | m/z=421.18($C_{32}H_{23}N$=421.54) |
| Sub 2-85 | m/z=245.12($C_{18}H_{15}N$=245.32) | Sub 2-86 | m/z=321.15($C_{24}H_{19}N$=321.42) |
| Sub 2-87 | m/z=259.1($C_{18}H_{13}NO$=259.31) | Sub 2-88 | m/z=319.14($C_{24}H_{17}N$=319.41) |
| Sub 2-89 | m/z=375.16($C_{27}H_{21}NO$=375.47) | Sub 2-90 | m/z=275.08($C_{18}H_{13}NS$=275.37) |
| Sub 2-91 | m/z=335.13($C_{24}H_{17}NO$=335.41) | Sub 2-92 | m/z=334.15($C_{24}H_{18}N_{2}$=334.42) |
| Sub 2-93 | m/z=409.18($C_{31}H_{23}N$=409.53) | Sub 2-94 | m/z=391.14($C_{27}H_{21}NS$=391.53) |
| Sub 2-95 | m/z=409.18($C_{31}H_{23}N$=409.53) | Sub 2-96 | m/z=575.22($C_{43}H_{29}NO$=575.71) |
| Sub 2-97 | m/z=561.25($C_{43}H_{31}N$=561.73) | Sub 2-98 | m/z=259.1($C_{18}H_{13}NO$=259.31) |
| Sub 2-99 | m/z=391.14($C_{27}H_{21}NS$=391.53) | Sub 2-100 | m/z=269.12($C_{20}H_{15}N$=269.35) |
| Sub 2-101 | m/z=335.13($C_{24}H_{17}NO$=335.41) | Sub 2-102 | m/z=335.13($C_{24}H_{17}NO$=335.41) |
| Sub 2-103 | m/z=459.2($C_{35}H_{25}N$=459.59) | Sub 2-104 | m/z=295.14($C_{22}H_{17}N$=295.38) |
| Sub 2-105 | m/z=573.21($C_{43}H_{27}NO$=573.69) | Sub 2-106 | m/z=361.18($C_{27}H_{23}N$=361.49) |
| Sub 2-107 | m/z=553.28($C_{42}H_{35}N$=553.75) | Sub 2-108 | m/z=285.15($C_{21}H_{19}N$=285.39) |
| Sub 2-109 | m/z=423.16($C_{31}H_{21}NO$=423.51) | Sub 2-110 | m/z=497.18($C_{37}H_{23}NO$=497.6) |
| Sub 2-111 | m/z=423.2($C_{32}H_{25}N$=423.56) | Sub 2-112 | m/z=245.12($C_{18}H_{15}N$=245.32) |
| Sub 2-113 | m/z=425.18($C_{31}H_{23}NO$=425.53) | Sub 2-114 | m/z=527.26($C_{40}H_{33}N$=527.71) |
| Sub 2-115 | m/z=451.19($C_{33}H_{25}NO$=451.57) | Sub 2-116 | m/z=589.2($C_{43}H_{27}NO_{2}$=589.69) |
| Sub 2-117 | m/z=477.25($C_{36}H_{31}N$=477.65) | Sub 2-118 | m/z=451.19($C_{33}H_{25}NO$=451.57) |
| Sub 2-119 | m/z=219.1($C_{16}H_{13}N$=219.29) | Sub 2-120 | m/z=335.13($C_{24}H_{17}NO$=335.41) |
| Sub 2-121 | m/z=361.18($C_{27}H_{23}N$=361.49) | Sub 2-122 | m/z=483.2($C_{37}H_{25}N$=483.61) |
| Sub 2-123 | m/z=309.12($C_{22}H_{15}NO$=309.37) | Sub 2-124 | m/z=351.11($C_{24}H_{17}NS$=351.47) |
| Sub 2-125 | m/z=351.11($C_{24}H_{17}NS$=351.47) | Sub 2-126 | m/z=407.17($C_{31}H_{21}N$=407.52) |
| Sub 2-127 | m/z=391.19($C_{28}H_{25}NO$=391.51) | Sub 2-128 | m/z=543.26($C_{40}H_{33}NO$=543.71) |
| Sub 2-129 | m/z=335.13($C_{24}H_{17}NO$=335.41) | Sub 2-130 | m/z=179.15($C_{12}HD_{10}N$=179.29) |
| Sub 2-131 | m/z=575.22($C_{43}H_{29}NO$=575.71) | Sub 2-132 | m/z=436.21($C_{30}H_{8}D_{11}NO_{2}$=436.55) |
| Sub 2-133 | m/z=499.19($C_{37}H_{25}NO$=499.61) | Sub 2-134 | m/z=335.13($C_{24}H_{17}NO$=335.41) |
| Sub 2-135 | m/z=513.17($C_{37}H_{23}NO_{2}$=513.6) | Sub 2-136 | m/z=573.21($C_{43}H_{27}NO$=573.69) |

(continued)

| compound | FD-MS | compound | FD-MS |
|---|---|---|---|
| Sub 2-137 | m/z=361.18($C_{27}H_{23}N$=361.49) | Sub 2-138 | m/z=515.15($C_{36}H_{21}NO_3$=515.57) |
| Sub 2-139 | m/z=605.18($C_{43}H_{27}NOS$=605.75) | Sub 2-140 | m/z=451.19($C_{33}H_{25}NO$=451.57) |
| Sub 2-141 | m/z=219.1($C_{16}H_{13}N$=219.29) | Sub 2-142 | m/z=335.13($C_{24}H_{17}NO$=335.41) |
| Sub 2-143 | m/z=285.15($C_{21}H_{19}N$=285.39) | Sub 2-144 | m/z=259.1($C_{18}H_{13}NO$=259.31) |
| Sub 2-145 | m/z=507.35($C_{37}HD_{24}N$=507.76) | Sub 2-146 | m/z=375.16($C_{27}H_{21}NO$=375.47) |

III. Synthesis of Final Product 1

1. Synthesis example of P1-6

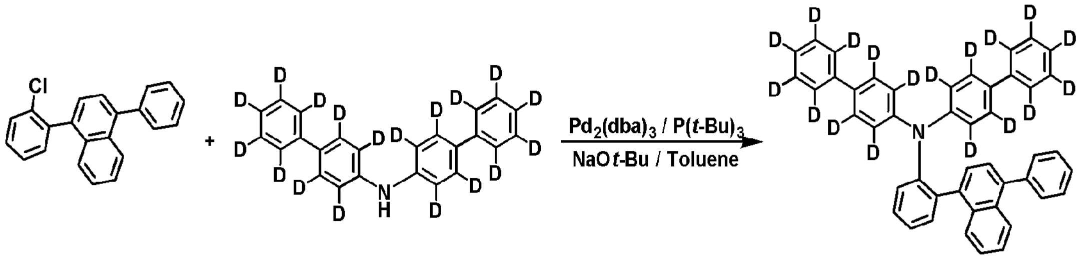


Sub 1-6 Sub 2-6 P1-6

Sub 1-6 (20 g, 63.5 mmol), Toluene (150 mL), Sub 2-6 (21.6 g, 63.5 mmol), $Pd_2(dba)_3$ (1.7 g, 1.9 mmol), $P(t\text{-}Bu)_3$ (12.2g, 3.8 mmol), NaOt-Bu (12.2 g, 127.1 mmol) were added and stirred at 100°C. When the reaction was completed, the organic layer was extracted with Toluene and water, dried over $MgSO_4$, concentrated, and the resulting compound was recrystallized using a silica gel column to obtain the product (30.2 g, 77%).

2. Synthesis example of P1-11

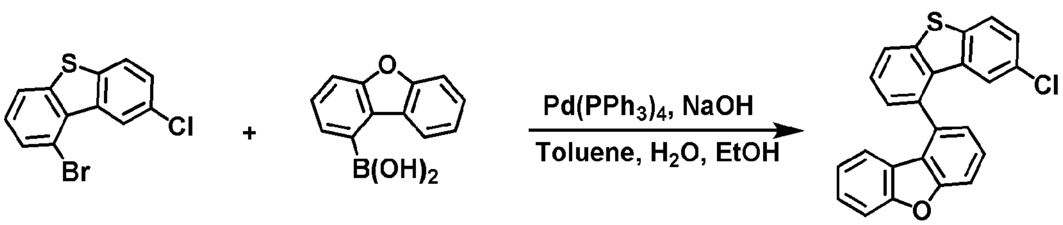


Sub 3-14 Sub 1-11

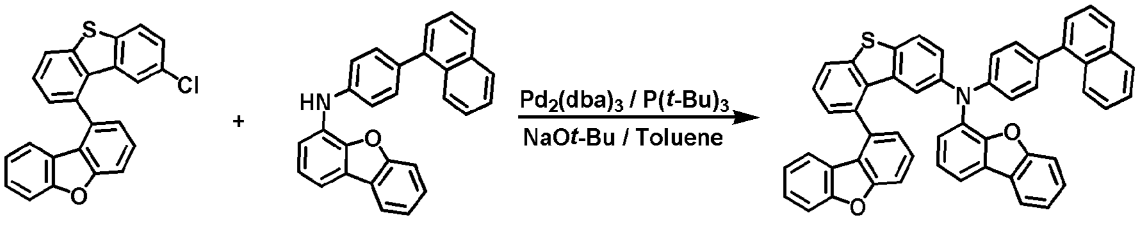


Sub 1-11 Sub 2-10 P1-11

(1) Synthesis of Sub 1-11

Sub 3-14 (30 g, 100.8 mmol), Toluene (270 mL), $H_2O$ (30 mL), Ethanol (30 mL), 1-Dibenzofuranylboronic acid (22.4 g, 105.9 mmol), $Pd(PPh_3)_4$ (3.5 g, 3.0 mmol), NaOH (8.1 g, 201.6 mmol) were added and stirred at 80°C. When the reaction is complete, the solution is extracted with Toluene and water, the organic layer is dried with $MgSO_4$, and the solvent is completely removed. The concentrate is dissolved in Toluene, concentrated, and the compound is subjected to silica gel column and recrystallization to obtain the product (27.5 g, 71%).

(2) Synthesis of P1-11

Sub 1-11 (25 g, 87.8 mmol), Toluene (220 mL), Sub 2-10 (33.8 g, 87.8 mmol), $Pd_2(dba)_3$ (2.4 g, 2.6 mmol), $P(t\text{-}Bu)_3$ (1.1g, 5.3 mmol), NaOt-Bu (16.9 g, 175.5 mmol) were added and stirred at 100°C. When the reaction was completed, the organic layer was extracted with Toluene and water, dried over $MgSO_4$, concentrated, and the resulting compound was recrystallized using a silica gel column to obtain the product (46.4 g, 72%).

3. Synthesis example of P1-15

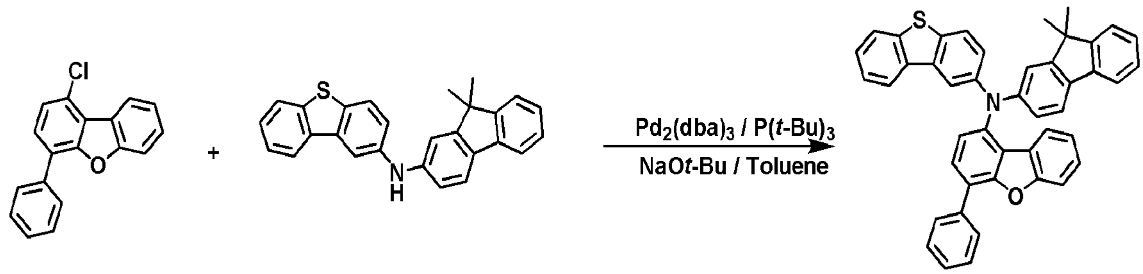


Sub1-14 Sub2-14 P1-15

Sub 1-14 (20 g, 71.8 mmol), Toluene (180 mL), Sub 2-14 (28.1 g, 71.8 mmol), $Pd_2(dba)_3$ (2.0 g, 2.2 mmol), $P(t\text{-}Bu)_3$ (13.8g, 4.3 mmol), NaOt-Bu (13.8 g, 143.5 mmol) were added and stirred at 100°C. When the reaction was completed, the organic layer was extracted with Toluene and water, dried over $MgSO_4$, concentrated, and the resulting compound was recrystallized using a silica gel column to obtain the product (36.8 g, 81%).

4. Synthesis example of P1-22

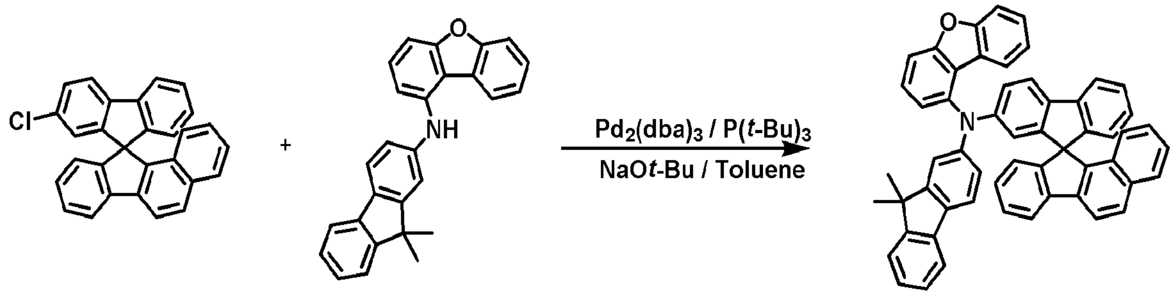


Sub 1-21 Sub 2-146 P1-22

Sub 1-14 (20 g, 71.8 mmol), Toluene (180 mL), Sub 2-14 (28.1 g, 71.8 mmol), $Pd_2(dba)_3$ (2.0 g, 2.2 mmol), $P(t\text{-}Bu)_3$ (13.8g, 4.3 mmol), NaOt-Bu (13.8 g, 143.5 mmol) were added and stirred at 100°C. When the reaction was completed, the organic layer was extracted with Toluene and water, dried over $MgSO_4$, concentrated, and the resulting compound was recrystallized using a silica gel column to obtain the product (27.3 g, 74%).

5. Synthesis example of P1-46

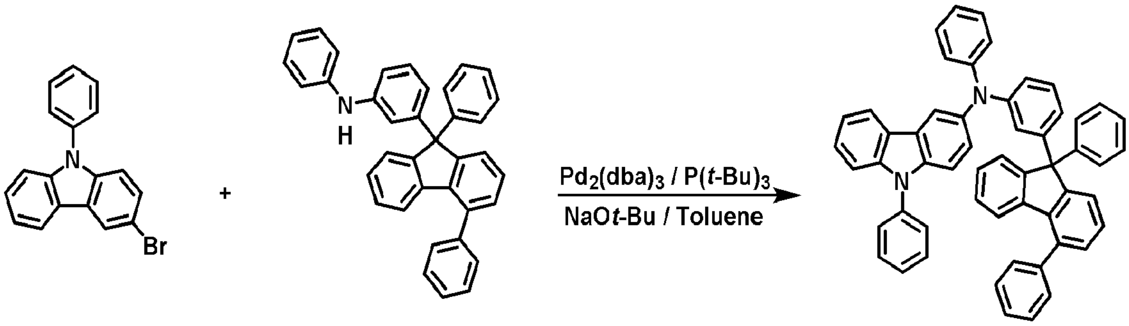


Sub 1-42 Sub 2-39 P1-46

Sub 1-42 (20 g, 62.1 mmol), Toluene (155 mL), Sub 2-39 (30.1 g, 62.1 mmol), $Pd_2(dba)_3$ (1.7 g, 1.9 mmol), $P(t\text{-}Bu)_3$ (0.8g, 3.7 mmol), NaOt-Bu (11.9 g, 124.1 mmol) were added and stirred at 100°C. When the reaction was completed, the organic layer was extracted with Toluene and water, dried over $MgSO_4$, concentrated, and the resulting compound was recrystallized using a silica gel column to obtain the product (30.7 g, 68%).

6. Synthesis example of P1-63

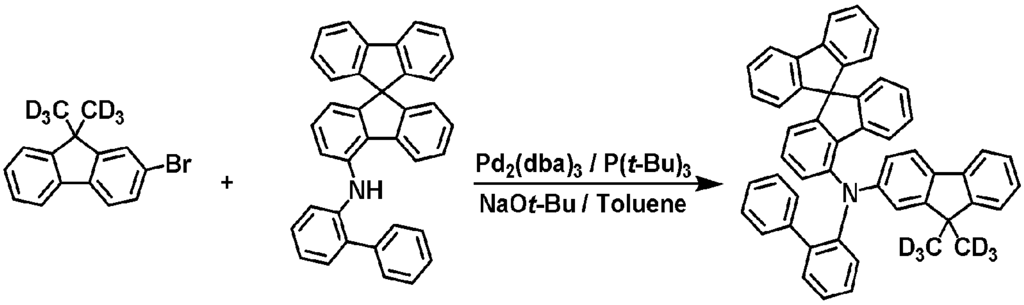


Sub 1-56 Sub 2-53 P1-63

Sub 1-56 (20 g, 71.6 mmol), Toluene (180 mL), Sub 2-53 (34.6 g, 71.6 mmol), $Pd_2(dba)_3$ (2.0 g, 2.1 mmol), P(t-Bu)$_3$ (0.9g, 4.3 mmol), NaOt-Bu (13.8 g, 143.3 mmol) were added and stirred at 100°C. When the reaction was completed, the organic layer was extracted with Toluene and water, dried over $MgSO_4$, concentrated, and the resulting compound was recrystallized using a silica gel column to obtain the product (39.1 g, 80%).

7. Synthesis example of P1-64

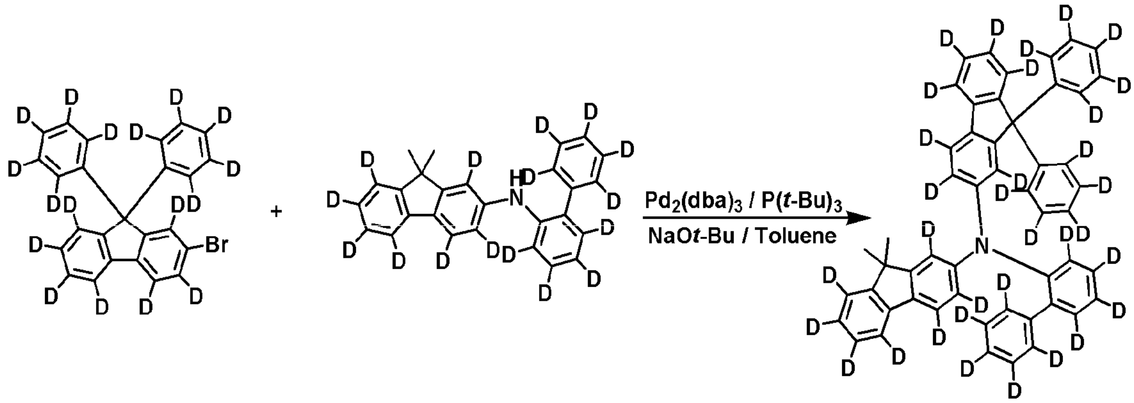


**Sub 1-57** **Sub 2-54** **P1-64**

Sub 1-57 (20 g, 48.3 mmol), Toluene (120 mL), Sub 2-54 (18.2 g, 48.3 mmol), $Pd_2(dba)_3$ (1.3 g, 1.4 mmol), $P(t\text{-}Bu)_3$ (0.6g, 2.9 mmol), NaOt-Bu (9.3 g, 96.5 mmol) were added and stirred at 100°C. When the reaction was completed, the organic layer was extracted with Toluene and water, dried over $MgSO_4$, concentrated, and the resulting compound was recrystallized using a silica gel column to obtain the product (27.8 g, 81%).

The FD-MS values of compounds P1-1 to P1-96 of the present invention manufactured according to the above synthetic examples are as shown in Table 3.

[Table 3]

| compound | FD-MS | compound | FD-MS |
|---|---|---|---|
| P1-1 | m/z=473.21($C_{36}H_{27}N$=473.62) | P1-2 | m/z=547.23($C_{42}H_{29}N$=547.7) |
| P1-3 | m/z=775.32($C_{60}H_{41}N$=775.99) | P1-4 | m/z=849.34($C_{66}H_{43}N$=850.08) |
| P1-5 | m/z=684.35($C_{52}H_{24}D_{11}N$=684.93) | P1-6 | m/z=617.37($C_{46}H_{15}D_{18}N$ =617.89) |
| P1-7 | m/z=740.55($C_{54}D_{39}N$=741.15) | P1-8 | m/z=503.17($C_{36}H_{25}NS$=503.66) |
| P1-9 | m/z=563.22($C_{42}H_{29}NO$=563.7) | P1-10 | m/z=705.25($C_{52}H_{35}NS$=705.92) |
| P1-11 | m/z=733.21($C_{52}H_{31}NO_2S$=733.88) | P1-12 | m/z=531.13($C_{36}H_{21}NO_2S$=531.63) |
| P1-13 | m/z=703.25($C_{52}H_{33}NO_2$=703.84) | P1-14 | m/z=815.18($C_{56}H_{33}NS_3$=816.07) |
| P1-15 | m/z=633.21($C_{45}H_{31}NOS$=633.81) | P1-16 | m/z=603.26($C_{45}H_{33}NO$=603.76) |
| P1-17 | m/z=629.31($C_{48}H_{39}N$=629.85) | P1-18 | m/z=793.37($C_{61}H_{47}N$=794.05) |
| P1-19 | m/z=753.34($C_{58}H_{43}N$=753.99) | P1-20 | m/z=857.31($C_{64}H_{43}NS$=858.12) |
| P1-21 | m/z=715.32($C_{55}H_{41}N$=715.94) | P1-22 | m/z=739.29($C_{56}H_{37}NO$=739.92) |
| P1-23 | m/z=791.36($C_{61}H_{45}N$=792.04) | P1-24 | m/z=807.39($C_{62}H_{49}N$=808.08) |
| P1-25 | m/z=815.32($C_{62}H_{41}NO$=816.02) | P1-26 | m/z=853.33($C_{65}H_{43}NO$=854.06) |
| P1-27 | m/z=705.34($C_{54}H_{43}N$ =705.94) | P1-28 | m/z=953.5($C_{73}H_{63}N$=954.31) |
| P1-29 | m/z=695.36($C_{50}H_{49}NS$=696.01) | P1-30 | m/z=721.28($C_{53}H_{39}NS$=721.96) |
| P1-31 | m/z=721.33($C_{54}H_{43}NO$=721.94) | P1-32 | m/z=781.3($C_{58}H_{39}NO_2$=781.95) |
| P1-33 | m/z=562.24($C_{42}H_{30}N_2$=562.72) | P1-34 | m/z=602.27($C_{45}H_{34}N_2$=602.78) |
| P1-35 | m/z=768.31($C_{57}H_{40}N_2O$=768.96) | P1-36 | m/z=870.4($C_{66}H_{50}N_2$=871.14) |
| P1-37 | m/z=678.3($C_{51}H_{38}N_2$=678.88) | P1-38 | m/z=602.27($C_{45}H_{34}N_2$=602.78) |
| P1-39 | m/z=726.3($C_{55}H_{38}N_2$=726.92) | P1-40 | m/z=814.3($C_{61}H_{38}N_2O$=814.99) |
| P1-41 | m/z=900.35($C_{69}H_{44}N_2$=901.12) | P1-42 | m/z=638.27($C_{48}H_{34}N_2$=638.81) |
| P1-43 | m/z=728.28($C_{54}H_{36}N_2O$=728.89) | P1-44 | m/z=832.29($C_{61}H_{40}N_2S$=833.07) |
| P1-45 | m/z=691.3($C_{51}H_{37}N_3$=691.88) | P1-46 | m/z=726.3($C_{55}H_{38}N_2$=726.92) |

(continued)

| compound | FD-MS | compound | FD-MS |
|---|---|---|---|
| P1-47 | m/z=802.33($C_{61}H_{42}N_2$=803.02) | P1-48 | m/z=850.33($C_{65}H_{42}N_2$=851.06) |
| P1-49 | m/z=571.32($C_{43}H_{41}N$=571.81) | P1-50 | m/z=653.4($C_{49}H_{51}N$=653.95) |
| P1-51 | m/z=713.4($C_{54}H_{51}N$=714.01) | P1-52 | m/z=751.42($C_{57}H_{53}N$=752.06) |
| P1-53 | m/z=725.4($C_{55}H_{51}N$=726.02) | P1-54 | m/z=765.43($C_{58}H_{55}N$=766.08) |
| P1-55 | m/z=701.4($C_{53}H_{51}N$=702) | P1-56 | m/z=697.37($C_{53}H_{47}N$=697.97) |
| P1-57 | m/z=651.39($C_{49}H_{49}N$=651.94) | P1-58 | m/z=693.34($C_{53}H_{43}N$=693.93) |
| P1-59 | m/z=787.42($C_{60}H_{53}N$=788.09) | P1-60 | m/z=745.46($C_{56}H_{59}N$ =746.09) |
| P1-61 | m/z=635.26($C_{49}H_{33}N$=635.81) | P1-62 | m/z=743.25($C_{54}H_{33}NO_3$=743.86) |
| P1-63 | m/z=681.33($C_{52}H_{31}D_6N$=681.91) | P1-64 | m/z=710.52($C_{52}H_6D_{33}N$=711.09) |
| P1-65 | m/z=753.34($C_{58}H_{43}N$=753.99) | P1-66 | m/z=715.32($C_{55}H_{41}N$=715.94) |
| P1-67 | m/z=629.27($C_{47}H_{35}NO$=629.8) | P1-68 | m/z=663.26($C_{50}H_{33}NO$=663.82) |
| P1-69 | m/z=707.26($C_{52}H_{37}NS$=707.93) | P1-70 | m/z=717.34($C_{55}H_{43}N$=717.96) |
| P1-71 | m/z=553.28($C_{42}H_{35}N$=553.75) | P1-72 | m/z=691.29($C_{52}H_{37}NO$=691.87) |
| P1-73 | m/z=643.29($C_{48}H_{37}NO$=643.83) | P1-74 | m/z=709.24($C_{51}H_{35}NOS$=709.91) |
| P1-75 | m/z=677.31($C_{52}H_{39}N$=677.89) | P1-76 | m/z=665.4($C_{50}H_{51}N$=665.96) |
| P1-77 | m/z=643.29($C_{48}H_{37}NO$=643.83) | P1-78 | m/z=633.21($C_{45}H_{31}NOS$=633.81) |
| P1-79 | m/z=693.27($C_{51}H_{35}NO_2$=693.85) | P1-80 | m/z=719.32($C_{54}H_{41}NO$=719.93) |
| P1-81 | m/z=699.35($C_{52}H_{45}NO$=699.94) | P1-82 | m/z=639.29($C_{49}H_{37}N$=639.84) |
| P1-83 | m/z=645.3($C_{48}H_{39}NO$=645.85) | P1-84 | m/z=663.39($C_{50}H_{49}N$=663.95) |
| P1-85 | m/z=617.24($C_{45}H_{31}NO_2$=617.75) | P1-86 | m/z=715.4($C_{51}H_{13}D_{22}NO_2$=715.98) |
| P1-87 | m/z=699.3($C_{51}H_{29}D_6NO_2$=699.88) | P1-88 | m/z=591.18($C_{42}H_{25}NO_3$=591.67) |
| P1-89 | m/z=801.34($C_{62}H_{43}N$=802.03) | P1-90 | m/z=617.27($C_{46}H_{35}NO$=617.79) |
| P1-91 | m/z=815.33($C_{61}H_{41}N_3$=816.02) | P1-92 | m/z=691.3($C_{51}H_{37}N_3$=691.88) |
| P1-93 | m/z=757.24($C_{55}H_{35}NOS$=757.95) | P1-94 | m/z=815.28($C_{61}H_{37}NO_2$=815.97) |
| P1-95 | m/z=697.19($C_{49}H_{31}NS_2$=697.91) | P1-96 | m/z=781.3($C_{58}H_{39}NO_2$=781.95) |

[Synthesis Example 2] Synthesis example of Formula 2

The compound (final product 2) represented by Formula 2 according to the present invention can be synthesized according to the reaction path of Reaction scheme 2, but is not limited thereto.

<Reaction Scheme 2> ((Hal$^2$ and Hal$^3$ are each independently I, Br or Cl.)

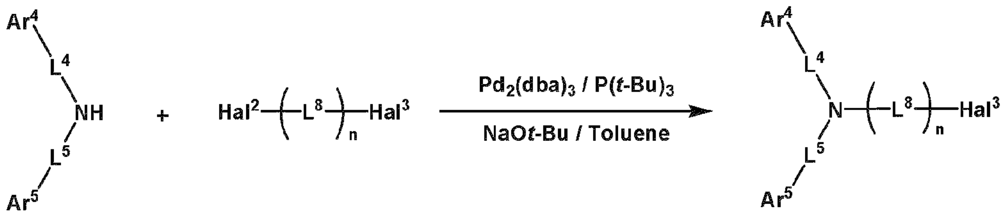


Sub 2 Sub 3 Inter 1

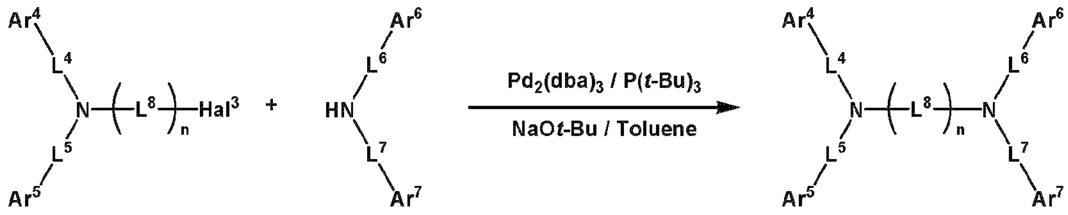


Inter 1 Sub 2 Final Product 2

I. Synthesis of Sub 3

Compounds belonging to Sub 3 of Reaction scheme 2 may be, but are not limited to, the compounds below, and Table 4 shows the FD-MS (Field Desorption-Mass Spectrometry) values of the compounds below.

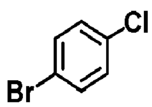

Sub 3-1

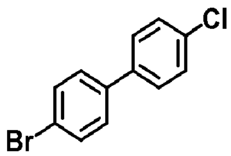

Sub 3-2

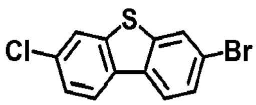

Sub 3-3

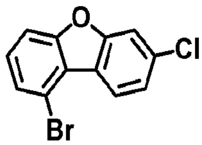

Sub 3-4

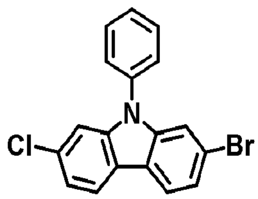

Sub 3-5

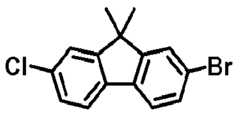

Sub 3-6

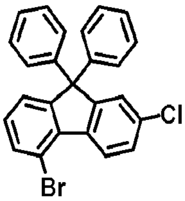

Sub 3-7

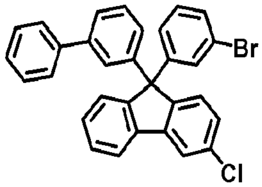

Sub 3-8

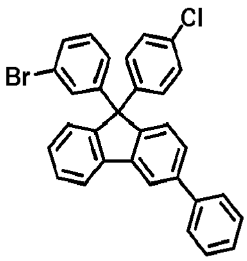

Sub 3-9

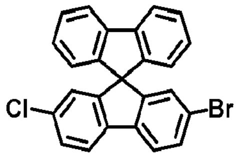

Sub 3-10

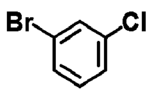

Sub 3-11

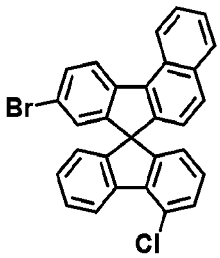

Sub 3-12

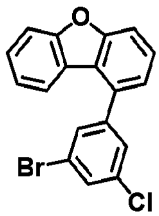

Sub 3-13

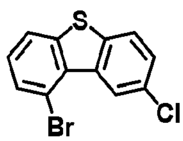

Sub 3-14

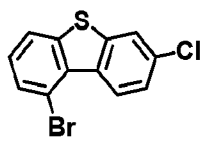

Sub 3-15

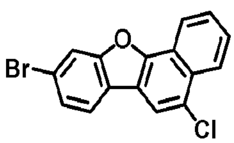

Sub 3-16

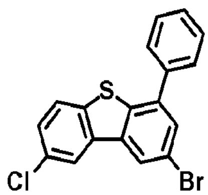

Sub 3-17

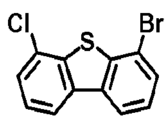

Sub 3-18

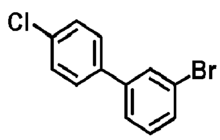

Sub 3-19

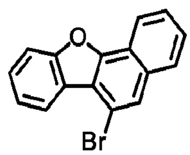

Sub 3-20

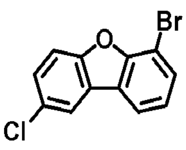
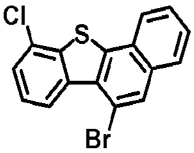
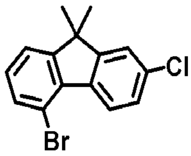
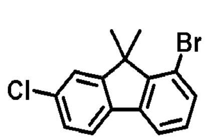
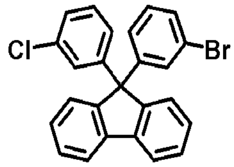

Sub 3-21 Sub 3-22 Sub 3-23 Sub 3-24 Sub 3-25

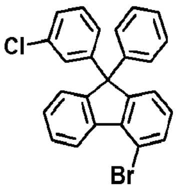
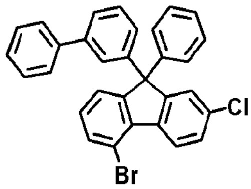
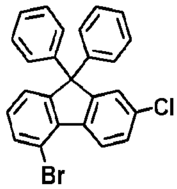
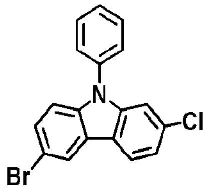
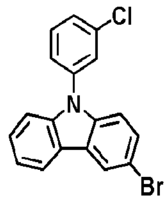

Sub 3-26 Sub 3-27 Sub 3-28 Sub 3-29 Sub 3-30

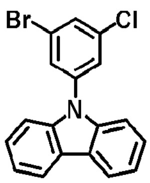
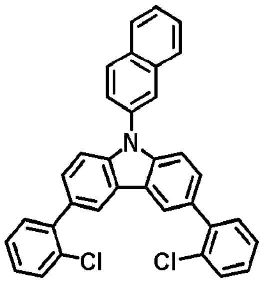
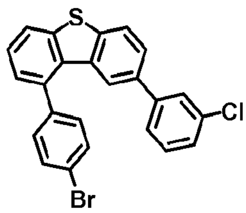
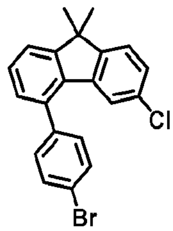
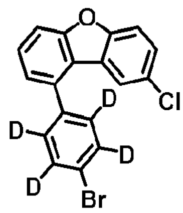

Sub 3-31 Sub 3-32 Sub 3-33 Sub 3-34 Sub 3-35

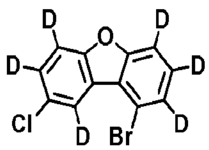
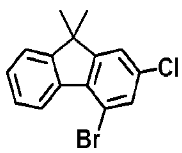
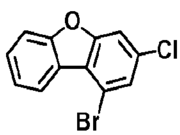
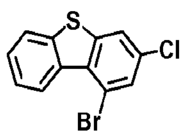
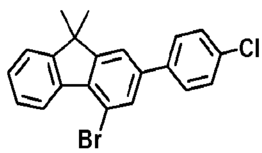

Sub 3-36 Sub 3-37 Sub 3-38 Sub 3-39 Sub 3-40

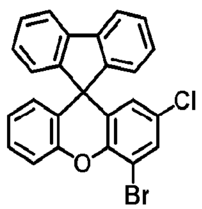
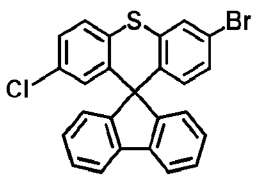
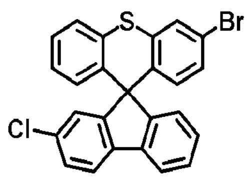
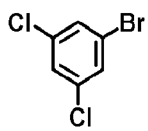
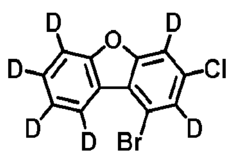

Sub 3-41 Sub 3-42 Sub 3-43 Sub 3-44 Sub 3-45

[Table 4]

| compound | FD-MS | compound | FD-MS |
|---|---|---|---|
| Sub 3-1 | m/z=189.92($C_6H_4BrCl$=191.45) | Sub 3-2 | m/z=265.95($C_{12}H_8BrCl$=267.55) |
| Sub 3-3 | m/z=295.91($C_{12}H_6BrClS$=297.59) | Sub 3-4 | m/z=279.93($C_{12}H_6BrClO$=281.53) |

(continued)

| compound | FD-MS | compound | FD-MS |
|---|---|---|---|
| Sub 3-5 | m/z=354.98($C_{18}H_{11}BrClN$=356.65) | Sub 3-6 | m/z=305.98($C_{15}H_{12}BrCl$=307.61) |
| Sub 3-7 | m/z=430.01($C_{25}H_{16}BrCl$=431.76) | Sub 3-8 | m/z=506.04($C_{31}H_{20}BrCl$=507.85) |
| Sub 3-9 | m/z=506.04($C_{31}H_{20}BrCl$=507.85) | Sub 3-10 | m/z=428($C_{25}H_{14}BrCl$=429.74) |
| Sub 3-11 | m/z=189.92($C_6H_4BrCl$=191.45) | Sub 3-12 | m/z=478.01($C_{29}H_{16}BrCl$=479.8) |
| Sub 3-13 | m/z=355.96($C_{18}H_{10}BrClO$=357.63) | Sub 3-14 | m/z=295.91($C_{12}H_6BrClS$=297.59) |
| Sub 3-15 | m/z=295.91($C_{12}H_6BrClS$=297.59) | Sub 3-16 | m/z=329.94($C_{16}H_8BrClO$=331.59) |
| Sub 3-17 | m/z=371.94($C_{18}H_{10}BrClS$=373.69) | Sub 3-18 | m/z=295.91($C_{12}H_6BrClS$=297.59) |
| Sub 3-19 | m/z=265.95($C_{12}H_8BrCl$=267.55) | Sub 3-20 | m/z=295.98($C_{16}H_9BrO$=297.15) |
| Sub 3-21 | m/z=279.93($C_{12}H_6BrClO$=281.53) | Sub 3-22 | m/z=345.92($C_{16}H_8BrClS$=347.65) |
| Sub 3-23 | m/z=305.98($C_{15}H_{12}BrCl$=307.61) | Sub 3-24 | m/z=305.98($C_{15}H_{12}BrCl$=307.61) |
| Sub 3-25 | m/z=430.01($C_{25}H_{16}BrCl$=431.76) | Sub 3-26 | m/z=430.01($C_{25}H_{16}BrCl$=431.76) |
| Sub 3-27 | m/z=506.04($C_{31}H_{20}BrCl$=507.85) | Sub 3-28 | m/z=430.01($C_{25}H_{16}BrCl$=431.76) |
| Sub 3-29 | m/z=354.98($C_{18}H_{11}BrClN$=356.65) | Sub 3-30 | m/z=354.98($C_{18}H_{11}BrClN$=356.65) |
| Sub 3-31 | m/z=354.98($C_{18}H_{11}BrClN$=356.65) | Sub 3-32 | m/z=513.11($C_{34}H_{21}Cl_2N$=514.45) |
| Sub 3-33 | m/z=447.97($C_{24}H_{14}BrClS$=449.79) | Sub 3-34 | m/z=382.01($C_{21}H_{16}BrCl$=383.71) |
| Sub 3-35 | m/z=359.99($C_{18}H_6D_4BrClO$=361.66) | Sub 3-36 | m/z=285.97($C_{12}D_6BrClO$=287.57) |
| Sub 3-37 | m/z=305.98($C_{15}H_{12}BrCl$=307.61) | Sub 3-38 | m/z=279.93($C_{12}H_6BrClO$=281.53) |
| Sub 3-39 | m/z=295.91($C_{12}H_6BrClS$=297.59) | Sub 3-40 | m/z=382.01($C_{21}H_{16}BrCl$=383.71) |
| Sub 3-41 | m/z=443.99($C_{25}H_{14}BrClO$=445.74) | Sub 3-42 | m/z=459.97($C_{25}H_{14}BrClS$=461.8) |
| Sub 3-43 | m/z=459.97($C_{25}H_{14}BrClS$=461.8) | Sub 3-44 | m/z=223.88($C_6H_3BrCl_2$=225.89) |
| Sub 3-45 | m/z=285.97($C_{12}D_6BrClO$=287.57) | | |

II. Synthesis of Final Product 2

1. Synthesis example of P2-22

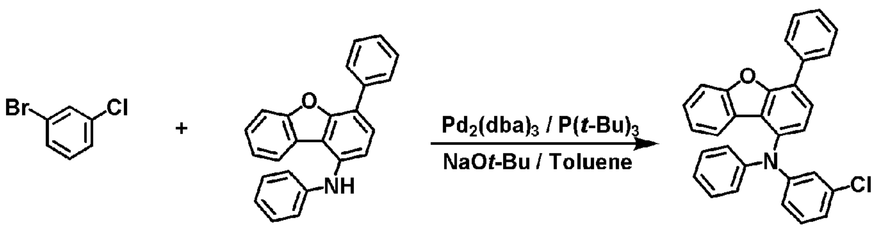


**Sub 3-11** **Sub 2-101** **Inter 1**

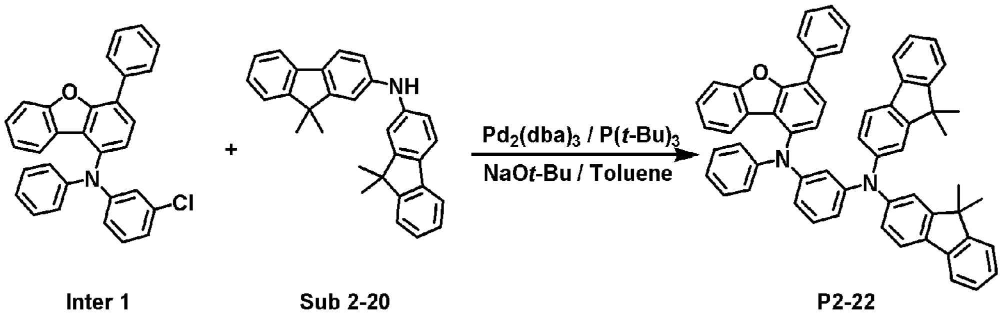


Inter 1 Sub 2-20 P2-22

(1) Synthesis of Inter 1

Sub 3-11 (30 g, 156.7 mmol), Toluene (390 mL), Sub 2-101 (52.6 g, 156.7 mmol), $Pd_2(dba)_3$ (4.3 g, 4.7 mmol), P(*t*-Bu)$_3$ (1.9 g, 9.4 mmol), NaO*t*-Bu (30.1 g, 313.4 mmol) were added and stirred at 50°C. When the reaction was completed, the organic layer was extracted with Toluene and water, dried over $MgSO_4$, concentrated, and the resulting compound was recrystallized using a silica gel column to obtain the product (49.6 g, 71%).

(2) Synthesis of P2-22

Inter 1 (20 g, 44.8 mmol), Toluene (110 mL), Sub 2-20 (18.0 g, 44.8 mmol), $Pd_2(dba)_3$ (1.2 g, 1.3 mmol), P(*t*-Bu)$_3$ (0.5g, 2.7 mmol), NaO*t*-Bu (8.6 g, 89.7 mmol) were added and stirred at 100°C. When the reaction was completed, the organic layer was extracted with Toluene and water, dried over $MgSO_4$, concentrated, and the resulting compound was recrystallized using a silica gel column to obtain the product (29.5 g, 81%).

2. Synthesis example of P2-36

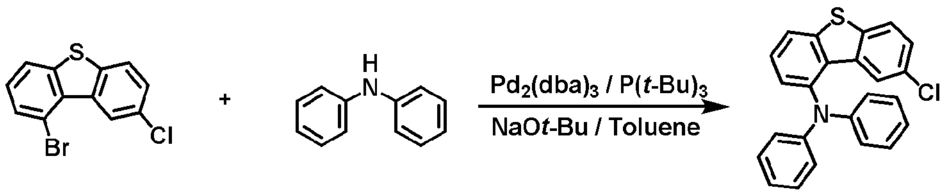


Sub 3-14 Sub 2-83 Inter 2

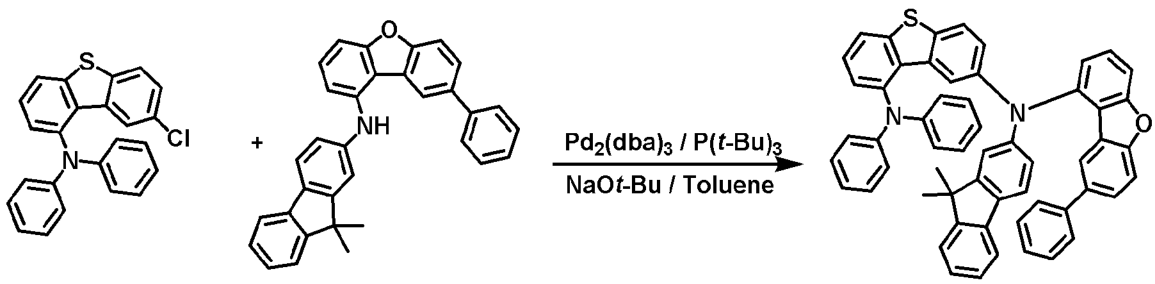


Inter 2 Sub 2-63 P2-36

(1) Synthesis of Inter 2

Sub 3-14 (30 g, 100.8 mmol), Toluene (250 mL), Sub 2-83 (17.1 g, 100.8 mmol), $Pd_2(dba)_3$ (2.8 g, 3.0 mmol), P(*t*-Bu)$_3$ (1.2 g, 6.0 mmol), NaOt-Bu (19.4 g, 201.6 mmol) were added and stirred at 50°C. When the reaction was completed, the organic layer was extracted with Toluene and water, dried over $MgSO_4$, concentrated, and the resulting compound was recrystallized using a silica gel column to obtain the product (30.7 g, 79%).

(2) Synthesis of P2-36

Inter 2 (20 g, 51.8 mmol), Toluene (130 mL), Sub 2-63 (23.4 g, 51.8 mmol), $Pd_2(dba)_3$ (1.4 g, 1.6 mmol), P(*t*-Bu)$_3$ (0.6g, 3.1 mmol), NaOt-Bu (10.0 g, 103.7 mmol) were added and stirred at 100°C. When the reaction was completed, the organic layer was extracted with Toluene and water, dried over $MgSO_4$, concentrated, and the resulting compound was recrystallized using a silica gel column to obtain the product (32.0 g, 77%).

3. Synthesis example of P2-45

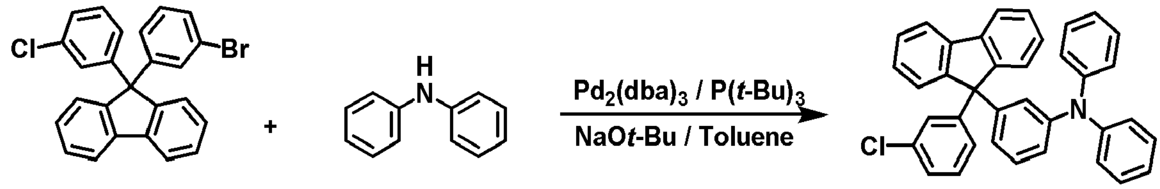


Sub 3-25 Sub 2-83 Inter 3

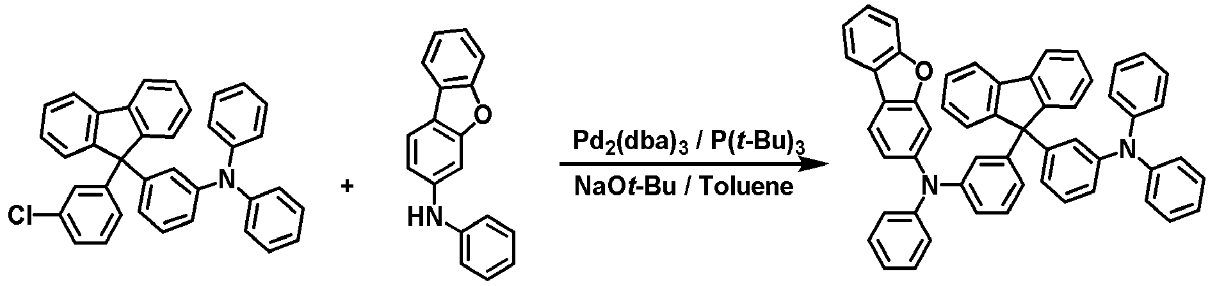


Inter 3 Sub 2-98 P2-45

(1) Synthesis of Inter 3

Sub 3-25 (30 g, 69.5 mmol), Toluene (175 mL), Sub 2-83 (11.8 g, 69.5 mmol), $Pd_2(dba)_3$ (1.9 g, 2.1 mmol), P(*t*-Bu)$_3$ (0.8 g, 4.2 mmol), NaOt-Bu (13.4 g, 139.0 mmol) were added and stirred at 50°C. When the reaction was completed, the organic layer was extracted with Toluene and water, dried over $MgSO_4$, concentrated, and the resulting compound was recrystallized using a silica gel column to obtain the product (23.8 g, 66%).

(2) Synthesis of P2-45

Inter 3 (20 g, 38.5 mmol), Toluene (145 mL), Sub 2-98 (10.0 g, 38.5 mmol), $Pd_2(dba)_3$ (1.1 g, 1.2 mmol), P(*t*-Bu)$_3$ (0.5g, 2.3 mmol), NaOt-Bu (7.4 g, 76.9 mmol) were added and stirred at 100°C. When the reaction was completed, the organic layer was extracted with Toluene and water, dried over $MgSO_4$, concentrated, and the resulting compound was recrystallized using a silica gel column to obtain the product (20.6 g, 72%).

4. Synthesis example of P2-61

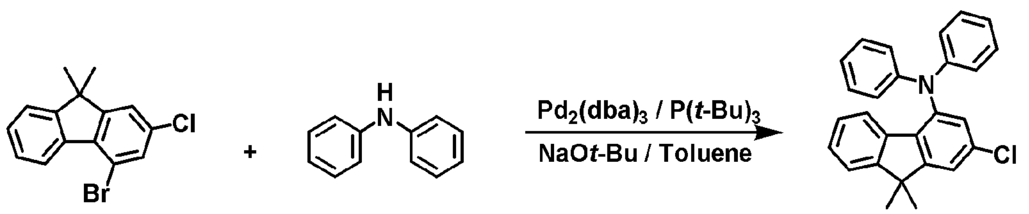


Sub 3-37 Sub 2-83 Inter 4

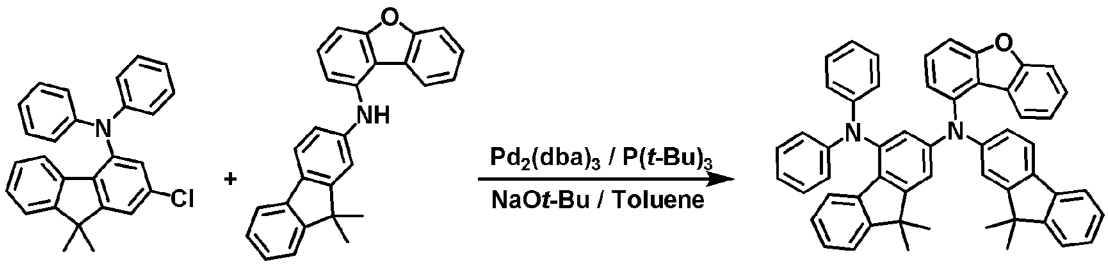


Inter 4

Sub 2-146

P2-61

(1) Synthesis of Inter 4

Sub 3-37 (30 g, 97.5 mmol), Toluene (245 mL), Sub 2-83 (16.5 g, 97.5 mmol), $Pd_2(dba)_3$ (2.7 g, 2.9 mmol), P(*t*-Bu)$_3$ (1.2 g, 5.9 mmol), NaO*t*-Bu (18.8 g, 195.1 mmol) were added and stirred at 50°C. When the reaction was completed, the organic layer was extracted with Toluene and water, dried over $MgSO_4$, concentrated, and the resulting compound was recrystallized using a silica gel column to obtain the product (33.2 g, 86%).

(2) Synthesis of P2-61

Inter 4 (20 g, 50.5 mmol), Toluene (130 mL), Sub 2-146 (19.0 g, 50.5 mmol), $Pd_2(dba)_3$ (1.4 g, 1.5 mmol), P(*t*-Bu)$_3$ (0.6g, 3.0 mmol), NaOt-Bu (9.7 g, 101.0 mmol) were added and stirred at 100°C. When the reaction was completed, the organic layer was extracted with Toluene and water, dried over $MgSO_4$, concentrated, and the resulting compound was recrystallized using a silica gel column to obtain the product (27.5 g, 74%).

The FD-MS values of compounds P2-1 to P2-76 of the present invention manufactured according to the synthetic examples are as shown in Table 5.

[Table 5]

| compound | FD-MS | compound | FD-MS |
|---|---|---|---|
| P2-1 | m/z=716.32($C_{54}H_{40}N_2$=716.93) | P2-2 | m/z=792.35($C_{60}H_{44}N_2$=793.03) |
| P2-3 | m/z=840.35($C_{64}H_{44}N_2$=841.07) | P2-4 | m/z=694.24($C_{so}H_{34}N_2S$=694.9) |
| P2-5 | m/z=754.3($C_{56}H_{38}N_2O$=754.93) | P2-6 | m/z=805.35($C_{60}H_{43}N_3$=806.02) |
| P2-7 | m/z=768.31($C_{57}H_{40}N_2O$=768.96) | P2-8 | m/z=858.36($C_{64}H_{46}N_2O$=859.09) |
| P2-9 | m/z=893.38($C_{67}H_{47}N_3$ =894.13) | P2-10 | m/z=924.32($C_{67}H_{44}N_2OS$=925.16) |
| P2-11 | m/z=816.31($C_{61}H_{40}N_2O$=817) | P2-12 | m/z=865.35($C_{65}H_{43}N_3$=866.08) |
| P2-13 | m/z=768.35($C_{58}H_{44}N_2$=769) | P2-14 | m/z=634.24($C_{45}H_{34}N_2S$=634.84) |
| P2-15 | m/z=652.29($C_{49}H_{36}N_2$=652.84) | P2-16 | m/z=818.33($C_{61}H_{42}N_2O$=819.02) |
| P2-17 | m/z=694.3($C_{51}H_{38}N_2O$=694.88) | P2-18 | m/z=894.36($C_{67}H_{46}N_2O$=895.12) |
| P2-19 | m/z=742.3($C_{55}H_{38}N_2O$=742.92) | P2-20 | m/z=856.29($C_{60}H_{44}N_2S_2$=857.15) |
| P2-21 | m/z=718.3($C_{53}H_{38}N_2O$=718.9) | P2-22 | m/z=810.36($C_{60}H_{46}N_2O$=811.04) |
| P2-23 | m/z=868.35($C_{65}H_{44}N_2O$=869.08) | P2-24 | m/z=942.36($C_{71}H_{46}N_2O$=943.16) |
| P2-25 | m/z=886.39($C_{66}H_{50}N_2O$=887.14) | P2-26 | m/z=796.38($C_{60}H_{48}N_2$=797.06) |
| P2-27 | m/z=782.33($C_{58}H_{42}N_2O$=782.99) | P2-28 | m/z=846.27($C_{61}H_{38}N_2OS$=847.05) |
| P2-29 | m/z=758.28($C_{55}H_{38}N_2S$=758.98) | P2-30 | m/z=694.3($C_{51}H_{38}N_2O$=694.88) |
| P2-31 | m/z=756.31($C_{56}H_{40}N_2O$=756.95) | P2-32 | m/z=718.26($C_{52}H_{34}N_2O_2$=718.86) |
| P2-33 | m/z=850.3($C_{61}H_{42}N_2OS$=851.08) | P2-34 | m/z=876.35($C_{64}H_{48}N_2S$=877.16) |
| P2-35 | m/z=840.32($C_{60}H_{44}N_2OS$=841.09) | P2-36 | m/z=800.29($C_{57}H_{40}N_2OS$=801.02) |
| P2-37 | m/z=901.31($C_{64}H_{43}N_3OS$=902.13) | P2-38 | m/z=922.32($C_{67}H_{42}N_2O_3$=923.08) |
| P2-39 | m/z=810.36($C_{60}H_{46}N_2O$=811.04) | P2-40 | m/z=784.31($C_{57}H_{40}N_2O_2$=784.96) |

(continued)

| compound | FD-MS | compound | FD-MS |
|---|---|---|---|
| P2-41 | m/z=1008.33($C_{70}H_{48}N_4S_2$=1009.3) | P2-42 | m/z=809.3($C_{58}H_{39}N_3O_2$=809.97) |
| P2-43 | m/z=850.39($C_{63}H_{50}N_2O$=851.11) | P2-44 | m/z=694.3($C_{51}H_{38}N_2O$=694.88) |
| P2-45 | m/z=742.3($C_{55}H_{38}N_2O$=742.92) | P2-46 | m/z=818.33($C_{61}H_{42}N_2O$=819.02) |
| P2-47 | m/z=920.41($C_{70}H_{52}N_2$=921.2) | P2-48 | m/z=966.4($C_{74}H_{50}N_2$=967.23) |
| P2-49 | m/z=833.34($C_{61}H_{43}N_3O$=834.03) | P2-50 | m/z=835.3($C_{60}H_{41}N_3S$=836.07) |
| P2-51 | m/z=997.35($C_{73}H_{47}N_3S$=998.26) | P2-52 | m/z=779.33($C_{58}H_{41}N_3$=779.9 9) |
| P2-53 | m/z=892.35($C_{64}H_{48}N_2OS$=893.16) | P2-54 | m/z=978.45($C_{73}H_{58}N_2O$=979.28) |
| P2-55 | m/z=758.37($C_{54}H_{22}D_{14}N_2O_2$=758.98) | P2-56 | m/z=785.3($C_{54}H_{23}D_{11}N_2O_2S$=786.01) |
| P2-57 | m/z=924.44($C_{67}H_{28}D_{16}N_2O_2$=925.2) | P2-58 | m/z=835.32($C_{60}H_{41}N_3O_2$=836.01) |
| P2-59 | m/z=925.33($C_{66}H_{43}N_3O_3$=926.09) | P2-60 | m/z=891.33($C_{63}H_{45}N_3OS$=892.13) |
| P2-61 | m/z=734.33($C_{54}H_{42}N_2O$=734.94) | P2-62 | m/z=832.31($C_{61}H_{40}N_2O_2$=833) |
| P2-63 | m/z=1028.31($C_{73}H_{44}N_2O_3S$=1029.23) | P2-64 | m/z=906.32($C_{67}H_{42}N_2O_2$=907.09) |
| P2-65 | m/z=784.31($C_{57}H_{40}N_2O_2$=784.96) | P2-66 | m/z=980.31($C_{69}H_{44}N_2O_3S$=981.18) |
| P2-67 | m/z=784.31($C_{57}H_{40}N_2O_2$=784.96) | P2-68 | m/z=938.3($C_{67}H_{42}N_2O_2S$=939.14) |
| P2-69 | m/z=900.37($C_{66}H_{48}N_2O_2$=901.12) | P2-70 | m/z=922.36($C_{68}H_{46}N_2O_2$=923.13) |
| P2-71 | m/z=938.3($C_{67}H_{42}N_2O_2S$=939.14) | P2-72 | m/z=888.32($C_{64}H_{44}N_2OS$=889.13) |
| P2-73 | m/z=780.3($C_{54}H_{32}D_5N_3OS$=781) | P2-74 | m/z=849.3($C_{60}H_{39}N_3O_3$=849.9 9) |
| P2-75 | m/z=849.3($C_{60}H_{39}N_3O_3$=849.99) | P2-76 | m/z=856.57($C_{61}D_{40}N_2O$=857.25) |

Meanwhile, exemplary synthesis examples of the present invention represented by Formula 1 and Formula 2 have been described, but these are all based on the Buchwald-Hartwig cross coupling reaction, Miyaura boration reaction, Suzuki cross-coupling reaction, Intramolecular acid-induced cyclization reaction (*J. mater. Chem.*1999, 9, 2095.), Pd(II)-catalyzed oxidative cyclization reaction (*Org. Lett.*2011*,* 13, 5504), and $PPh_3$-mediated reductive cyclization reaction (*J. Org. Chem.* 2005, 70, 5014.), and it will be easily understood by those skilled in the art that the reaction proceeds even when other substituents defined in Formula 1 are bonded in addition to the substituents specified in the specific synthesis examples.

Capacitance measurement

In the present invention, an ALPHA-AN Analyzer was used as an impedance measuring instrument and a device having a BNC (input)/RF (output) terminal was used as a jig. The measurement conditions were based on a frequency of 500 Hz, the DC voltage was measured from 0 V to 4 V in 0.01 increments, and the AC voltage was set to +0.1V.

Capacitance was measured using an organic electronic element configured as shown in FIG. 1, and the difference in capacitance characteristic values was calculated as shown in Equation 2. The capacitance characteristic values measured according to the capacitance measurement method and the photoelectrical characteristics of the organic electronic element are as shown in Table 6.

Manufacturing and Evaluation of organic electronic elements

[Example 1] Green organic light emitting device

After vacuum-depositing $N^1$-(naphthalen-2-yl)-$N^4$,$N^4$-bis(4-(naphthalen-2-yl(phenyl)amino)phenyl)-$N^1$-phenyl-benzene-1,4-diamine (hereinafter '2-TNATA') film on top of a 150 nm thick ITO (Indium Tin Oxide) anode formed on an organic substrate, a 10 nm thick hole injection layer was formed, a hole transport layer was formed by vacuum depositing P1-39 as shown in Table 6 to a thickness of 120 nm on the hole injection layer. Compound P1-15 was vacuum-deposited to a thickness of 30 nm on the hole transport layer to form a buffer layer, and then compound P1-86 was vacuum-deposited to a thickness of 10 nm on the buffer layer to form an emitting-auxiliary layer. On the emitting-auxiliary layer, an emitting layer with a thickness of 30 nm was formed by doping 4,4'-N,N'-dicarbazole-biphenyl (hereinafter, CBP) as a host material and

tris[2-phenylpyridinato-C2,N]iridium(III) (hereinafter, 'Ir(ppy)$_3$') as a dopant at a weight ratio of 92:8. 2,2',2"-(1,3,5-benzinetriyl)-tris(1-phenyl-1-Hbenzimidazole) (hereinafter abbreviated as 'TPBi') was deposited on the emitting layer to a thickness of 40 nm, LiF was deposited to a thickness of 1 nm to form an electron injection layer, and Mg and Ag were deposited at a weight ratio of 1:9 on the electron injection layer to form a cathode to a thickness of 20 nm.

[Example 2] to [Example 15] or [Comparative Example 1] to [Comparative Example 2]

An organic electronic element was manufactured in the same manner as in Example 1, except that the compound of the present invention described in Table 6 was used.

The electroluminescence (EL) characteristics were measured using CS-2000 from Minolta by applying a positive DC voltage to the organic electronic elements manufactured in the present invention, and the capacitance was measured using an ALPHA-AN Analyzer impedance measuring instrument manufactured by Novocontrol. The luminescence lifetime of the organic electronic element was measured at room temperature up to T95 (95% of the initial luminance of 100%) using the M6100 equipment manufactured by Mcscience.

Additionally, among the device characteristics of the organic electronic element in Table 1, the driving voltage and current density represent characteristics at 5,000 nit, and the Luminescence efficiency, etc. represent characteristics at 15,000 nit.

The measuring apparatus can evaluate the performance of new materials compared to comparative compounds under identical conditions, without being affected by possible daily fluctuations in deposition rate, vacuum quality or other parameters.

During the evaluation, one batch contains 4 identically prepared OLEDs including a comparative compound, and the performance of a total of 12 OLEDs is evaluated in 3 batches, so the value of the experimental results obtained in this way indicates statistical significance.

[Table 6]

| | 정공 수송층 | 버퍼층 | 발광 보조층 | 구동 전압 (V) | 효율 (cd/A) | $V_{cmax}$ (V) | $V_{turn-on}$ (V) | 전류밀도 (@$V_{c(0.8nF)}$) (mA/cm$^2$) | $V_{c(0.8nF)}$ (V) | $V_{cmax}$-$V_{c(0.8nF)}$ (V) | T95 (hrs) |
|---|---|---|---|---|---|---|---|---|---|---|---|
| 비교예 (1) | P1-39 | P2-61 | P1-65 | 3.4 | 152.88 | 2.35 | 2.2 | 1.02E-05 | 0.1 | 1.95 | 69 |
| 비교예 (2) | P1-37 | P1-78 | P1-65 | 3.53 | 153.1 | 2.2.5 | 2.2 | 9.83E-06 | 0.86 | 1.39 | 71 |
| 실시예 (1) | P1-39 | P1-15 | P1-86 | 3.28 | 179.28 | 2.45 | 2.25 | 1.13E-05 | 1.95 | 0.5 | 92 |
| 실시예 (2) | P1-37 | P2-38 | P1-65 | 3.61 | 169.03 | 2.1 | 2.25 | 7.75E-05 | 1.25 | 0.85 | 86 |
| 실시예 (3) | P1-39 | F1-70 | P2-62 | 3.3 | 166.32 | 2.55 | 2.3 | 1. 14E-05 | 2.1 | 0.45 | 97 |
| 실시예 (4) | P1-39 | P2-30 | P2-62 | 3.25 | 179.52 | 2.55 | 2.35 | 7.43E-06 | 2.05 | 0.5 | 93 |
| 실시예 (5) | P1-39 | P2-58 | P2-62 | 3.59 | 167 | 2.7 | 2.3 | 8.02E-05 | 2.13 | 0.57 | 91 |
| 실시예 (6) | P1-75 | P2-36 | P1-72 | 3.66 | 171.38 | 2.15 | 2.35 | 4.38E-05 | 1.36 | 0.79 | 92 |
| 실시예 (7) | P1-39 | P1-69 | P1-86 | 3.31 | 182.71 | 2.45 | 2.2 | 3.76E-05 | 1.83 | 0.62 | 89 |
| 실시예 (8) | P1-37 | P2-36 | P1-65 | 3.25 | 165.4 | 2.35 | 2.15 | 6.31E-06 | 1.12 | 1.23 | 81 |
| 실시예 (9) | P1-39 | P1-70 | P1-85 | 3.21 | 168.05 | 2.35 | 2.1 | 5.13E-06 | 1.38 | 0.77 | 82 |
| 실시예 (10) | P1-39 | P1-70 | P1-88 | 3.59 | 177.9 | 2.6 | 2.1 | 9.18E-01 | 1.94 | 0.66 | 95 |
| 실시예 (11) | P1-39 | P2-36 | P2-62 | 3.49 | 179.7 | 2.6 | 2.3 | 6.82.E-04 | 2.2 | 0.4 | 96 |
| 실시예 (12) | P1-39 | P2-36 | P2-57 | 3.35 | 177.4 | 2.45 | 2.2 | 6.62E-06 | 2.09 | 0.36 | 92 |
| 실시예 (13) | P1-39 | P1-23 | P2-56 | 3.35 | 179.7 | 2.5 | 2.3 | 2.79E-05 | 2.02 | 0.48 | 99 |
| 실시예 (14) | PI-39 | P2-36 | P1-89 | 3.44 | 181.1 | 2.6 | 2.3 | 5.56 .E-04 | 2.15 | 0.45 | 103 |
| 실시예 (15) | P1-39 | P2-36 | P1-93 | 3.4 | 203.8 | 2.55 | 2.3 | 3.74E-05 | 2.14 | 0.41 | 117 |

As can be seen from the results in Table 6, it can be confirmed that the examples of organic electronic element satisfying Equation 2, which are fabricated by combining various hole transport layers, buffer layers, and emitting-auxiliary layers, have significantly improved element characteristics compared to the comparative examples that do not satisfy Equation 2, and in particular, the lifetime is greatly improved.

The timing of $V_{c(0.8nF)}$ and $V_{cmax}$ may vary depending on the interaction of the hole transport layer, buffer layer, and emitting-auxiliary layer, thereby controlling the Hole trap and changing the performance of the organic electronic element. In particular, in terms of lifetime, since the voltage of $V_{c(0.8nF)}$ increases and the range of voltage difference up to $V_{cmax}$ is small, the deterioration of the interface can be minimized through rapid exhaustion of carriers stored inside.

This means that from the perspective of the lifetime of organic electronic elements, having an appropriate level of Capacitance characteristics may be more appropriate for improving element performance, since unconditional rapid carrier consumption can result in an extremely narrow recombination region where Exciton Confinement occurs. Depending on the structure and material properties of the element, appropriate Capacitance characteristics may vary.

Therefore, in the present invention, it was confirmed that the lifetime and efficiency of the element can be improved depending on the values of $V_{c(08nF)}$ and $V_{cmax}$ among the Capacitance characteristics.

FIG. 3 is a graph showing the lifetime of an organic electronic element according to the $V_{cmax}$ - $V_{C\ (0.8\ nF)}$ value according to one embodiment of the present invention.

FIG. 4 is a graph showing the efficiency of an organic electronic element according to the $V_{cmax}$ - $V_{C\ (0.8\ nF)}$ value according to one embodiment of the present invention.

That is, as can be seen in FIGS. 3 and 4, the lifetime and efficiency of the element increase according to the $V_{cmax}$ - $V_{C\ (0.8\ nF)}$ value, and in particular, it can be seen that the lifetime and efficiency increase significantly in an element having a $V_{Cmax}$ - $V_{C\ (0.8\ nF)}$ value of 1.3 or less, as in the present invention.

Additionally, FIG. 2 is a graph showing the results of a Capacitance measurement experiment. Example 15 shows that $V_{cmax}$ - $V_{C\ (08\ nF)}$ value is less than or equal to 1.3 V, while Comparative Example 1 shows that $V_{cmax}$ - $V_{C\ (0.8\ nF)}$ value exceeds 1.3 V. It appears that when $V_{cmax}$ - $V_{C\ (0.8\ nF)}$ value exceeds 1.3 V, unnecessary charge accumulation at the interface occurs due to an increase in trapped holes. This causes the formation of the exciton recombination zone to move to the interface of the emitting-auxiliary layer, which lowers the charge carrier balance and reduces the emitting efficiency and lifetime. Also, in the case of Comparative Example 1, holes are accumulated more at the interface between the emitting-auxiliary layer and the emitting layer than in Example 15. As the hole accumulation progresses more, the hole release in the emitting layer also occurs more rapidly and excitons are also generated more rapidly, which causes deterioration at the interface between the emitting-auxiliary layer and the emitting layer and roll-off of the efficiency of the entire element. In summary, more stable structure of the organic electronic devices results in a delayed onset of VC(0.8 nF) and a more rapid decrease in capacitance.

In Comparative Example 1, the accumulation of holes started before 1 V, and after the electric capacity increased, a voltage of 2 V or more was consumed for the consumption of internally stored carriers at 3 V or more, but in Example 11, the accumulation of holes started at 2 V or more, and a voltage of about 1 V was consumed for the consumption of internally stored carriers at 3 V or more, so it seems to exhibit excellent characteristics in terms of efficiency and lifetime. It can be understood that organic electronic elements with suitable interactions between the hole transport layer, buffer layer, and emitting-auxiliary layer have a characteristic of rapid decrease in capacitance due to rapid consumption of charged carriers within a short voltage range.

Although exemplary embodiments of the present invention have been described for illustrative purposes, those skilled in the art will appreciate that various modifications, additions and substitutions are possible, without departing from the scope and spirit of the invention as disclosed in the accompanying claims. Therefore, the embodiment disclosed in the present invention is intended to illustrate the scope of the technical idea of the present invention, and the scope of the present invention is not limited by the embodiment.

The scope of the present invention shall be construed on the basis of the accompanying claims, and it shall be construed that all of the technical ideas included within the scope equivalent to the claims belong to the present invention.

## Claims

1. An organic electronic element comprising a first electrode; second electrode; and an organic material layer comprising an emitting layer formed between the first electrode and the second electrode; wherein the organic material layer comprises a hole transport layer formed between the first electrode and the emitting layer, and an emitting-auxiliary layer formed between the hole transport layer and the emitting layer, wherein the organic electronic element has capacitance characteristics satisfying Equation 2.

[Equation 2]

$$V_{cmax} - V_{c(0.8nF)} \leq 1.3\ V$$

Wherein:

1) $V_{Cmax}$ is the voltage value at which the capacitance of an organic electronic element after deposition is measured to be maximum.
2) $V_{C(0.8nF)}$ is the voltage value at which the capacitance of the organic electronic element after deposition is measure to be 0.8 nF.

**2.** The organic electronic element according to claim 1, wherein the $V_{Cmax}$ is the driving voltage range of exciton recombination of the organic electronic element which is $\pm 0.5$ of $V_{turn\text{-}on}$.

**3.** The organic electronic element according to claim 1, wherein the range of the $V_{C(0.8nF)}$ is the driving voltage range of the organic electronic element having a current density range of $1.0\times10^{-7}$ to $1.0\times10^{-4}$ mA/cm$^2$.

**4.** The organic electronic element according to claim 1, wherein a buffer layer is further formed between the hole transport layer and the emitting-auxiliary layer.

**5.** The organic electronic element according to claim 4, wherein at least one of the hole transport layer, the buffer layer and the emitting-auxiliary layer comprise a compound represented by Formula 1 or Formula 2:

[Formula 1]

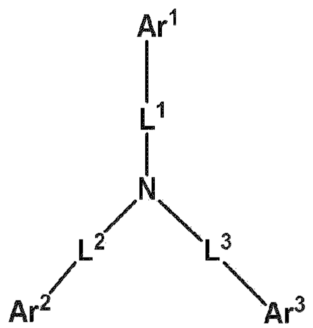

[Formula 2]

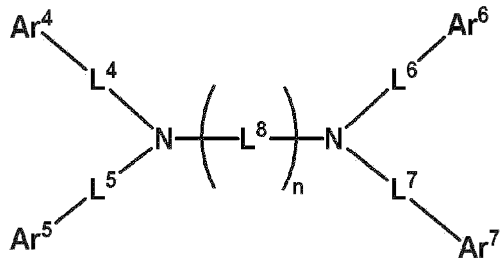

Wherein:

$L^1$, $L^2$, $L^3$, $L^4$, $L^5$, $L^6$ and $L^7$ are each independently selected from the group consisting of single bond; a $C_6$-$C_{60}$ arylene group; a fluorenylene group; a $C_2$-$C_{60}$ heterocyclic group including at least one heteroatom of O, N, S, Si or P; and a fused ring group of a $C_3$-$C_{60}$ aliphatic ring and a $C_6$-$C_{60}$ aromatic ring;
$L^8$ is each independently selected from the group consisting of a $C_6$-$C_{60}$ arylene group; a fluorenylene group; a $C_2$-$C_{60}$ heterocyclic group including at least one heteroatom of O, N, S, Si or P; and a fused ring group of a $C_3$-$C_{60}$ aliphatic ring and a $C_6$-$C_{60}$ aromatic ring;
$Ar^1$, $Ar^2$, $Ar^3$, $Ar^4$, $Ar^5$, $Ar^6$ and $Ar^7$ are each independently selected from the group consisting of an $C_6$-$C_{60}$ aryl group; a fluorenyl group; a $C_2$-$C_{60}$ heterocyclic group including at least one heteroatom of O, N, S, Si or P; a fused ring group of a $C_3$-$C_{60}$ aliphatic ring and a $C_6$-$C_{60}$ aromatic ring; a $C_3$-$C_{60}$ aliphatic ring; a $C_1$-$C_{50}$ alkyl group; a $C_2$-$C_{20}$ alkenyl group; a $C_2$-$C_{20}$ alkynyl group; a $C_1$-$C_{30}$ alkoxyl group; a $C_6$-$C_{30}$ aryloxy group; and -L'-N(R')(R"); or $Ar^4$ and $Ar^5$ or $Ar^6$ and $Ar^7$ can be bonded to each other to form a ring,
Wherein L' is selected from the group consisting of a single bond; a $C_6$-$C_{60}$ arylene group; a fluorenylene group; a $C_3$-$C_{60}$ aliphatic ring; and a $C_2$-$C_{60}$ heterocyclic group including at least one heteroatom of O, N, S, Si or P;
Wherein R' and R" are each independently selected from the group consisting of an $C_6$-$C_{60}$ aryl group; a fluorenyl group; a $C_3$-$C_{60}$ aliphatic ring; and a $C_2$-$C_{60}$ heterocyclic group including at least one heteroatom of O, N, S, Si or P;
n is an integer from 1 to 3,

wherein the aryl group, arylene group, heterocyclic group, fluorenyl group, fluorenylene group, fused ring group, aliphatic ring group, alkyl group, alkenyl group, alkynyl group, alkoxy group and aryloxy group may be substituted with one or more substituents selected from the group consisting of deuterium; halogen; silane group substituted or unsubstituted with a $C_1$-$C_{20}$ alkyl group or a $C_6$-$C_{20}$ aryl group; siloxane group; boron group; germanium group; cyano group; nitro group; $C_1$-$C_{20}$ alkylthio group; $C_1$-$C_{20}$ alkoxyl group; $C_6$-$C_{20}$ aryloxy group; $C_1$-$C_{20}$ alkyl group; $C_2$-$C_{20}$ alkenyl group; $C_2$-$C_{20}$ alkynyl group; $C_6$-$C_{20}$ aryl group; $C_6$-$C_{20}$ aryl group substituted with deuterium; a fluorenyl group; $C_2$-$C_{20}$ heterocyclic group; a $C_3$-$C_{20}$ cycloalkyl ring; a $C_7$-$C_{20}$ arylalkyl group; a $C_8$-$C_{20}$ arylalkenyl group; and -L'-NR'R"; also the hydrogen of these substituents may be further substituted with one or more deuterium, and also the substituents may be bonded to each other to form a saturated or unsaturated ring, wherein the term 'ring' means a $C_3$-$C_{60}$ aliphatic ring or a $C_6$-$C_{60}$ aromatic ring or a $C_2$-$C_{60}$ heterocyclic group or a fused ring formed by the combination thereof.

**6.** The organic electronic element according to claim 5, wherein at least one of the $Ar^1$, $Ar^2$ and $Ar^3$ and/or at least one of $Ar^4$, $Ar^5$, $Ar^6$ and $Ar^7$ is represented by any one of Formulae Ar-a to Ar-d:

Formula Ar-a

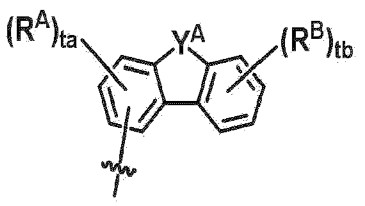

Formula Ar-b

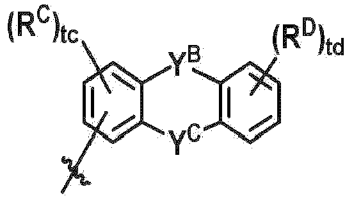

Formula Ar-c

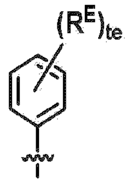

Formula Ar-d

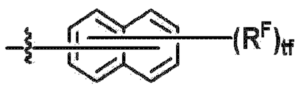

Wherein:

$Y^A$, $Y^B$ and $Y^C$ are each independently O, S, $NR^{1A}$, $Si(R^{1B})(R^{1C})$ or $C(R^{1B})(R^{1C})$, $R^A$, $R^B$, $R^C$, $R^D$, $R^E$, $R^F$, $R^{1A}$, $R^{1B}$ and $R^{1C}$ are each the same or different, and each independently selected from the group consisting of a hydrogen; deuterium; halogen;

cyano group; $C_6$-$C_{20}$ aryl group; $C_6$-$C_{20}$ aryl group substituted with deuterium; a fluorenyl group; a $C_2$-$C_{60}$ heterocyclic group including at least one heteroatom of O, N, S, Si or P; $C_1$-$C_{20}$ alkyl group; $C_2$-$C_{20}$ alkenyl group; $C_2$-$C_{20}$ alkynyl group; $C_1$-$C_{20}$ alkoxyl group; $C_6$-$C_{20}$ aryloxy group; and -L'-N(R')(R"); or an adjacent plurality of $R^A$s or plurality of $R^B$s or plurality of $R^C$s or plurality of $R^D$s or plurality of $R^E$s or plurality of $R^F$s may be bonded to each other to form a ring, or $R^{1B}$ and $R^{1C}$ can be bonded to each other to form a spiro,

ta and tc are each independently an integer of 0 to 3, tb and td are each independently an integer of 0 to 4, te is an integer of 0 to 5, tf is an integer of 0 to 7,

L', R' and R" are the same as defined in claim 5,

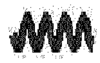

indicates the binding position.

**7.** The organic electronic element according to claim 1, further comprising a light efficiency enhancing layer formed on at least one surface of the first electrode and the second electrode, the surface being opposite to the organic material layer.

8. The organic electronic element according to claim 1, wherein the organic material layer comprises 2 or more stacks comprising a hole transport layer, an emitting layer and an electron transport layer on the first electrode, and at least one of the stacks comprises an emitting auxiliary-layer between the hole transport layer and the emitting layer.

9. The organic electronic element according to claim 8, wherein the organic material layer further comprises a charge generation layer formed between the 2 or more stacks.

10. An electronic device comprising a display device comprising the organic electronic element of claim 1; and a control unit for driving the display device.

11. The electronic device according to claim 10, wherein the organic electronic element is at least one of an OLED, an organic solar cell, an organic photo conductor(OPC), organic transistor (organic TFT) and an element for monochromic or white illumination.

FIG. 1

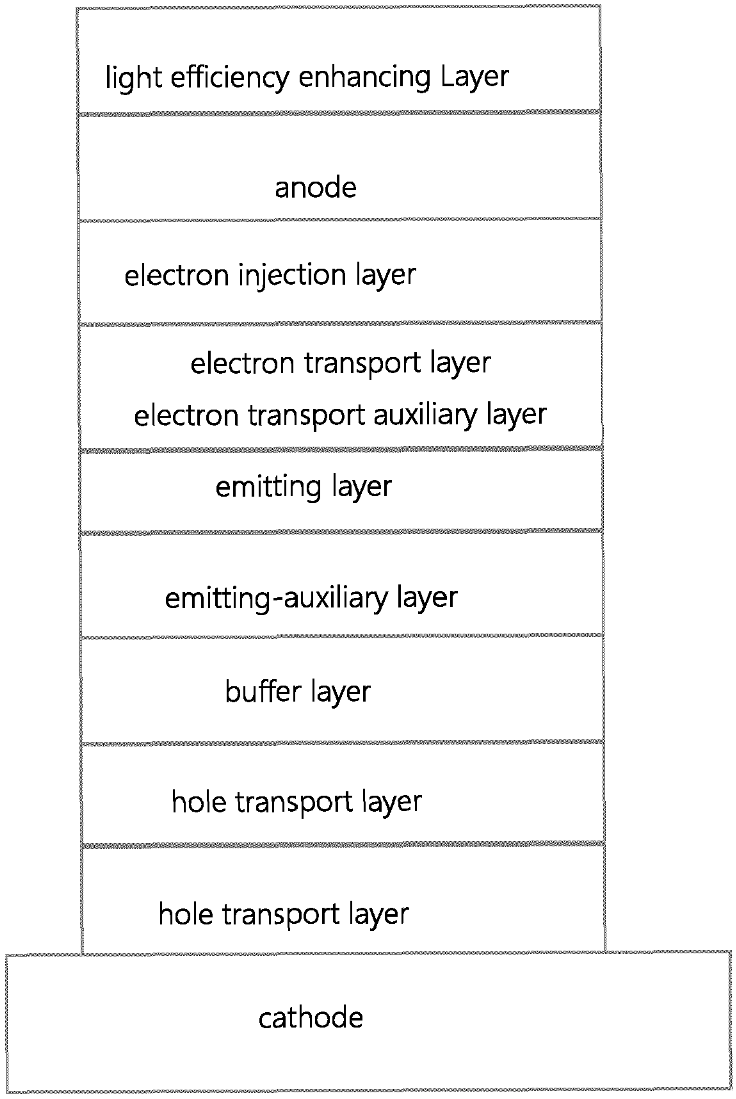
light efficiency enhancing Layer
anode
electron injection layer
electron transport layer
electron transport auxiliary layer
emitting layer
emitting-auxiliary layer
buffer layer
hole transport layer
hole transport layer
cathode

FIG. 2

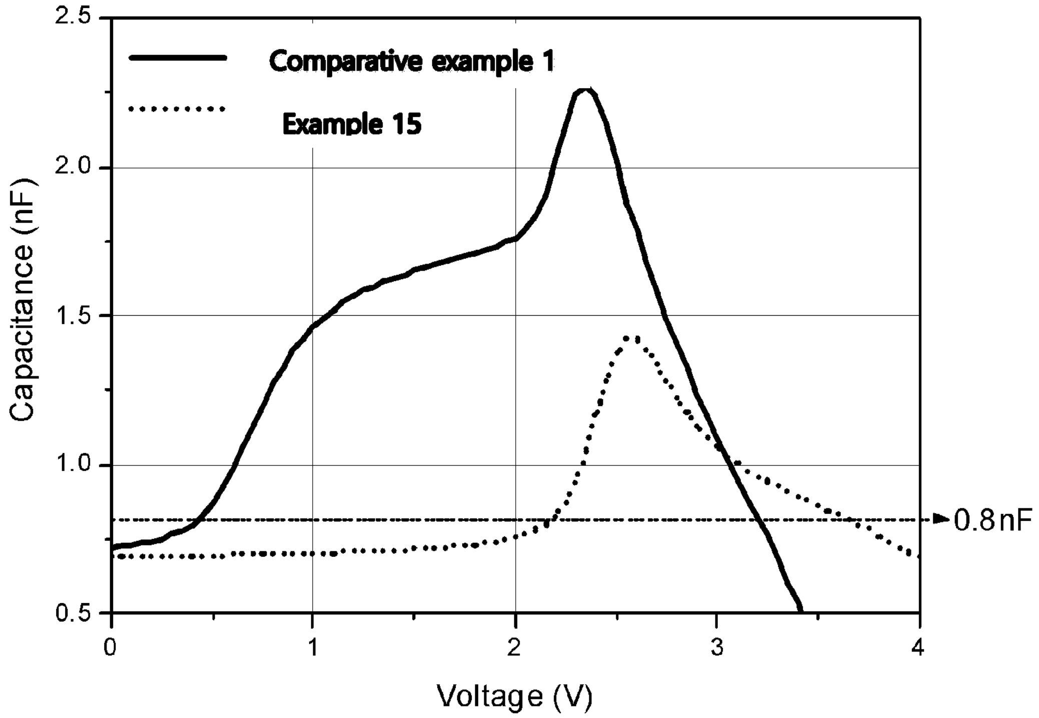
Comparative example 1
Example 15
Capacitance (nF)
2.5
2.0
1.5
1.0
0.5
0
1
2
3
4
Voltage (V)
0.8nF

FIG. 3

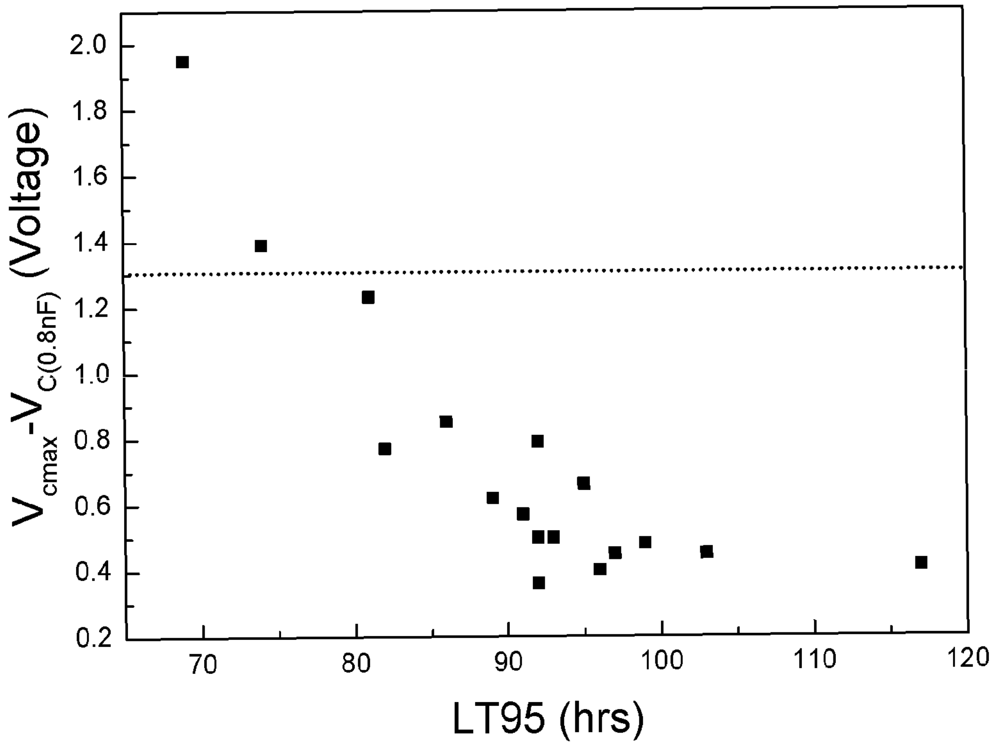
2.0
1.8
1.6
1.4
1.2
1.0
0.8
0.6
0.4
0.2
$V_{cmax}$-$V_{C(0.8nF)}$ (Voltage)
70
80
90
100
110
120
LT95 (hrs)

FIG. 4

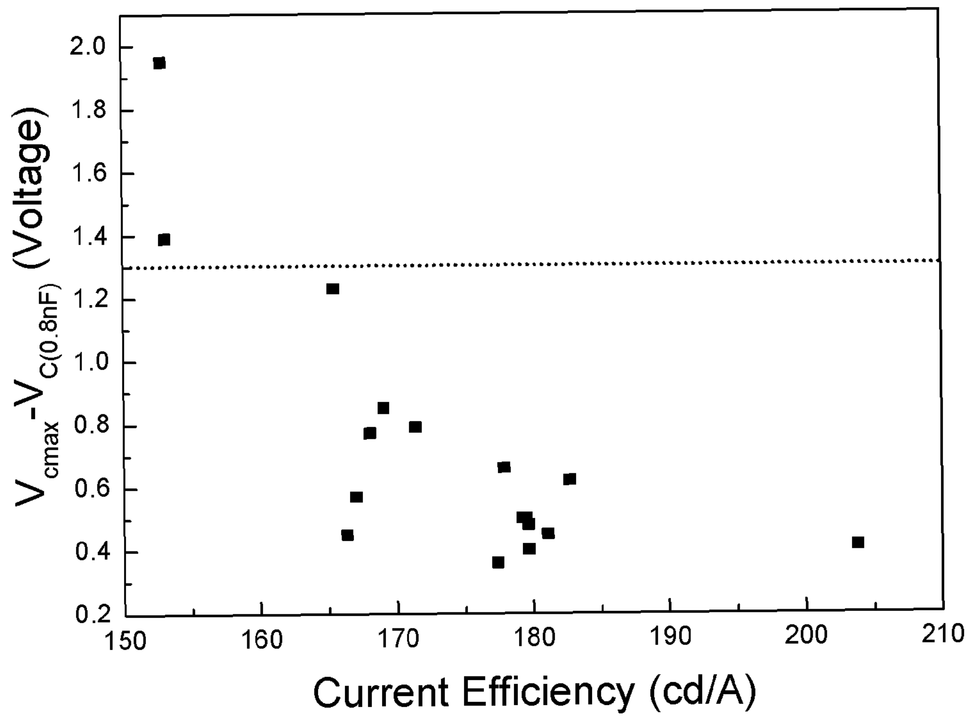
2.0
1.8
1.6
1.4
1.2
1.0
0.8
0.6
0.4
0.2
$V_{cmax}$-$V_{C(0.8nF)}$ (Voltage)
150
160
170
180
190
200
210
Current Efficiency (cd/A)

Europäisches Patentamt
European Patent Office
Office européen des brevets

# EUROPEAN SEARCH REPORT

Application Number
EP 25 17 7499

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2023/189639 A1 (LEE JE WOO [KR] ET AL) 15 June 2023 (2023-06-15)<br>* paragraphs [0019], [0125], [0168] - [0185]; figures 1,3,4; compounds A-27 * | 1,5-11<br>2-4 | INV.<br>H10K50/15<br>H10K50/18<br>ADD.<br>H10K50/19<br>H10K85/60 |
| Y | US 2024/130219 A1 (WANG ZHEN [CN] ET AL) 18 April 2024 (2024-04-18)<br>* paragraphs [0010] - [0014]; figure 3 * | 2,3 | |
| Y | US 2018/205032 A1 (LEE BUMSUNG [KR] ET AL) 19 July 2018 (2018-07-19)<br>* figure 1 * | 4 | |
| | | | TECHNICAL FIELDS SEARCHED (IPC) |
| | | | H10K |

The present search report has been drawn up for all claims

1

| Place of search | Date of completion of the search | Examiner |
|---|---|---|
| Munich | 17 September 2025 | Beierlein, Udo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 25 17 7499

This annex lists the patent family members relating to the patent documents cited in the above-mentioned European search report. The members are as contained in the European Patent Office EDP file on
The European Patent Office is in no way liable for these particulars which are merely given for the purpose of information.

17-09-2025

| Patent document cited in search report | Publication date | Patent family member(s) | Publication date |
|---|---|---|---|
| US 2023189639 A1 | 15-06-2023 | NONE | |
| US 2024130219 A1 | 18-04-2024 | CN 117769279 A | 26-03-2024 |
| | | JP 2024046755 A | 04-04-2024 |
| | | KR 20240041842 A | 01-04-2024 |
| | | US 2024130219 A1 | 18-04-2024 |
| US 2018205032 A1 | 19-07-2018 | CN 107849442 A | 27-03-2018 |
| | | EP 3321341 A1 | 16-05-2018 |
| | | JP 6691598 B2 | 28-04-2020 |
| | | JP 2018532253 A | 01-11-2018 |
| | | KR 20170007626 A | 19-01-2017 |
| | | US 2018205032 A1 | 19-07-2018 |
| | | WO 2017010726 A1 | 19-01-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 101647160